# EUROPEAN PATENT APPLICATION

(11) **EP 1 229 460 A1**
(43) Date of publication of application: **07.08.2002**
(21) Application number: 00974946.6
(22) Date of filing: 13.11.2000
(51) Int. Cl.: G06F 17/50

(54) **SYSTEM FOR SUPPORTING BUILDING PRODUCTION**

(30) Priority: 12.11.1999 JP 32337499
(71) Applicant: Noguchi, Sumio, Tokyo 104-0052 (JP)
(72) Inventor: NOGUCHI, Sumio, Tyuuou-ku Tokyo 104-0052 (JP); ABE, Yosiyuki, Yokohama-shi Kanagawa 225-0003 (JP)
(74) Representative: Banzer, Hans-Jörg, Dipl.-Ing.
(86) International application number: JP0007977
(87) International publication number: WO0137149

(57) **Abstract**

The building production support system of this invention inputs information on elements that are the smallest units to compose a design target object, detail libraries that are generated by defining multi-layered element complexes that consist of combinations of elements and planning figures, and provides a total design piece generation means that selects elements or element complexes from said detail libraries to relate them to figure pieces, and a detail design piece generation means that outputs various kinds of figure information based on said total design pieces, at each stage of design according to requests. Recursive iteration of design and correction can be easily done and various kinds of drawings can be obtained at each stage of design on request. Furthermore, detail information can be corrected or changed easily.

## Description

### TECHNOLOGY AREA

This invention is related to a building production support system, especially to a building production support system that manages information generated at each building production process such as design, construction or management, so that such information can be smoothly transported and easily transformed as design drawings, quantity survey information and cost estimation.

### BACKGROUND OF THE INVENTION

Conventional CAD systems for building production are designed to generate CAD data effectively as completed design drawings. For example, a two-dimensional CAD system provides a simple set of drawing functions to make up final drawings on blank sheets. Several commands, such as positioning commands for service ducts, columns, beams, walls and fittings, are provided by such a CAD system, and two-dimensional drawings can be developed and displayed by the computer as a result when parameters for each command are entered through input devices such as a keyboard or a pointing mouse.

In building production, many studies should be made from various aspects such as plane/elevation/section plans, functions, performances, cost and quality. It is very difficult, however, to change or modify even a portion of the total design by using such conventional CAD systems, since most of such works should be done manually. Additionally, output data of such conventional CAD systems merely provide coordinate values, without showing any building construction information for actual walls, columns or beams corresponding to each line segment.

Thus conventional CAD systems are inadequate as a building production support system for building designers who usually brushes up their plans through repeated design changes. Also, generated data in one conventional CAD system cannot be used commonly in another CAD system, which make it difficult to deploy such data for different application outputs.

A so called object-oriented CAD system has been already proposed for building design, which enables to draw figures by attaching building position information to each object in a general CAD system. In this CAD system, building position information objects, such as column, wall, slab, roof or door information, are provided in advance, and each object contains information that limits its own behavior. For example, the object of "a window" limits itself not to move to outside of a wall, since the window should be on the wall.

The plane figure, the elevation figure and the section figure are generated when this object-oriented CAD system is applied for the design of a three dimensional shape. If the plane figure is modified, the result is automatically reflected on the corresponding elevation and section figures. Also, if the center of a service duct is moved, corresponding sizes or positions in the related objects will be shifted automatically.

Conventional object-oriented CAD systems, however, have such problems as will be mentioned in the following. Firstly, although communication between each design stage starting from planning, followed by basic design, practical design and final working drawing output, is carried out by using drawings, output drawings of a conventional object-oriented CAD system can be applied almost only to the basic design stage.

At the planning design stage, communication between the owner and the contractor starts by hearing and understanding numerous requirements from owners and then embodying them on drawings. Drawings used at this stage are so-called single line drawings that are drawn by using simple one line. A drawn item on such figures implies rather symbolic or conceptual meaning such as a zoning or an aperture, rather than a realistic item such as a wall or a door. Thus, a rigid output drawing of an object-oriented CAD system, if used at this stage, is not comfortable for a designer or an engineer to utilize. Moreover, detailed specifications or additional information on the figures are almost meaningless, since the purpose of the drawings at this stage is merely to summarize requirements of the owner, and since usually such drawings must be repeatedly re-drawn totally on the blank paper, reflecting feedbacks from the owner.

Secondly, whereas purposes of the drawings at the practical design stage are to transfer the precise information of the designed building to the construction contractor, and to check the total fitness of the design in detail, information in output drawings of a conventional object-oriented CAD system that contain only position level information for walls or columns is insufficient for such purposes. Furthermore, even if such building component level objects are provided in a conventional object-oriented CAD system, such information cannot be utilized as it is at the design stage, since the design at this stage basically handles information of how the status of each component should be.

Thirdly, a conventional object-oriented CAD system cannot flexibly deal with the complex design processes of building production. It is common that many persons work in cooperation at design processes of building production, since experiences and technical skills of one person only are insufficient for executing design processes in the modern building production that is becoming more complex, diversified and functionalized. It is common that once a general building direction is determined through a design meeting, each design engineer or each section engineer designs its responsible portion in parallel. In RC base wall design, for example, thickness and structure of the RC wall is designed by a structure design engineer, while finish is designed by an artistic designer. That is, information is once converged and made common to all relevant people at an initial design meeting and then each engineer or section starts design in parallel, which means diversification of information. The whole design is carried out by iterating this cycle of conversion and diversion, to obtain final unified information as a set of design documents. A conventional object-oriented CAD system is not so flexible as to be applied for such complex design processes.

Fourthly, at the building construction stage, an overall construction figure and detail construction figures should be prepared with all of the components in the figures expressing physical information of actual building components, in order to carry out actual construction works. But information volumes and levels of the output figures of a conventional object-oriented CAD system are not sufficient in order to generate enough and precise building construction information, as is similar for the practical design stage.

Also at the building construction stage, an overall construction figure and detail construction figures should be generated by cross-checking the design figure and document information that is produced by the design processes. But a conventional object-oriented CAD system cannot flexibly applied to such building production processes as cross-checking of design information or design information deployment to construction information. Similarly, smooth information transfer from the construction stage to the management stage is impossible for a conventional object-oriented CAD system.

The purpose of this invention is to provide a construction production support system which can generate versatile additional construction production information data that are required at each of the design stage, the construction stage and the management stage throughout the construction production processes, by utilizing drawing data output of an existing two-dimensional or three-dimensional CAD system, and can output. these additional data in an easily deployable and extendable format.

### SUMMARY OF THE INVENTION

The above mentioned purpose is attained by the following composition of this invention.
**1.** A construction production support system that contains (1) a means to input planning data pieces that consist of figure pieces, (2) a means to generate total design pieces by : (a) generating a detail library (DL) through defining a building design target by elements composing said building design target and by multi-layered element complexes each of which is composed of a combination of said elements or complexes of said elements, and (b) selecting necessary elements or element complexes from said detail library in order to attach meaning to each of said figure pieces, and (3) a means to generate detail design pieces from information of said total design pieces and to output necessary information.
**2.** A construction production support system claimed in claim 1 where said detail library consists of an element layer, a component layer and a position layer, and the component layer consists of one or a number of elements and the position layer consists of one or a number of components or positions.
**3.** A construction production support system claimed in claim 1 where said detail library contains connection data that define a competing portion between positions or components.
**4.** A construction production support system claimed in claim 1 where said construction production support system contains a generating means and a correcting means for said detail library.
**5.** A construction production support system claimed in claim 1 where said construction production support system contains CAD functions.
**6.** A construction production support system claimed in claim 1 where said means to generate detail design pieces contains a means to output drawing data derived from detail design piece data.
**7.** A construction production support system claimed in claim 1 where said means to generate detail design pieces contains a means to output quantity surveying data derived from detail design piece data.
**8.** A construction production support system claimed in claim 1 where said means to generate detail design pieces contains a means to output endurance period managing data derived from detail design piece data.
**9.** A construction production support system claimed in claim 1 where said construction production support system contains a correcting means for said total design pieces and a correcting means for said detail design pieces.
**10.** A construction production support system claimed in claim 9 where each of said total design pieces and detail design pieces contains a request data base (DB) through which any change in any design piece can be reflected on other design pieces.
**11.** A construction production support system claimed in claim 10 where construction production support system contains a priority order DB that stores information of each designer's correction right.
**12.** A construction production support system claimed in claim 1 where said detail library (DL) possesses the same two data sets for designing and for construction and replaces the DL for designing by DL for construction automatically to generate detail design pieces for construction.
**13.** A method to support construction production that contains (1) a step to input planning drawings that consist of figure pieces, (2) a step to generate total design pieces by : (a) generating a detail library (DL) through defining a building design target by elements composing said building design target and by multi-layered element complexes each of which is composed of a combination of said elements or complexes of said elements, and (b) selecting necessary elements or element complexes from said detail library in order to attach meaning to each of said figure pieces, and (3) a step to generate detail design pieces from information of said total design pieces and to output necessary information.
**14.** An information recording medium of which contents can be read by a computer and in which a computer program is recorded to carry out functions of : (1) a means to input planning data pieces that consist of figure pieces, (2) a means to generate total design pieces by : (a) generating a detail library (DL) through defining a building design target by elements composing said building design target and by multi-layered element complexes each of which is composed of a combination of said elements or complexes of said elements, and (b) selecting necessary elements or element complexes from said detail library in order to attach meaning to each of said figure pieces, and (3) a means to generate detail design pieces from information of said total design pieces and to output necessary information.

If the building production support system of this invention is used at an early stage of design planning, recursive design-and-correction cycles through displaying precise two-dimensional figures on a computer monitor screen can be carried out by using CAD data and by adding or changing them by using information from the data library. If necessary, displaying of desired design support information on the screen is also possible, by selecting and processing information on total design pieces and on elements, components, position or connections of detail design pieces, which are determined by using the detail library (occasionally abbreviated as "DL" hereafter).

Throughout design, construction and management stages using the building production support system of this invention, change or correction of the detail information can be easily done through change of total design pieces or detail design pieces by selection change or replacement of corresponding data in the DL, or by change of their parameter settings.

Furthermore, since said DL in the building production support system of this invention has a layered information structure consisting of elements, components, positions and connections for each of design, construction and management targets, various types of information search become possible enabling precise response to any request at any stage such as a change for total design from a change in detail design or vice versa, as is peculiar to design work.

Also, logical data management becomes possible in the building production support system of this invention, by defining and managing three-dimensional shapes, structures, functions and other attributes of the targets as the DL, by defining and managing intentions and opinions of concerned people in each stage of design, construction and management, and by preparing extension programs (a drawing data generation program, for example) used in each "location" such as each stage mentioned above or each section of the building production. Consequently, flexible exchange and management of information throughout design, construction and management, and easy access to any of data bases (occasionally abbreviated as "DB" hereafter) throughout the system become possible.

In the process of generating working drawings from practical design figures and documents, for example, an extension program links the DL for construction works to (actually replace the DL by) the total design pieces and the detail design pieces in the practical design figures and documents, thus enabling generation of extension data as the expression of the working drawings.

It becomes possible to manage data most appropriately at each stage and in each section independently, by defining a significant minimum unit as an element, by managing components, positions and connections through elements, and by replacing design pieces of elements, components, positions and connections at each stage or at each section. Additionally, various physical simulations can be carried out since the minimum meaning and the physical shape corresponds one to one.

Furthermore, management of quantity surveying and endurance period becomes possible in the building production support system of this invention, by adding cost and endurance period information of each element and component in the DL mentioned above.

### DESCRIPTION OF THE DRAWINGS

**Figure 1** is an explanation figure (1) to explain functions and relationship between data in the system of this invention.
**Figure 2** is another explanation figure (2) to explain functions and relationship between data in the system of this invention.
**Figure 3** is a function block diagram to show the configuration of the system of this invention.
**Figure 4** is a block diagram to show an example of hardware configuration of the system of this invention.
**Figure 5** is an explanation figure to explain the data structure of a DL.
**Figure 6** is an explanation figure (1) to explain the structure of DBs that compose a total design piece (a planning design piece).
**Figure 7** is an explanation figure (2) to explain the structure of DBs that compose a total design piece (a planning design piece).
**Figure 8** is an explanation figure to explain the structure of DBs that compose a total design piece (a connection design piece).
**Figure 9** is an explanation figure (1) to explain the structure of DBs that compose a detail design piece (a planning design piece).
**Figure 10** is an explanation figure (2) to explain the structure of DBs that compose a detail design piece (a planning design piece).
**Figure 11** is an explanation figure to explain the structure of DBs that compose a detail design piece (a connection design piece).
**Figure 12** is an explanation figure (1) to explain the structure of DBs that composes a DL.
**Figure 13** is an explanation figure (2) to explain the structure of DBs that composes a DL.
**Figure 14** is an explanation figure to explain the structure of DBs that compose an element of the DL.
**Figure 15** is an explanation figure (1) to explain the structure of DBs that compose an element of the DL (connection).
**Figure 16** is an explanation figure (2) to explain the structure of DBs that compose an element of the DL (connection).
**Figure 17** is an explanation figure to explain data examples in the change history DB for a detail plane figure.
**Figure 18** is an explanation figure to explain data examples in the request DB.
**Figure 19** is an explanation figure to explain data examples of the total design piece change history DB.
**Figure 20** is an explanation figure to explain data examples of the total design piece process waiting DB.
**Figure 21** is a flow chart to show the element data generation process.
**Figure 22** is a flow chart to show the component data generation process.
**Figure 23** is a flow chart to show the position data generation process.
**Figure 24** is a flow chart to show the connection data generation process.
**Figure 25** is a flow chart to show the DL change process.
**Figure 26** is a flow chart to show the outline of a design example using the system of this invention.
**Figure 27** is an explanation figure to show the execution timing of each process in Fig. 26.
**Figure 28** is a flow chart to show the generation process for total design pieces (planning design pieces).
**Figure 29** is a flow chart to show the generation process for the total design pieces (connection design pieces).
**Figure 30** is a flow chart to show the generation process for the detail design pieces.
**Figure 31** is a flow chart to show the detail of the process (5) in Fig. 30.
**Figure 32** is a flow chart to show the detail of the process (7) in Fig. 30.
**Figure 33** is a flow chart to show the total design piece change process and the DL change process.
**Figure 34** is a flow chart to show the detail of the process (5) in Fig. 33.
**Figure 35** is a flow chart to show the detail of the process (6) in Fig. 33.
**Figure 36** is an explanation figure to show the detail design piece change process.
**Figure 37** is a flow chart to show the detail design piece change process.
**Figure 38** is a flow chart to show the detail of the process (12) in Fig 37.
**Figure 39** is a flow chart to show the detail of the process (7) in Fig 38.
**Figure 40** is a flow chart to show the request consideration process.
**Figure 41** is a flow chart to show the reflection process to the request DB.
**Figure 42** is a flow chart to show the process of handling a change request to the other detail design piece.
**Figure 43** is a flow chart to show the detail of the process (14) in Fig. 42.
**Figure 44** is a flow chart to show the detail design piece synchronization process.
**Figure 45** is a flow chart to show the correction process for a detail design piece.
**Figure 46** is an explanation figure to show the construction design piece generation process through DL replacement.
**Figure 47** is a flow chart to show the construction design piece generation process through DL replacement.
**Figure 48** is a flow chart to show the detail of the process of (1) in Fig. 47.
**Figure 49** is a flow chart to show the detail of the process of (14) in Fig. 48.
**Figure 50** is a flow chart to show the detail of the process of (2) in Fig. 47.
**Figure 51** is a flow chart to show the detail of the process of (3) in Fig. 47.
**Figure 52** is a flow chart to show the detail of the process of (6) in Fig. 51.
**Figure 53** is a flow chart to show the detail of the process of (4) in Fig. 47.
**Figure 54** is an explanation figure to show the data structure of a total design piece (a planning design piece).
**Figure 55** is an explanation figure to show the data structure of a total design piece (a connection design piece).
**Figure 56** is an explanation figure to show the data structure of a detail design piece (a planning design piece).
**Figure 57** is an explanation figure to show the data structure of a detail design piece (a connection design piece).
**Figure 58** is an explanation figure to show the data structure of the DL (the element DB).
**Figure 59** is an explanation figure to show the data structure of the DL (the component DB, the position DB).
**Figure 60** is an explanation figure to show the data structure of the DL (connection).
**Figure 61** is an explanation figure to show a generated example (1) of a total design piece (a planning design piece).
**Figure 62** is an explanation figure to show a generated example (2) of a total design piece (a planning design piece).
**Figure 63** is an explanation figure to show a generated example (3) of a total design piece (a planning design piece).
**Figure 64** is an explanation figure to show a generated example (4) of a total design piece (a planning design piece).
**Figure 65** is an explanation figure to show a generated example (5) of a total design piece (a planning design piece).
**Figure 66** is an explanation figure to show a generated example (1) of a total design piece (a connection design piece).
**Figure 67** is an explanation figure to show a generated example (2) of a total design piece (a connection design piece).
**Figure 68** is an explanation figure to show a generated example (3) of a total design piece (a connection design piece).
**Figure 69** is an explanation figure to show a generated example (4) of a total design piece (a connection design piece).
**Figure 70** is an explanation figure to show a generated example (1) of a detail design piece (a plane figure).
**Figure 71** is an explanation figure to show a generated example (2) of detail design piece (a plane figure).
**Figure 72** is an explanation figure to show a generated example (3) of a detail design piece (a plane figure).
**Figure 73** is an explanation figure to show a generated example (4) of detail design piece (a plane figure).
**Figure 74** is an explanation figure to show an example (1) of total design piece change (DL change).
**Figure 75** is an explanation figure to show an example (2) of total design piece change (DL change).
**Figure 76** is an explanation figure to show an example (3) of total design piece change (DL change).
**Figure 77** is an explanation figure to show an example (4) of total design piece change (DL change).
**Figure 78** is an explanation figure to show an example (5) of total design piece change (DL change).
**Figure 79** is an explanation figure to show an example (6) of total design piece change (DL change).
**Figure 80** is an explanation figure to show an example (7) of total design piece change (DL change).
**Figure 81** is an explanation figure to show an example (8) of total design piece change (DL change).
**Figure 82** is an explanation figure to show an example (9) of total design piece change (DL change).
**Figure 83** is an explanation figure to show an example (10) of total design piece change (DL change).
**Figure 84** is an explanation figure to show a generated example (1) of a detail design piece (a detail plane figure).
**Figure 85** is an explanation figure to show a generated example (2) of a detail design piece (a detail plane figure).
**Figure 86** is an explanation figure to show a generated example (3) of a detail design piece (a detail plane figure).
**Figure 87** is an explanation figure to show a generated example (4) of a detail design piece (a detail plane figure).
**Figure 88** is an explanation figure to show a generated example (5) of a detail design piece (a detail plane figure).
**Figure 89** is an explanation figure to show a generated example (1) of a detail design piece (a detail section figure).
**Figure 90** is an explanation figure to show a generated example (2) of a detail design piece (a detail section figure).
**Figure 91** is an explanation figure to show a generated example (3) of a detail design piece (a detail section figure).
**Figure 92** is an explanation figure to show an example (1) of correction for another detail design piece.
**Figure 93** is an explanation figure to show an example (2) of correction for another detail design piece.
**Figure 94** is an explanation figure to show an example (3) of correction for another detail design piece.
**Figure 95** is an explanation figure to show an example (4) of correction for another detail design piece.
**Figure 96** is an explanation figure to show an example (5) of correction for another detail design piece.
**Figure 97** is an explanation figure to show an example (6) of correction for another detail design piece.
**Figure 98** is an explanation figure to show an example (7) of correction for another detail design piece.
**Figure 99** is an explanation figure to show an example (8) of correction for another detail design piece.
**Figure 100** is an explanation figure to show an example (9) of correction for another detail design piece.
**Figure 101** is an explanation figure to show an example (10) of correction for another detail design piece.
**Figure 102** is an explanation figure to show an example (11) of correction for another detail design piece.
**Figure 103** is an explanation figure to show an example (12) of correction for another detail design piece.
**Figure 104** is an explanation figure to show an example (13) of correction for another detail design piece. .
**Figure 105** is an explanation figure to show an example (14) of correction for another detail design piece.
**Figure 106** is an explanation figure to show an example (15) of correction for another detail design piece.
**Figure 107** is an explanation figure to show an example (16) of correction for another detail design piece.
**Figure 108** is an explanation figure to show a data example (1) of the detail plane figure change history DB.
**Figure 109** is an explanation figure to show a data example (2) of the detail plane figure change history DB.
**Figure 110** is an explanation figure to show a data example (1) of a total design piece request DB.
**Figure 111** is an explanation figure to show a data example (2) of a total design piece request DB.
**Figure 112** is an explanation figure to show an example of change in a detail management parameter DB.
**Figure 113** is an explanation figure to show a data example of a detail design piece request DB.
**Figure 114** is an explanation figure to show a data example (1) of a total design piece request DB.
**Figure 115** is an explanation figure to show a data example (2) of a total design piece request DB.
**Figure 116** is an explanation figure to show a data example of a total design piece DB.
**Figure 117** is an explanation figure to show a data example of an unprocessed total design piece DB.
**Figure 118** is an explanation figure to show an example of revision process for extension data.
**Figure 119** is an explanation figure to show a data example of a detail design piece DB.
**Figure 120** is an explanation figure to show data examples of a change history DB and a detail design piece request DB.
**Figure 121** is an explanation figure to show an example (1) of correction for a detail design piece.
**Figure 122** is an explanation figure to show an example (2) of correction for a detail design piece.
**Figure 123** is an explanation figure to show an example (3) of correction for a detail design piece.
**Figure 124** is an explanation figure to show an example (4) of correction for a detail design piece.
**Figure 125** is an explanation figure to show an example (5) of correction for a detail design piece.
**Figure 126** is an explanation figure to show an example (1) of change process for the extension data.
**Figure 127** is an explanation figure to show an example (2) of change process for the extension data.
**Figure 128** is an explanation figure to show a data example of a total design piece (a connection) DB.
**Figure 129** is an explanation figure to show a data example of the total design piece change history DB.
**Figure 130** is an explanation figure to show a data example of the detail plane figure request DB.
**Figure 131** is an explanation figure to show an example (1) of a construction design piece generated by DL replacement.
**Figure 132** is an explanation figure to show an example (2) of a construction design piece generated by DL replacement.
**Figure 133** is an explanation figure to show an example (3) of a construction design piece generated by DL replacement.
**Figure 134** is an explanation figure to show an example (4) of a construction design piece generated by DL replacement.
**Figure 135** is an explanation figure to show an example (5) of a construction design piece generated by DL replacement.
**Figure 136** is an explanation figure to show an example (6) of a construction design piece generated by DL replacement.
**Figure 137** is an explanation figure to show an example (7) of a construction design piece generated by DL replacement.
**Figure 138** is an explanation figure to show the relationship between various data in the system of this invention.
**Figure 139** is an explanation figure to show the structure of total design piece data.
**Figure 140** is an explanation figure to show the structure of detail design piece data.
**Figure 141** is an explanation figure to show the structure of extension data.
**Figure 142** is a flow chart to show the details of process of (8) in Fig. 30.

### DESCRIPTION OF THE PREFERRED EMBODIMENT

The preferred embodiment of the building production support system of this invention will be explained hereinafter referring to drawings. Several terms used in the description are defined first; "A planning design piece" is a set of data that shows a certain design intention such as the position of a column or a wall by a shape of the structural object. "A connection design piece" is a set of data that shows a specific portion such as a competing portion of two adjacent walls or a fitting portion at a wall end. "A project" means a whole design work for a building. "The extension process", or "the extension data", means a process of generating and outputting CAD formatted drawing data from detail design piece data, or the output data of that process, respectively.

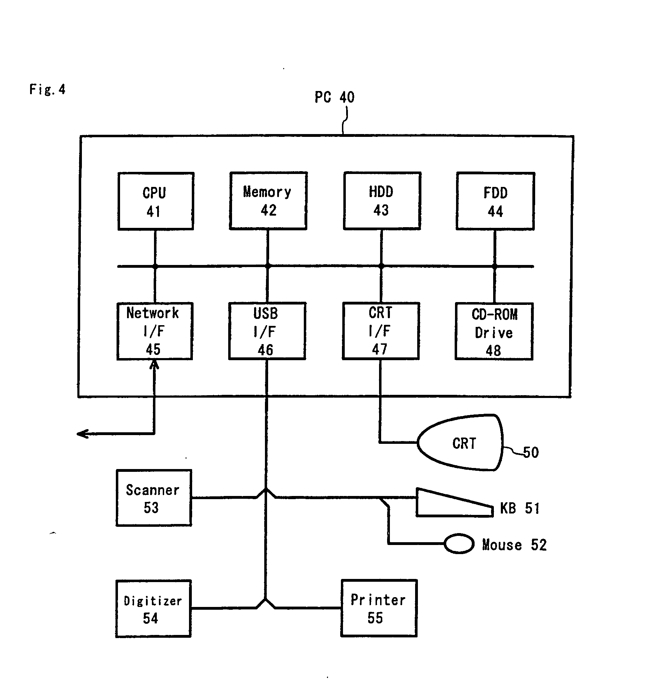

Figure 4 is a block diagram to show an example of hardware configuration of the system of this invention. Functions of the building production support system of this invention are realized by implementing programs that performs such functions as explained in the following on a computer 40, typically a personal computer (PC). The PC 40 includes a CPU 41, a memory 42, a hard disc drive (HDD) 43, a floppy disc drive (FDD) 44, a network interface circuit 45 for the connection to LAN or Internet, an USB interface circuit 46, a CRT interface circuit 47, and a CD-ROM drive 48.

Such peripheral devices as a CRT 50, a Keyboard 51, a pointing mouse 52, a scanner 53, a digitizer 54 and a printer 56 are connected to the PC 40. It is desirable to connect a digital plotter to the PC additionally. Such a personal computer as described above is well-known and commercially available.

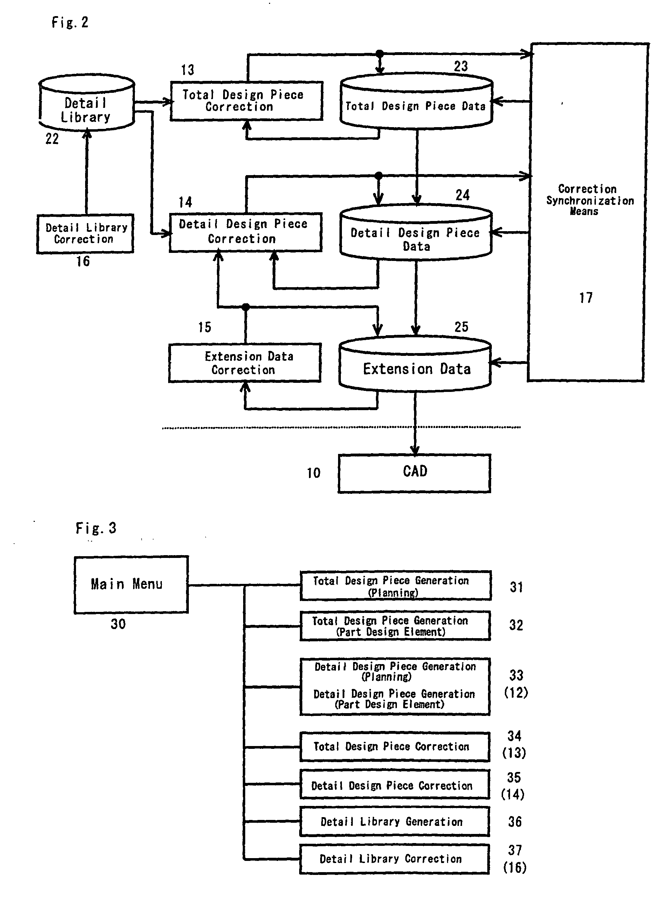

Figure 3 is a function block diagram to show the configuration of the system of this invention. The building production support system of this invention contains function blocks of; the total design piece (planning design piece) generating function 31, the total design piece (connection design piece) generating function 32, the detail design piece (planning design piece and connection design piece) generating function 33(12), the total design piece correction function 34(13), the detail design piece (including extension data) correction function 35(14), the DL generating function 36 and the DL correction function 37(16). Each of these functions can be selected and executed by direction from the main menu 30.

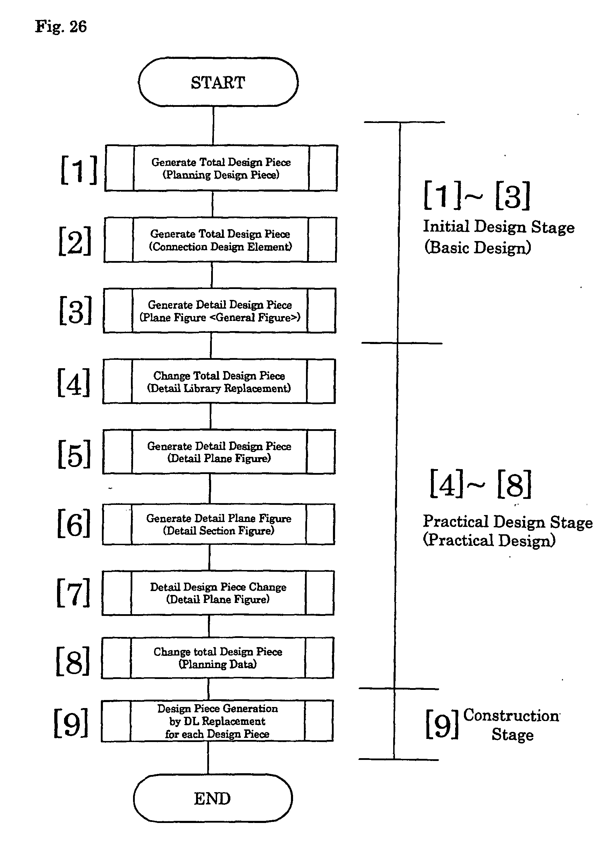

Details of each function will be explained in the following embodiment examples. The total design piece (planning design piece) generating function 31 corresponds to the process [1] in Fig.26. Similarly, the total design piece (connection design piece) generating function 32 corresponds to the process [2], and the detail design piece (planning design piece and connection design piece) generating function 33(12) corresponds to [3], [5] and [6] in Fig. 26, respectively.

The total design piece correction function 34(13) corresponds to some portions of the processes [7] and [8], and the detail design piece (including extension data) correction function 35(14) also corresponds to some portions of the processes [7] and [8].

The correction synchronization means 17 in Figure 2 is to synchronize correction processes of 13, 14, 15 each other, and the correction processes carried out by the means 17 correspond also to some portions of [7] and [8] in Fig.26.

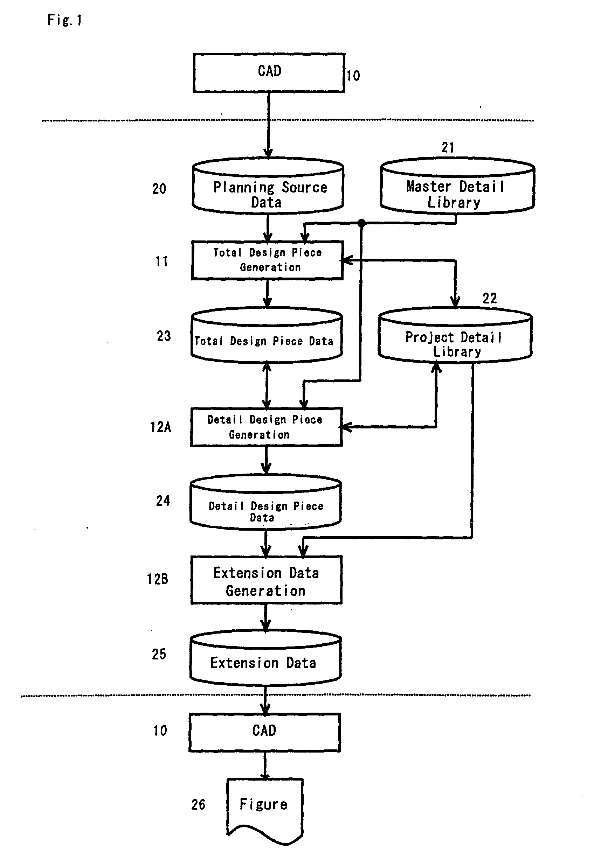

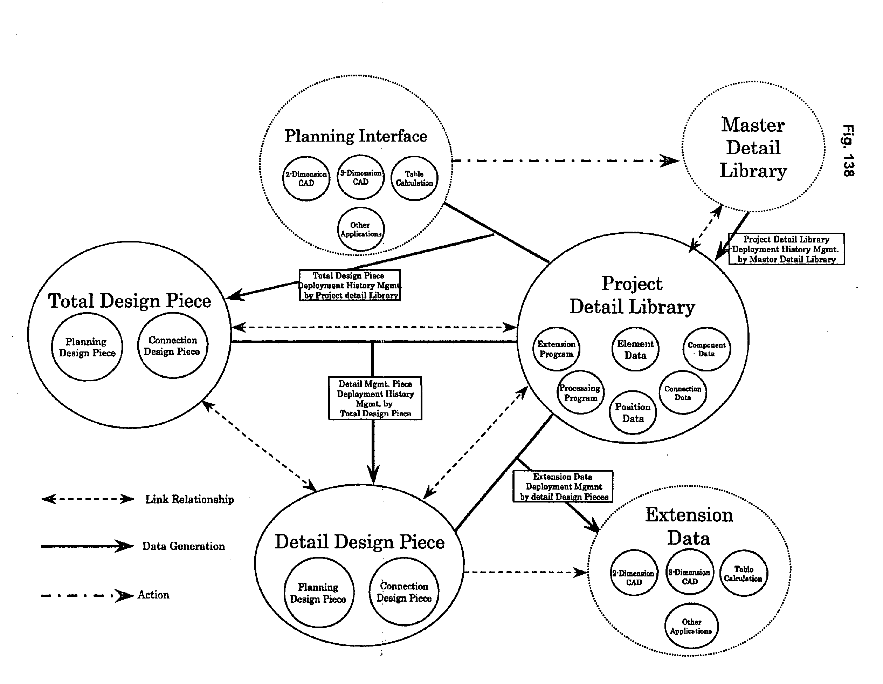

Figures 1 and 2 are explanation figures to explain functions and relationship between data in the system of this invention. Figure 138 is an explanation figure to show the relationship between various data in the system of this invention. Rectangular blocks in Figures 1 and 2 present programs or functions, and cylindrical blocks in the figures present data or databases. A conventional CAD system for building production 10 in Fig.1 is used together with the building production support system of this invention, when a building is designed by using the building production support system of this invention. The CAD system 10 in Fig. 1 may be either independent from, or included in, the system of this invention.

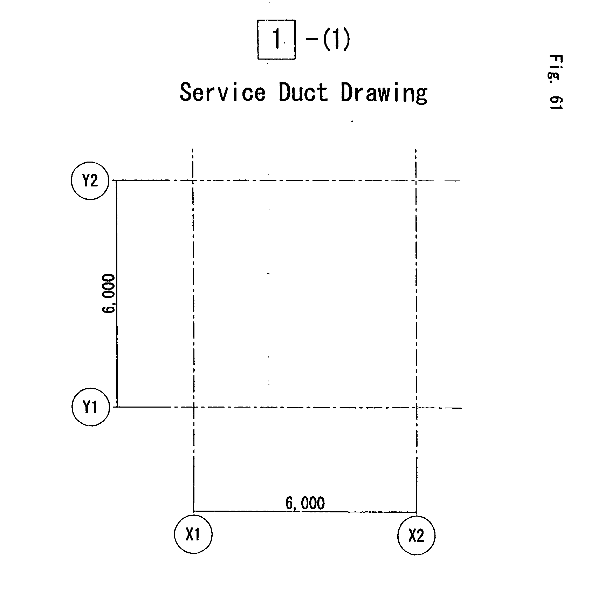

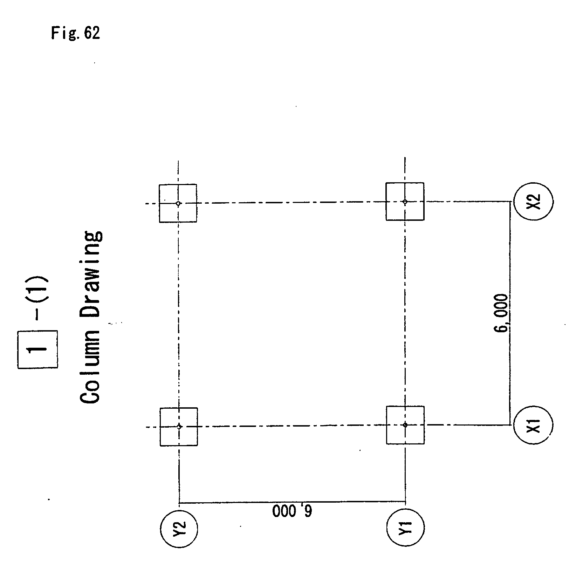

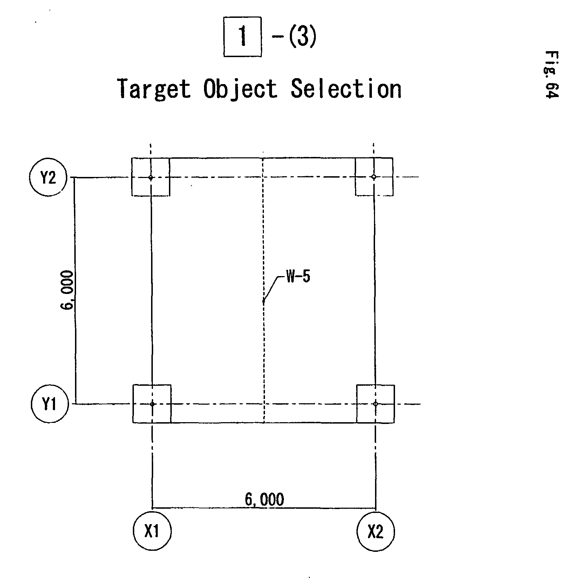

The planning source data 20 in Fig.1 that consist of figure pieces are first generated in the system of this invention by using the CAD system 10 (or the integrated CAD function in the system of this invention) as shown in Figures 61 to 63. Then the total design piece data 23 and the project DL 22 are generated from the planning source data 20 and the master DL 21 by using the total design piece generating means 11 (see Figures 64 to 69). Of course, necessary DL data should be stored in the master DL 21 before this process starts. Generation or correction of the DL can be done by the generation function 36 and correction function 37 in Fig. 3, although these processes are not shown in Fig. 1. The project DL 22 is a data base in which DL information selected from the master DL to be contained in detail design pieces is registered.

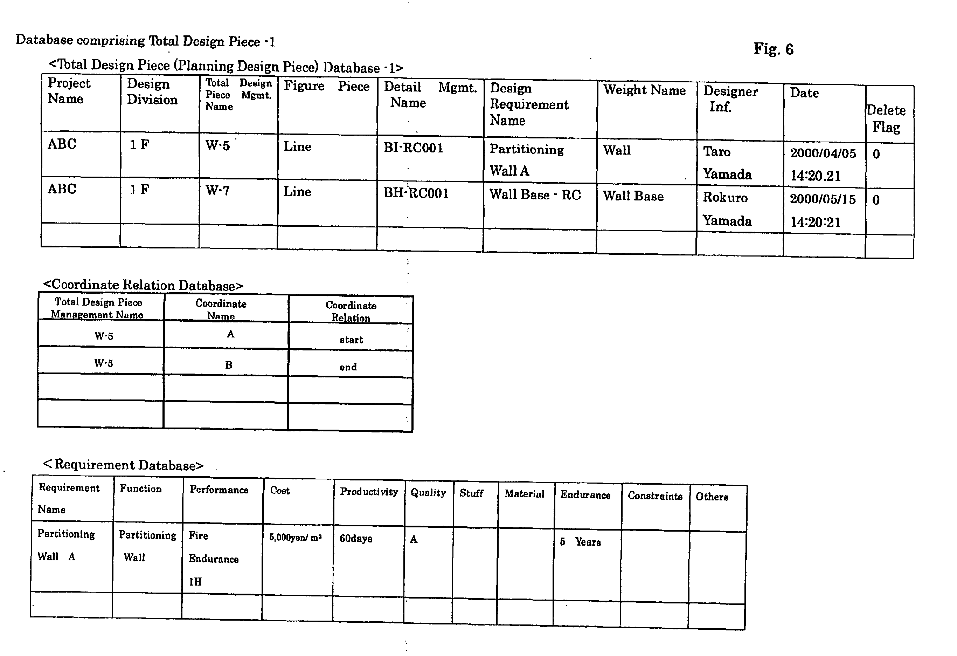

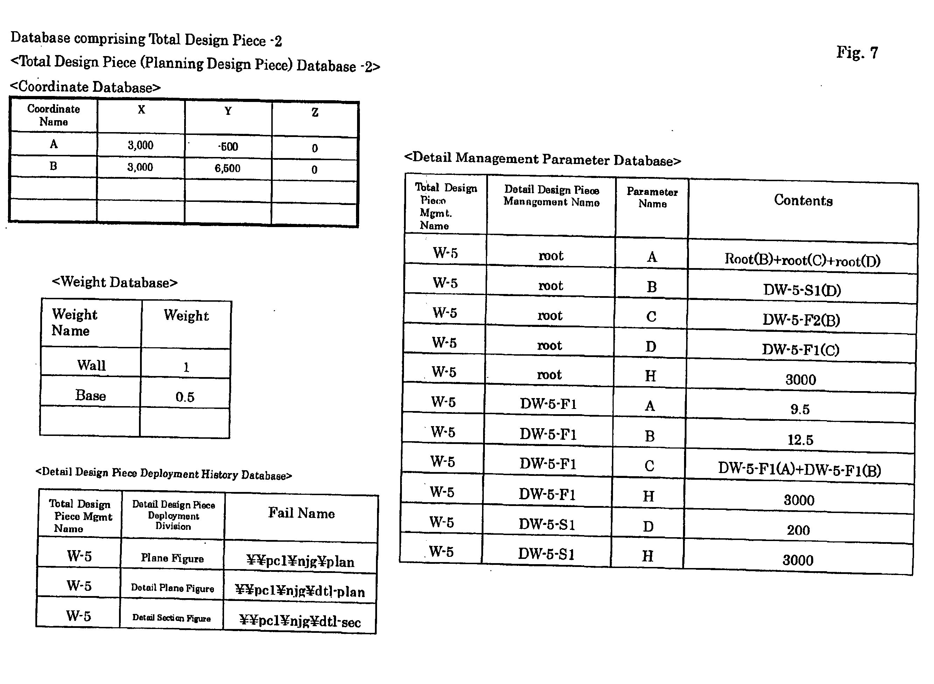

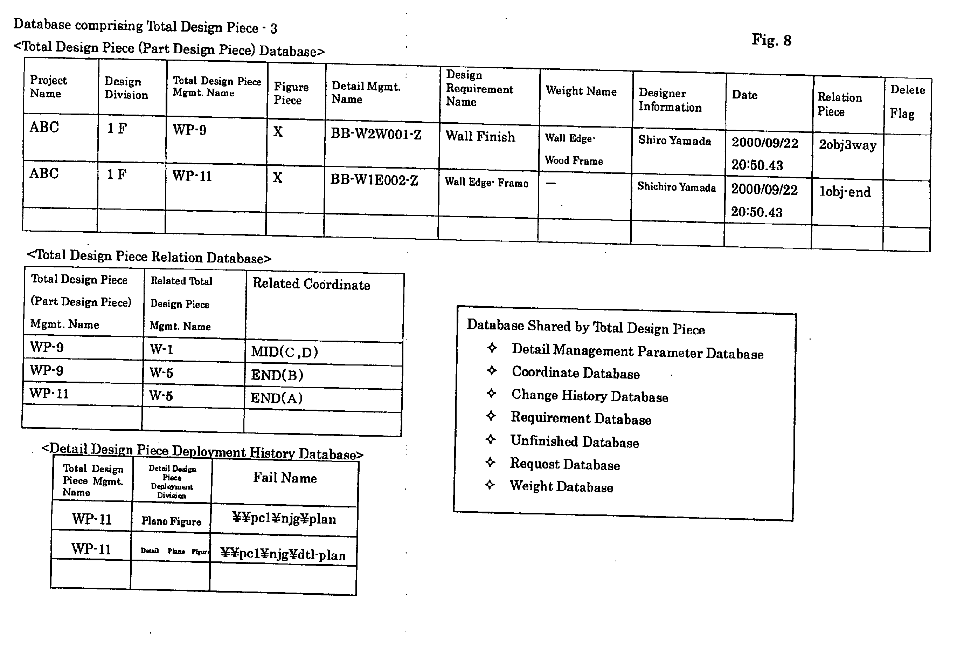

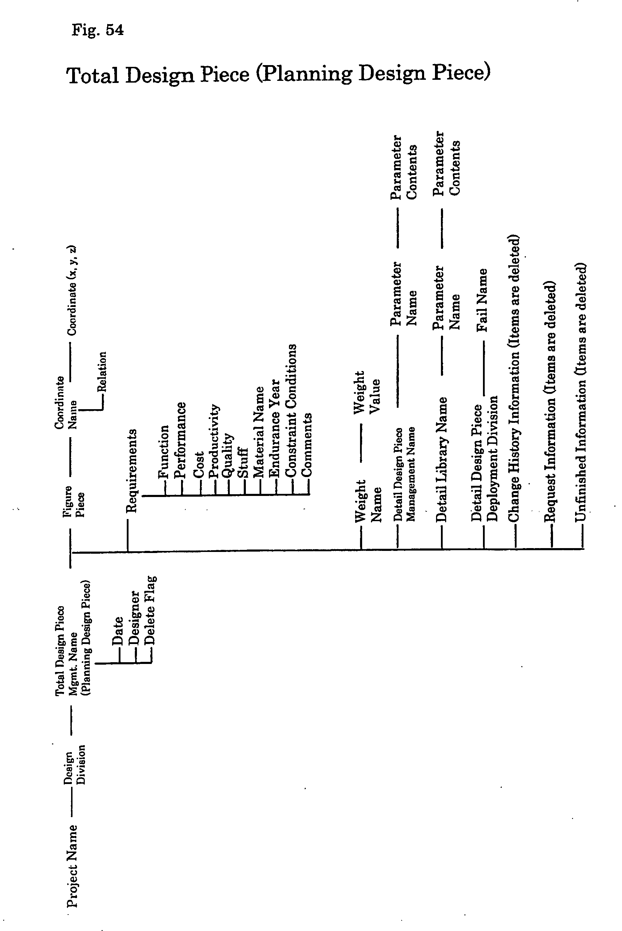

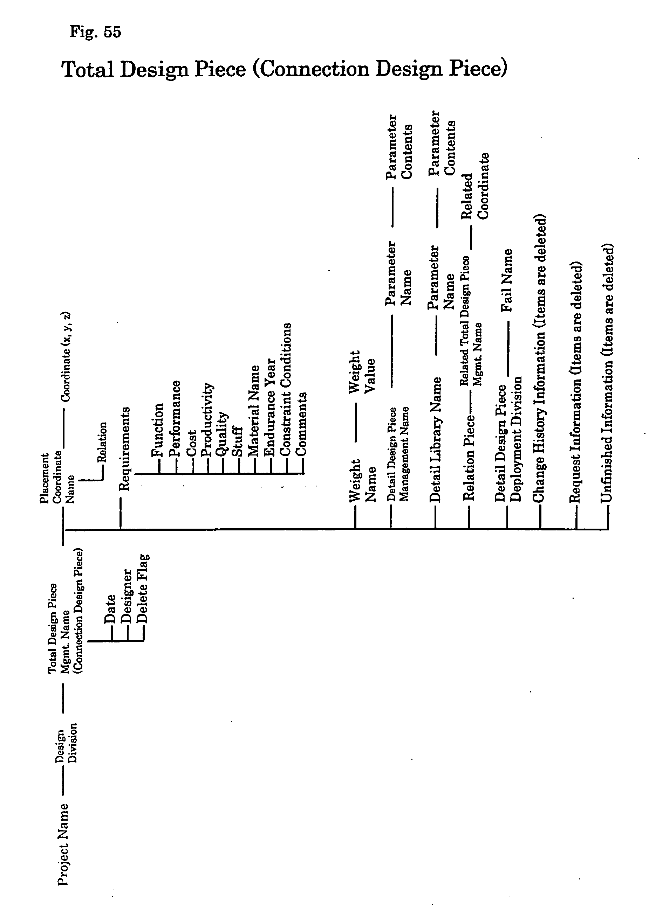

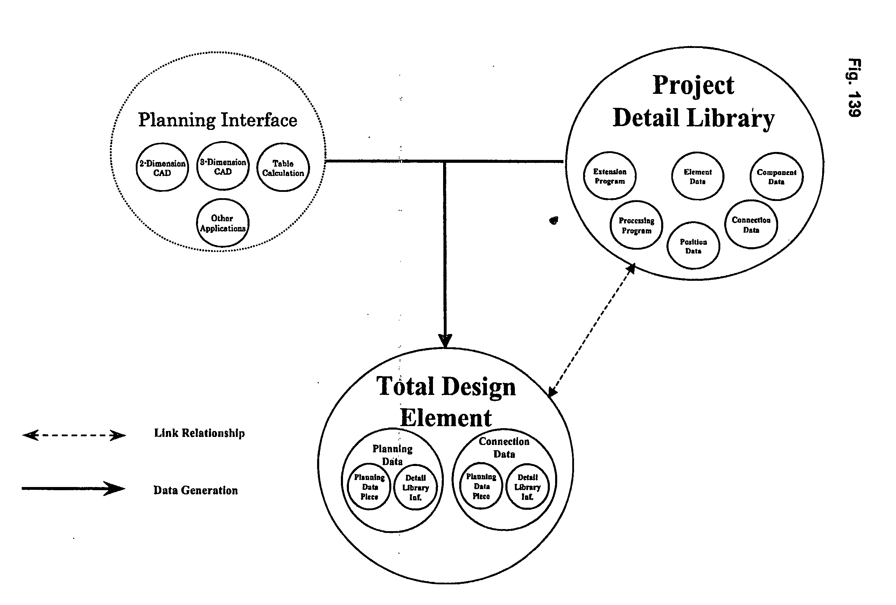

Figures 6 and 7 are explanation figures to explain the structure of the DB that composes a total design piece (a planning design piece), and Fig. 8 is an explanation figure to explain the structure of the DB that composes a total design piece (a connection design piece). Figure 54 is an explanation figure to show the data structure of a total design piece (a planning design piece), and Figure 55 is an explanation figure to show the data structure of a total design piece (a connection design piece). Also Fig. 139 is an explanation figure to show how the total design piece data are generated.

Figures 6 to 9 are to show the structure of a total design piece in the form of relational DB. Figures 54 and 55 are to show the structure of the same total design piece in the form of a spanning tree. Various data for various items as shown in Figures 6 to 8 or in Figures 54 and 55 are related to the total design piece and stored in related databases.

As explained above, the total design piece data 23 consists of planning design pieces and connection design pieces. A planning design piece is a set of data that manages elements (such as columns, beams, floors, walls, ceilings and furniture which compose a room) which specify spatial configuration planning in building production. A connection design piece is a set of data that manages competing in planning design pieces (such as competing between a column and a wall, or between walls). A planning design piece consists of coordinates that show configuration of walls and columns, figure pieces (geometric figure pieces such as "LINE" and "BOX"), DL information, design requirements, weights, attributes for detail design piece management, generation history information and others. A connection design piece consists of its positioning coordinates, DL information, relation piece information, design requirements, weights, detail design piece attributes, generation history information, and others. DL will be explained later.

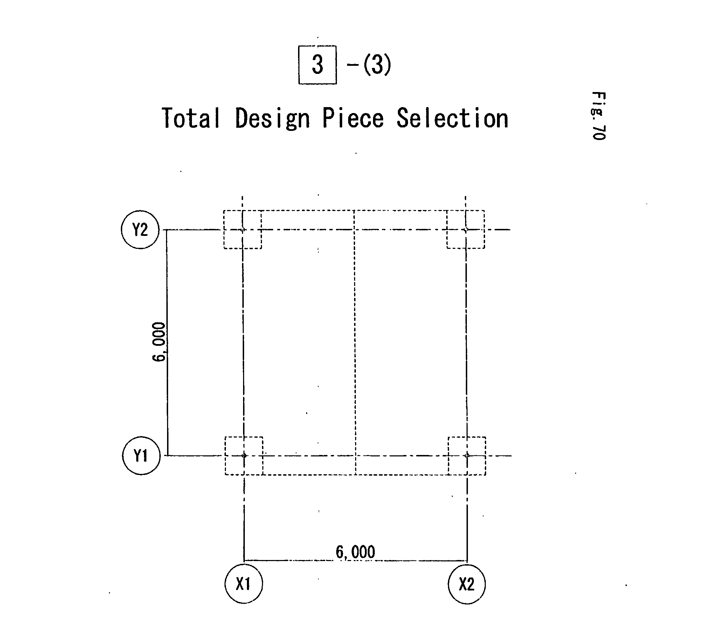

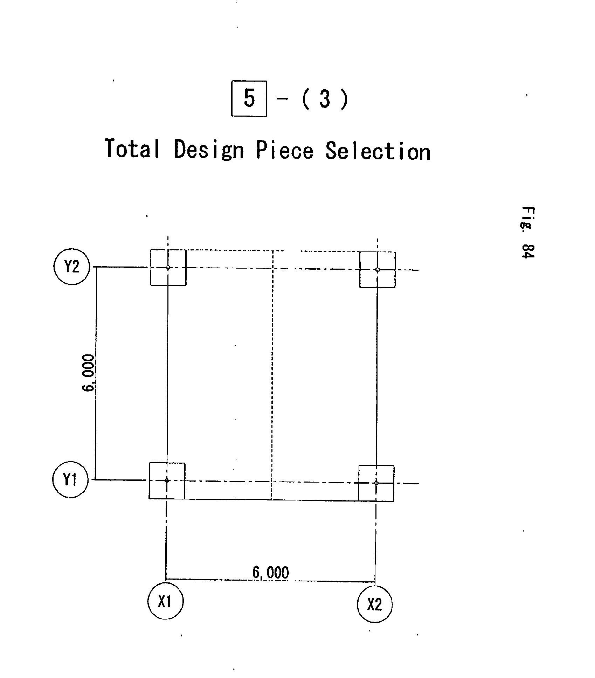

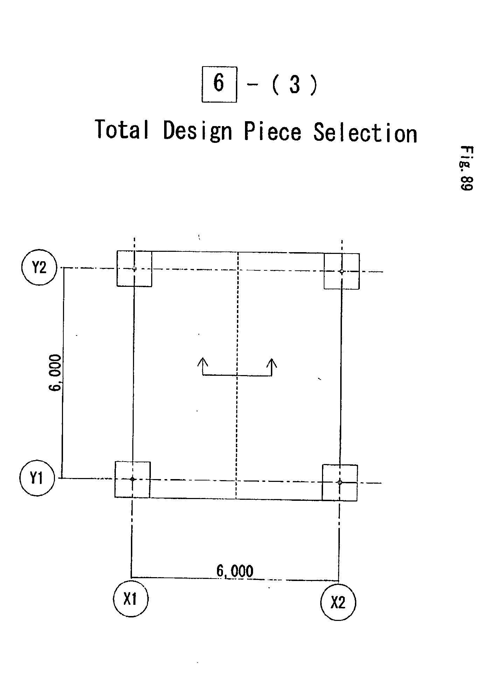

The next process in Fig. 1 is to generate one or a number of detail design piece(s) 24 from the total design piece data 23 and the project DL 22, by the detail design piece generating means 12A. Then one or a number of extension data 25 are generated by the extension generation means 12B, from each of detail design piece 24 and each of DL 22 (examples are shown in Figures 70 to 73 for plane figures, Figures 84 to 88 for detail plane figures and Figures 89 to 91 for section figures).

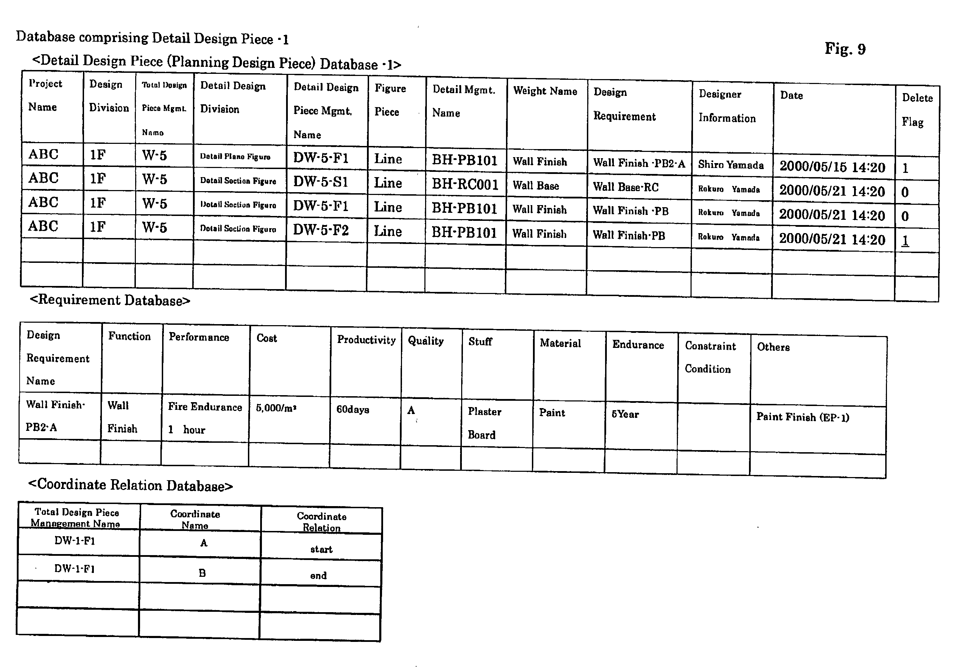

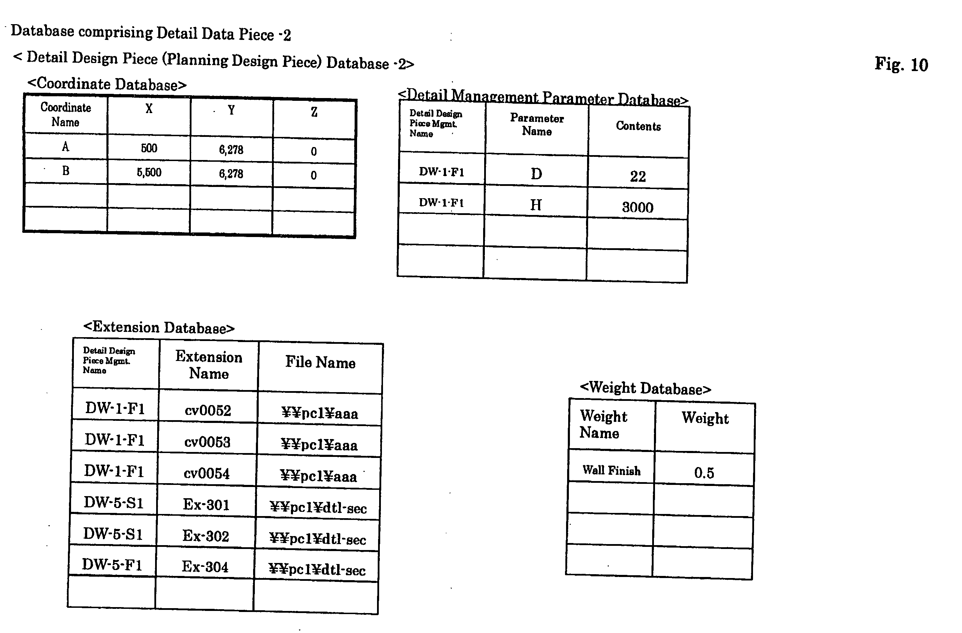

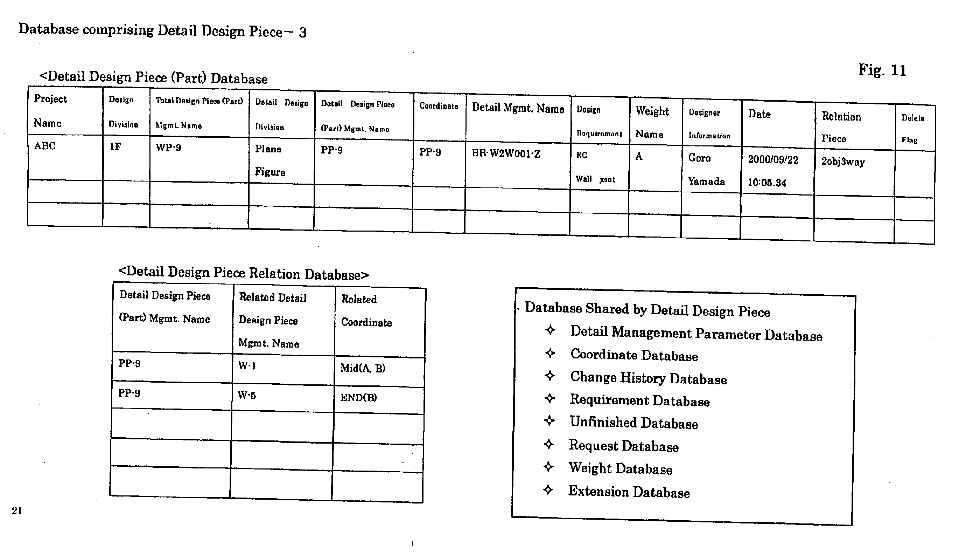

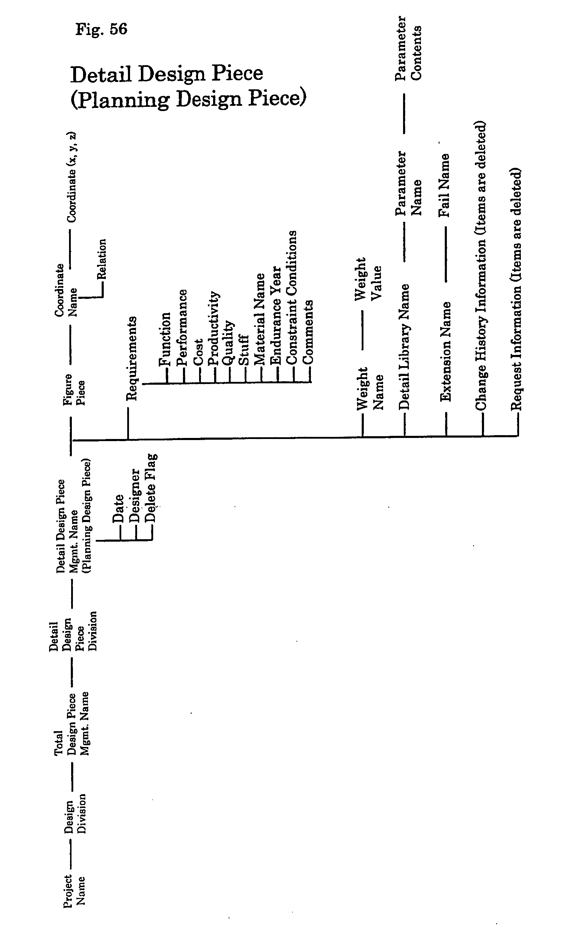

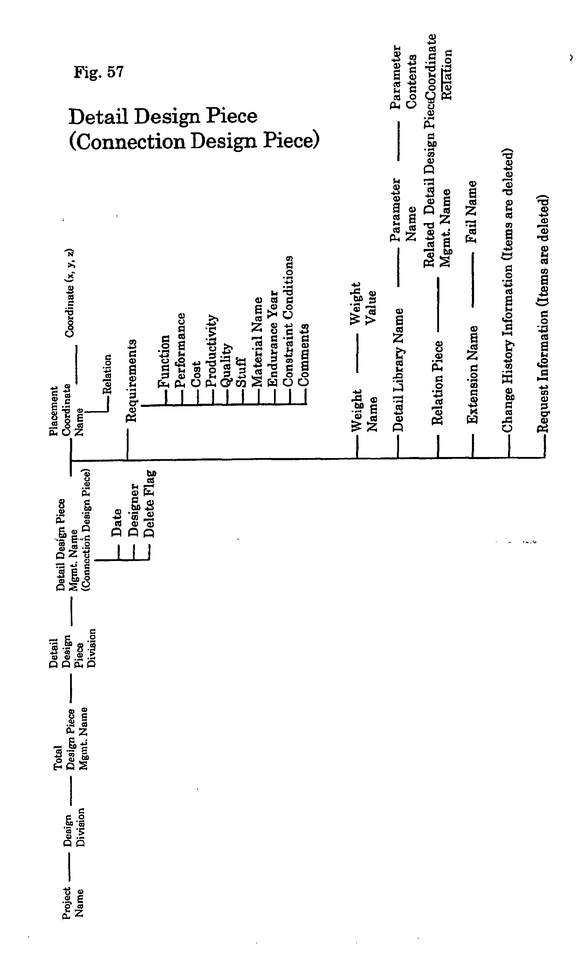

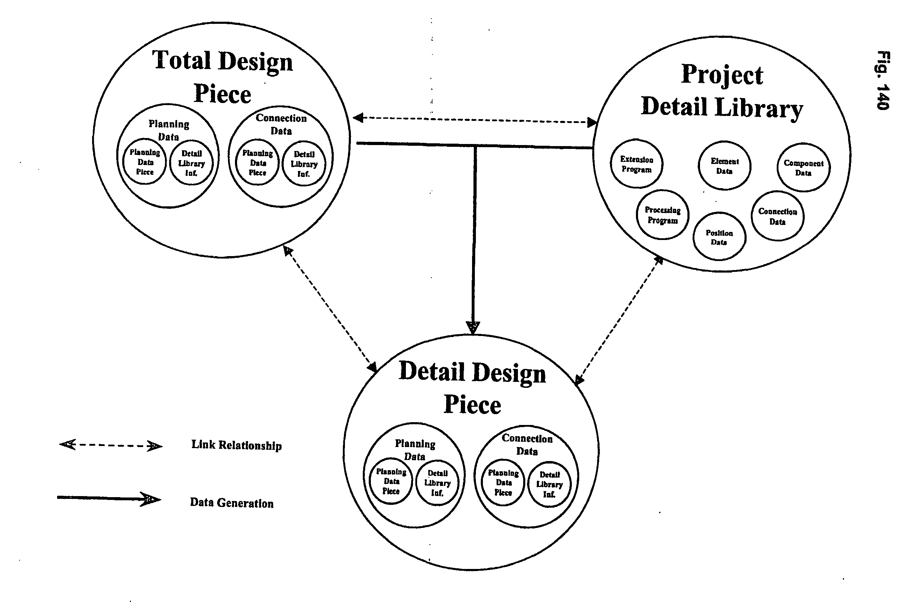

Figure 9 and 10 are an explanation figures to explain the structure of the DB that composes a detail design piece (a planning design piece), and Fig. 11 is an explanation figure to explain the structure of the DB that composes a detail design piece (a connection design piece). Also Fig. 56 is to show the data structure of a detail design piece (a planning design piece) and Fig. 57 is to show the data structure of a detail design piece (a connection design piece). Figure 140 is an explanation figure to show the structure of detail design piece data.

Figures 9 to 11 are to show the structure of a detail design piece in the form of relational DB. Figures 56 and 57 are to show the structure of the same detail design piece in the form of a spanning tree. Various data for various items as shown in Figures 9 to 11 or in Figures 56 and 57 are related to the detail design piece and stored in related databases.

The detail design piece data 24 also consists of planning design pieces and connection design pieces. A planning design piece here is a set of data that manages elements which compose a total management piece 23 (such as columns, beams, floors, walls, ceilings and furniture). Here, typical examples of such elements in the design process are a wall base element and a wall finish element that compose a wall. A connection design piece here is a set of data that manages competing between these planning design pieces or fitting at edges, such as competing between wall bases. The detail design piece 24 is generated from the total design piece 23 and the DL 22, and is related to the total design piece 23 through the detail design management data contained in the total design piece 23, and through total design piece management name contained in the detail design piece 24.

It is possible to register necessary conditions that an arbitrary element of the total design piece or the detail design piece must satisfy in request data bases for the total design piece and the detail design piece. Whether such conditions are satisfied or not is checked at each design stage.

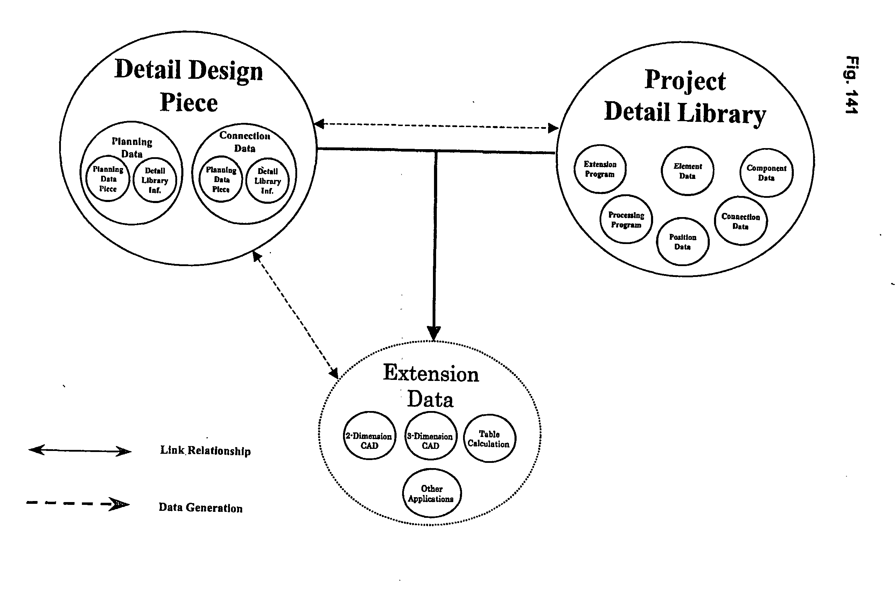

Figure 141 is an explanation figure to show the structure of extension data.
The extension data 25 in Fig. 1 are drawing data that can be read by a CAD system, for example, quantity surveying data that can be read by a table calculation software for cost estimation, endurance period management data or structure analysis data obtained by simulations. The extension data are related to a detail design piece through the extension data management attributes in the detail design piece from which the extension data are generated.

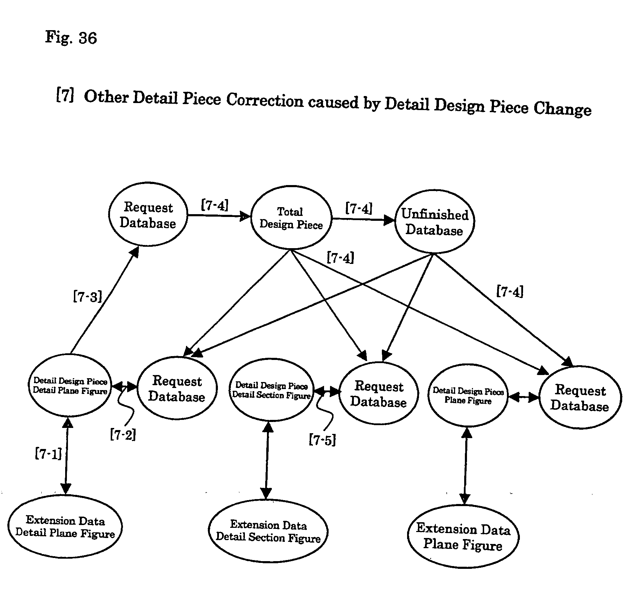

Relationship between the total design piece, detail design piece and extension data are shown in Fig. 36. As shown in the figure, in one specific design project there exist several number of detail design pieces based on various design requirements such as a plane figure, a detail plane figure and a section figure, corresponding to one set of total design piece data (a wall element, for example). Similarly, according to requirements there may be one or several sets of extension data which are output data such as various drawings, quantity survey information and cost estimation information, corresponding to one detail design piece.

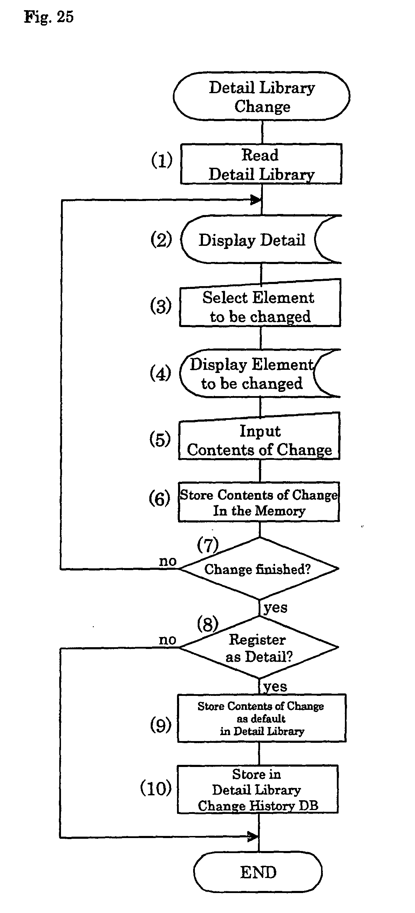

When the design is to be corrected, the total design piece 23, the detail design piece 24, the extension data 25 and the DL 22 are corrected by the total design correction means 13, detail design correction means 14 and the extension data correction means 15. Related other data are also corrected by the correction synchronization means 17. Details will be explained in embodiment examples in the following (see Fig. 25 for DL correction and Fig. 26 [7], [8] for correction of a total design piece, detail design piece and extension data).

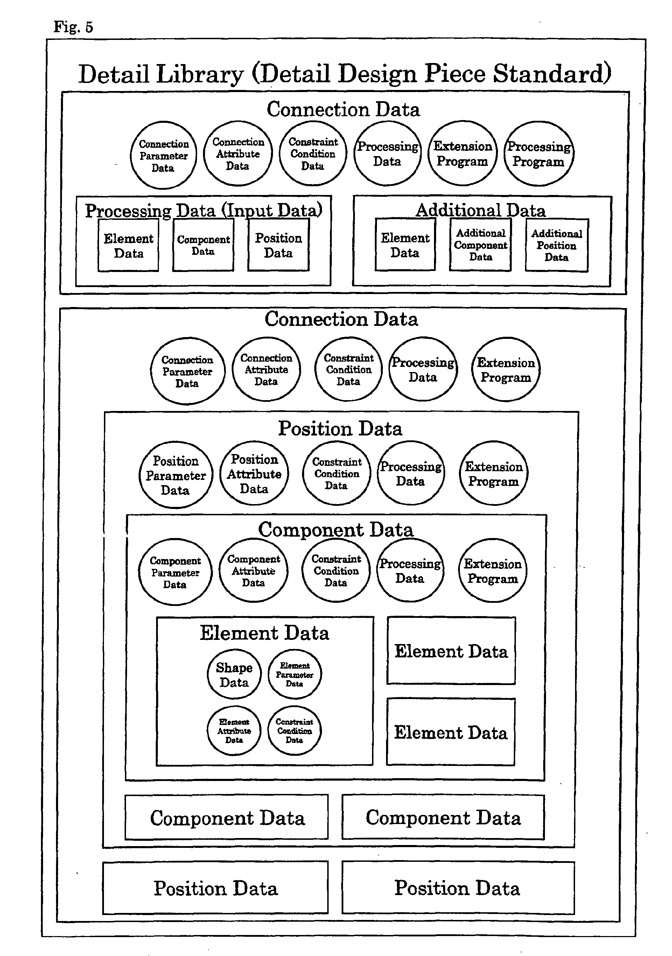

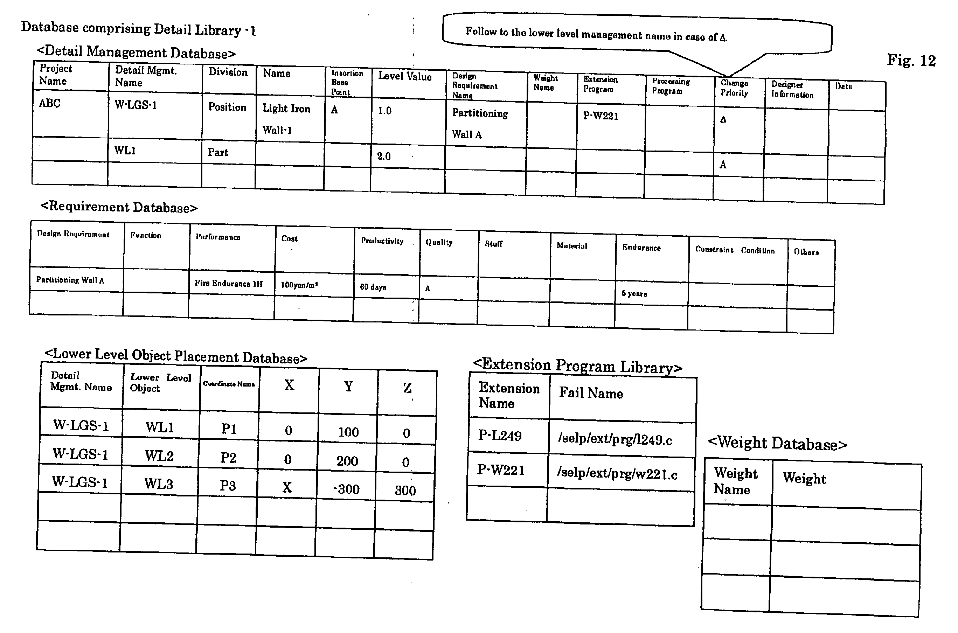

Figure 5 is an explanation figure to explain the data structure of a DL. Figures 12 to 14 are explanation figures to explain the structure of DBs that compose the DL.

The DL 21(22) in Fig. 1 contains element data, component data position data and connection data. Here these element data, component data, position data and connection data are generated by segmenting first the target object for design, construction and management, typically a building, into an "element" that is a significant minimum unit as a component of the target object, a "component" that is a combination of elements (an element complex), a "position" that is a combination of components or positions, and a "connection" that shows an competing position of a number of positions or components or fitting portion at an edge, and then defining these element data, component data, position data and connection data by using such segments.

It is desirable to define a "component" layer item to correspond to each of component materials or commodities that are available in the market. By doing this, it becomes possible to define various complex requirements for such commercially available component materials or commodities as the items in the "element" layer that is positioned as the lower layer of the "component" layer. Additionally, by defining design knowledge of component combinations as an item of the "position" layer that is the upper layer of the "element" layer, it becomes possible to prevent leakage of "position" information that is valuable design knowledge, while at the same time to enable flexible information circulation, by enabling logical information transmission and collection for such information as various requirements in detail, range specifications and selection conditions at the procurement of component materials or commodities in the market.

It is also desirable that a "component" layer item corresponds to each of component materials or commodities that are available in the market rather than to an "element" layer item in order to circulate information smoothly over different industries or sections in the building construction, since a "significant minimum unit" may be different for each industry or for each section of the building construction.

In the case of an H-shape steel in the detail library for structure design, for example, a flange that is a plate to support bending stress is defined as an "element" that is the significant minimum unit and the H-shape steel itself is defined as a "component". But in the detail library for artistic design, an H-shape steel itself may be defined as an element as a significant minimum unit, while it may be defined also as a "component". Although it is possible for each section such as artistic design section or structure design section, or each process such as design or construction to share the same detail library, it is better to circulate information at the component layer. This is because it is actually difficult for sections or organizations in the building construction industry that is becoming more complex, diversified and advanced, to share a detail library containing design knowledge as property, while it is common that building design is carried out by a number of sections and organizations in parallel.

There may be an item that is both an element and a component at the same time. For example, a wall paper as a component is also an element, for it cannot be decomposed to a smaller unit. Similarly, for a wall, the wall itself is a position, and units such as the wall base and the wall finish are positions also. A connection is defined as a competing between walls, floors, columns or beams, or fitting at a wall edge.

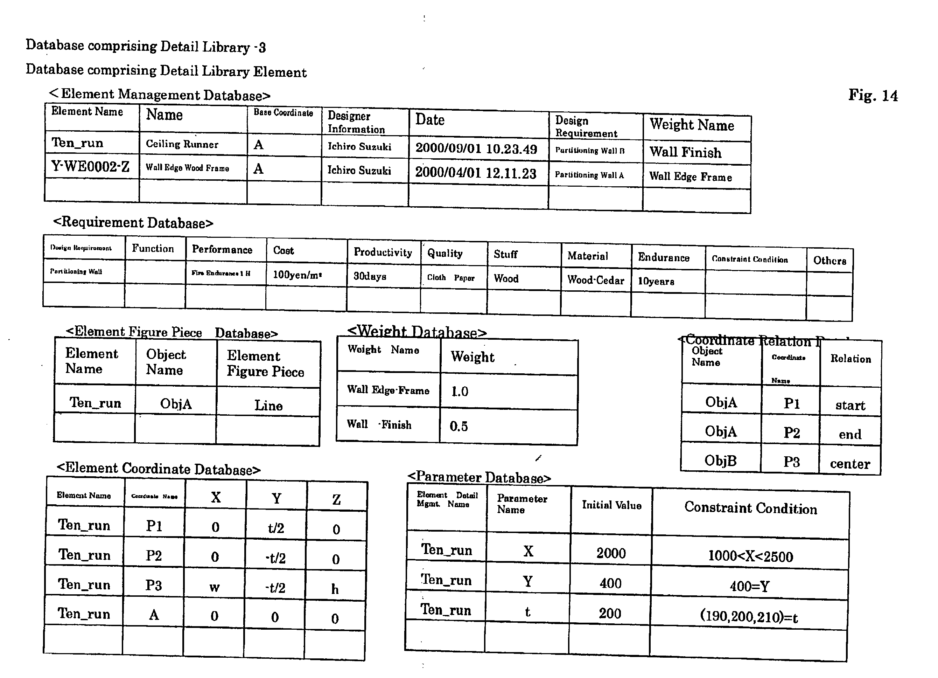

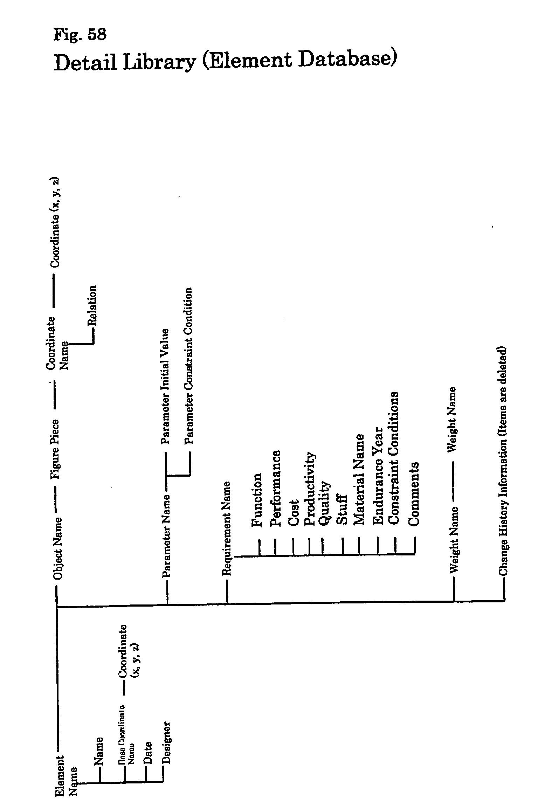

Figure 58 is an explanation figure to show the data structure of a DL (the element DB). Figure 14 is an explanation figure to explain the structure of DBs that compose an element of the DL. The element data consist of a complex of element data that define the shape, requirement information, weight information, generation history information, parameter information and constraint condition information of the element that is a significant minimum unit composing a building.

In the element data mentioned above, the shape is defined by using a shape generation interface or by using one of modeling soft wares (including CAD or CG), with the definition of coordinate points that are the basis of the shape. Other attributes are defined according to necessity. The attributes include decision programs for placement conditions such as geometrical constraints, or for size constraints. The element is different from the conventional attribute defined for a shape piece object, in that the element has a physical meaning also through one by one correspondence between the significant minimum unit and the shape.

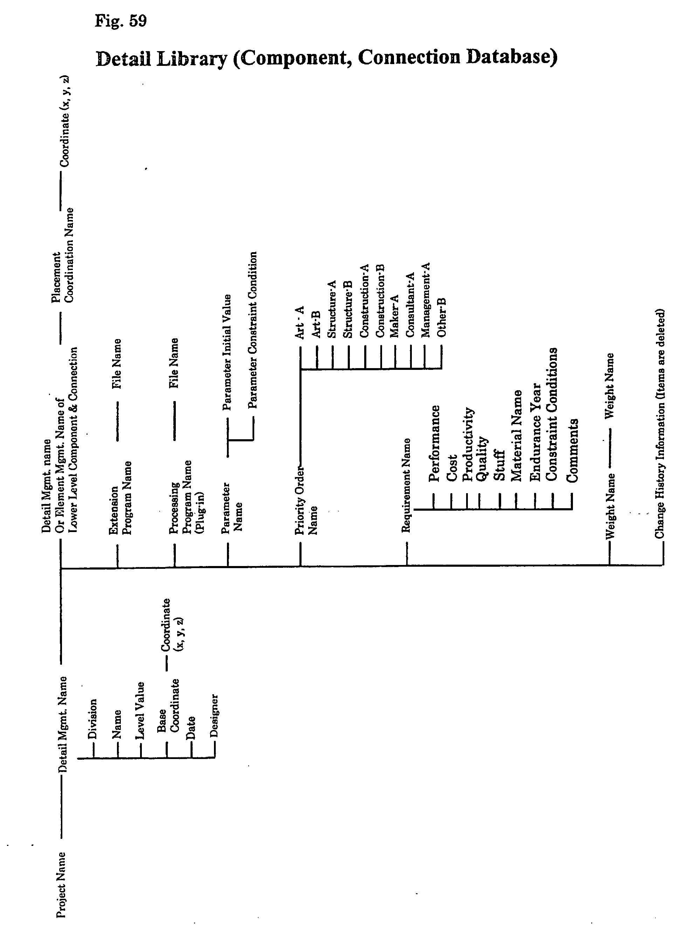

Figure 59 is an explanation figure to show the data structure of the DL (a component, a position). The component data define requirement information, weight information, priority order information, parameter information, process program information, extension program information, constraint information, generation history information and element management information of a component (including such as a unit treated as an element material or a commodity) that consists of a combination of above-mentioned elements. In this component data library, such data contained in the aforementioned element data library can be also contained or not.

As explained above, when a minimum unit of a component is also an element, the shape of the component is defined by the element, and element placement information or component attributes are defined as the component data. The position data consist of a complex of position data that define combinations of, or requirements for elements, components and positions at each position in a building such as a floor, a wall or a ceiling. Placement information and attributes of components such as floors, walls (inner and outer), ceilings, furniture, windows or stairs, are defined as position data. Position data corresponds to a basic unit for each process, such as design or construction.

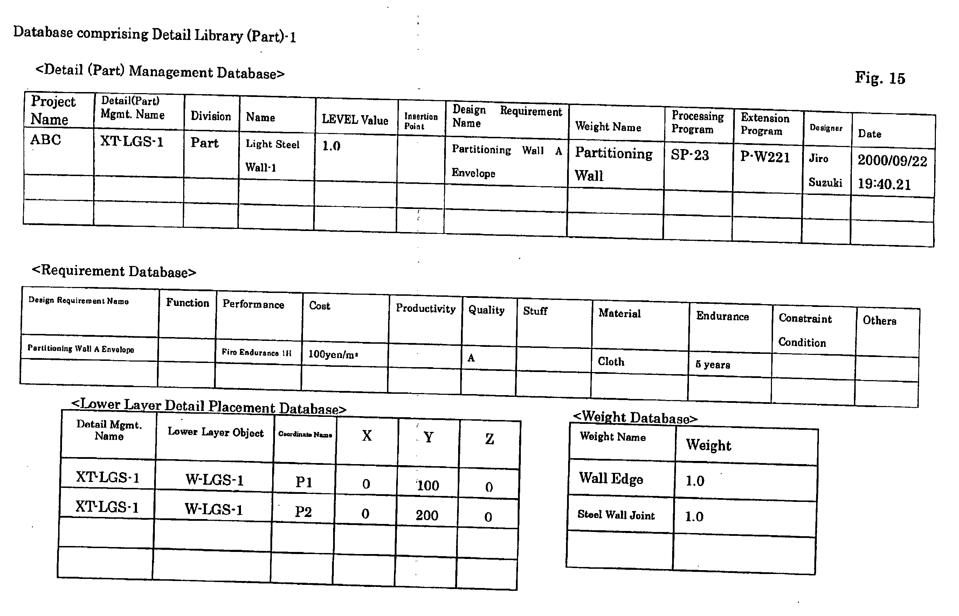

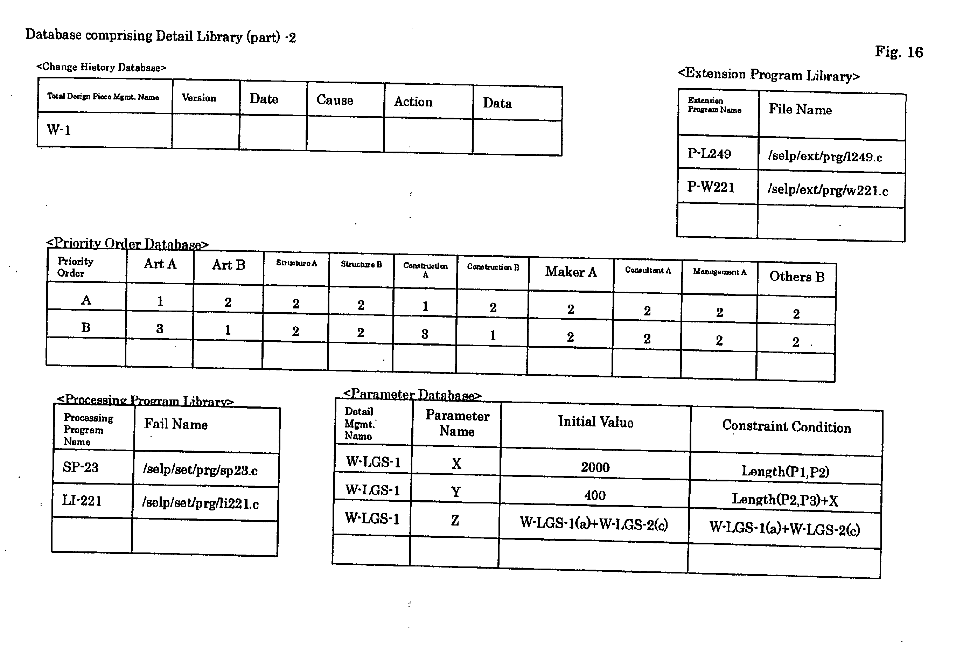

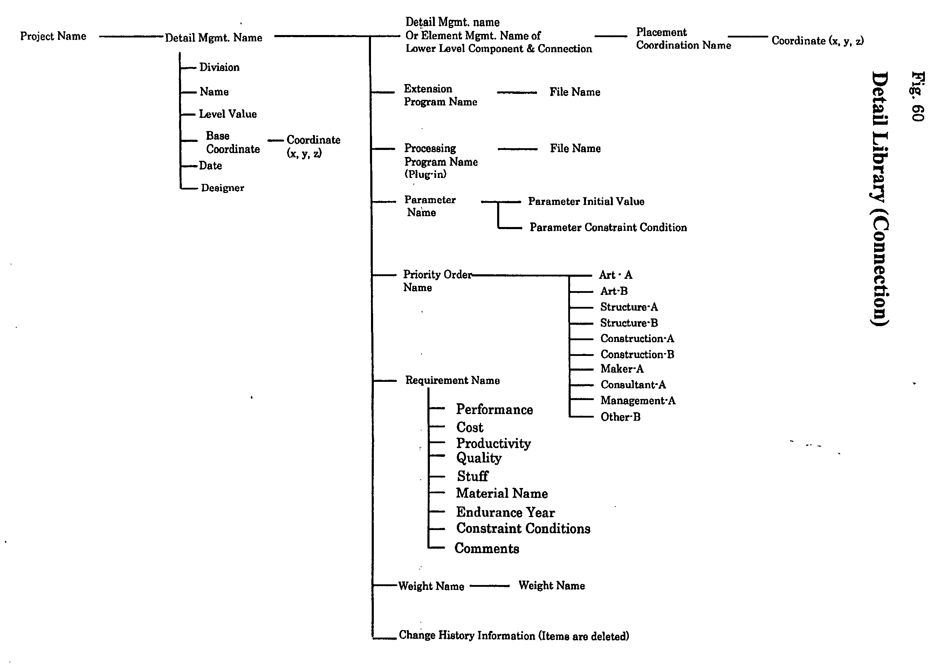

Figure 60 is an explanation figure to show the data structure of the DL (connection). Figures 15 and 16 are explanation figures to explain the structure of DBs that compose elements of the DL (connection). The "connection" data consist of a complex of connection design pieces that define competing or fitting between positions, between a position and a component and between components, and of a complex of connection design pieces that are defined by a combination of elements, components and positions. The latter definitions by a combination of elements, components and positions are made for a connection of a building where expression by positions only is impossible, as is similar in the case of position. Attributes as a "connection" are defined as connection data for placement information and for cross point information of each position and component.

Items such as the endurance period of a component or a price of a component may be recorded in each data library. The whole DL is composed of these four layered libraries (element, component, position, and connection).

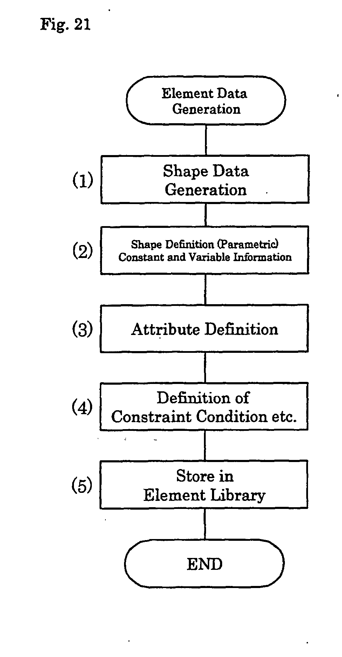

Next, generation and correction of the DL is explained. In designing a building, it is desirable to generate and correct elements, components, positions and connections and store them in the master DL prior to the start of design, through processes shown in Figures 21 to 25. If DL data were generated in past designs, the data can be utilized in a new design as they are, thus the DL is renewed and refined more and more for the next new design.

Figure 21 is a flow chart to show the element data generation process. Details of each step of (1) to (5) of the process in Fig.21 are shown in the following.
(1) Generate a shape by using a shape generation interface, or by using software such as CAD, CG, or modeling software. Either of a two dimensional shape or a three dimensional may be allowed and the name of the shape, the coordinates for the point of the shape, the name for the coordinates and relationship between them are defined. In the case where the shape is a two dimensional circular arc, for example, the information that is an arc, the coordinates of the center point of the arc, the name of the center point and an expression showing relationship between them such as "the center point" or "CENTER" and information of the starting point and the destination point. Since the shape information is deployed by the extension program in the detail library, shape definition at element layer is made so that it has the most suitable form when used by the extension program. Shape definition is not necessarily required since elements do not always have a shape (in such a case where attributes for component definition include some work as an element, for example. In such cases the element itself doesn't have a shape but may have a number of attributes, constraint conditions and a complicate selection alternatives.
(2) Define fixed information and variable information additionally for the shape data that is generated at (1). Also set nominal values for the variable information (parameters), and store them as default values.
(3) Define requirements (functions, performance, cost, productivity, quality, and the endurance period), generation history information (date of generation and the information of the person who generated the element) and weight information. Here the weight information is the weighting coefficients that are used in the extension program at the output of drawings, for example, to decide which of the concerned elements should win for competing or fitting. In the case of crossing by wall base and wall finish, for example, wall base wins e wall finish according to weights, and the wall base expression lines include the wall finish expression lines. The requirements to be defined may include a program that outputs requirements from the input of a shape and its constraint conditions, when requirements that should be satisfied by the element must be modified according to other requirements such as dimensions of the shape.
(4) Define constraint conditions for information defined by step (2) and (3). These constraint conditions may be a program that outputs constraint conditions from the input of a shape and a number of requirements, when the constraint conditions that should be defined change according to dimensions of the shape or other requirements.
(5) Store the resultant contents of steps (1) to (4)

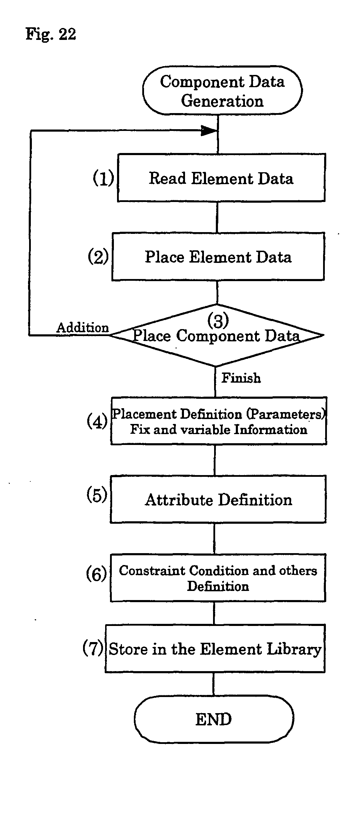

Figure 22 is a flow chart to show the generation process for the component data in the DL. Details of each step of (1) to (7) of the process in Fig.22 are shown in the following.
(1) Read element data from the element data library.
(2) Place the element data on a two dimensional screen by using the component generating interface. If the element to use doesn't have a shape, select an appropriate element DB and register it.
(3) Check whether placement and registration of all element data are completed or not. If not finished, repeat steps of (1) to (3)
(4) Define fixed information and variable information (parameters) for the element data placed by steps (1) to (3). Set nominal values for variable information (parameters) and store them as the default values.
(5) Define requirements to be met by the component, priority order information, extension program information, processing program information, generation history information and weight information. These requirements that should be satisfied by the component may be a program that outputs requirements to be met by the component from the input of the element placement and combination information or other requirements, when the requirements are changed according to the element placement and combination or other requirements.
(6) Define constraint conditions for the information defined in the steps of (2), (4) and (5). The constraint conditions may be a program that outputs constraint conditions from the input of the element placement and combination information or other requirements, when the requirements are changed according to the element placement and combination information or other requirements.
(7) Store the contents of (2), (4), (5) and (6) in the component DB so that the contents can be utilized later.

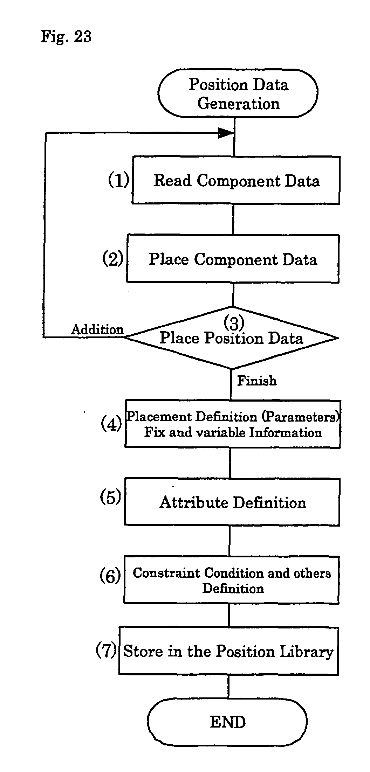

Figure 23 is a flow chart to show the position data generation process. Details of each step of (1) to (7) of the process in Fig.23 are shown in the following.
(1) Read position data and component data from the position data library and the component data library.
(2) Place the position data and component data on a two dimensional screen by using the position generating interface.
(3) Check whether placement of all data is completed or not. If not finished, repeat steps of (1) to (3).
(4) Define fixed information and variable information (parameters) for the position data and component data placed by steps (1) to (3). Set nominal values for variable information (parameters) and store them as the default values.
(5) Define requirements to be met by the position, priority order information, extension program information, processing program information, generation history information and weight information. These requirements that should be satisfied by the position may be a program that outputs requirements to be met by the position from the input of the placement and combination information of positions and components, or other requirements, when the requirements are changed according to the placement and combination information of positions and components, or other requirements.
(6) Define constraint conditions for the information defined in the steps of (2), (4) and (5). The constraint conditions may be a program that outputs constraint conditions from the input of the placement and combination information of positions and components, or other requirements, when the requirements are changed according to the placement and combination information of positions and components, or other requirements.
(7) Store the contents of (2), (4), (5) and (6) in the position DB so that the contents can be utilized later.

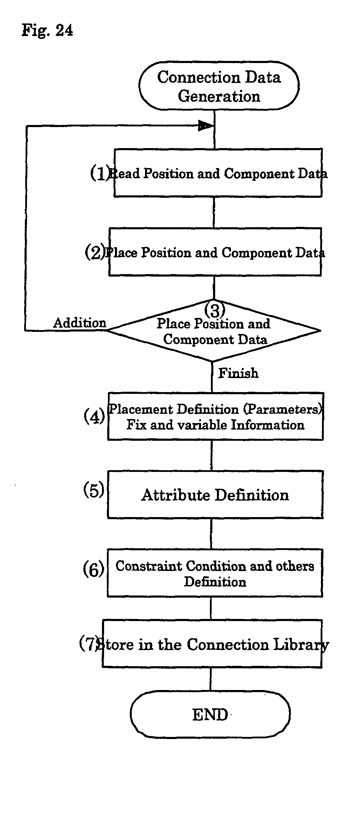

Figure 24 is a flow chart to show the connection data generation process. Details of each step of (1) to (7) of the process in Fig.24 are shown in the following.
(1) Read position data and component data from the position data library and the component data library.
(2) Place the position data and component data on a two dimensional screen by using the connection generating interface.
(3) Check whether placement of all data is completed or not. If not finished, repeat steps of (1) to (3).
(4) Define fixed information and variable information (parameters) for the position data and component data placed by steps (1) to (3). Set nominal values for variable information (parameters) and store them as the default values.
(5) Define requirements to be met by the connection, priority order information, extension program information, processing program information, generation history information and weight information. These requirements that should be satisfied by the connection may be a program that outputs requirements to be met by the connection from the input of the placement and combination information of positions and components, or other requirements, when the requirements are changed according to the placement and combination information of positions and components, or other requirements.
(6) Define constraint conditions for the information defined in the steps of (2), (4) and (5). The constraint conditions may be a program that outputs constraint conditions from the input of the placement and combination information of positions and components, or other requirements, when the requirements are changed according to the placement and combination information of positions and components, or other requirements.
(7) Store the contents of (2), (4), (5) and (6) in the position DB so that the contents can be utilized later.

Figure 25 is a flow chart to show the DL change process. Details of each step of (1) to (10) of the process in Fig.25 are shown in the following.
(1) Read DL data (elements, components, positions and connection)
(2) Place the DL data on a two dimensional screen.
(3) Since data of a component, a position or a connection have a layered structure, select DLs (an element, a component, a position or a connection) that should be changed.
(4) Display the information of the selected DLs (an element, a component, a position or a connection) on a two dimensional display.
(5) Make necessary process of addition, replacement or deletion by using DL change interface.
(6) Record the contents of change made by (5) in a memory.
(7) Decide whether the changes are finished or not. Go to (8) if finished, and return to (2) if not finished yet.
(8) Decide whether contents of the changes should be registered in the DL or not. If it should be, then advance to (9).
(9) Register the stored contents of the changes made by (6) in the DL as the default values.
(10) Register the change history to the DL change history DB.

Each process in the system of this information will be explained in detail by using design procedure in building design as an example.

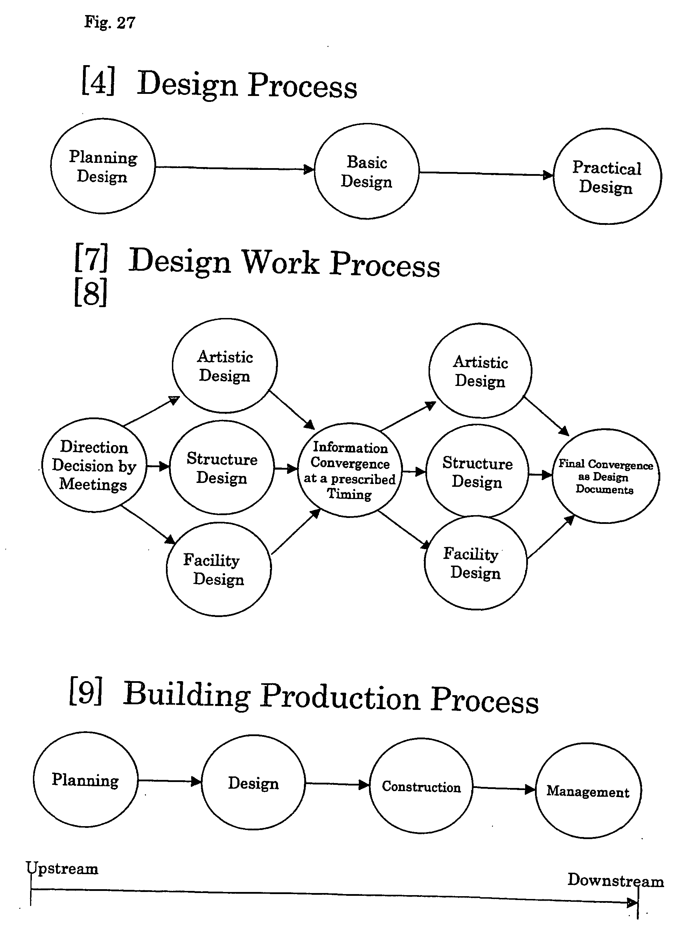

Figure 26 is a flow chart to show the outline of a design example using the system of this invention. Figure 27 is an explanation figure to show the execution timing of each process in Fig. 26, and to show each process of a building production.

At the step (1) in Fig. 26, a plane figure is generated as a planning figure that is composed of figure pieces by using a two-dimensional CAD system, as is the same process in a conventional building design CAD. Then, generate total design pieces (planning design pieces) by selecting objective figurepieces and by selecting and attaching necessary related data in the DL to them.

At the step (2), total design pieces (connection design pieces) for already generated total design pieces (planning design pieces) are generated. At the step (3), planning design pieces and connection design pieces are generated as detail design pieces that correspond to plane figures for the generated total design pieces, and also extension data that are used as the drawing data of the plane figures are generated, corresponding to the detail design pieces. Processes up to this point are the initial design stage.

At the step (4), change of total design pieces from basic design purpose to practical design purpose is carried out through the DL replacement process. At the step (5), detail design piece (detail plane figures) are generated. At the step (6), detail design piece (detail section figures) are generated. At the step (7), changes in detail design pieces (detail plane figures) and reflections (synchronizations) to other detail design elements are carried out. At the step (8), changes in total design pieces (detail plane figures) are carried out. Processes up to this point are the practical design stage (practical design). In actual design, steps from (5) to (8) are iterated by a number of designers.

At step (9), generation of total design pieces and detail design pieces for construction work are carried out by the DL replacement for each design piece. This process corresponds to the construction stage.

As shown in Fig. 27, one whole construction process (a project) is started by planning and then followed downstream by design, construction and management. Similarly, design process is started by planning design and then followed downstream by basic design and practical design. Once design direction is determined at a design meeting, various design works such as artistic design, structural design or facility design are carried out by many designers independently (information divergence). During the design process, information feedback and convergence as a common knowledge are made at an appropriate prescribed timing. Information reflection to all other design processes by an addition or a correction is an example of such information convergence. Iteration of these divergence and convergence of information are made during the design process, and the final results are converged as the design documents (drawings).

The contents of each step in Fig. 26 are explained in detail in the following.

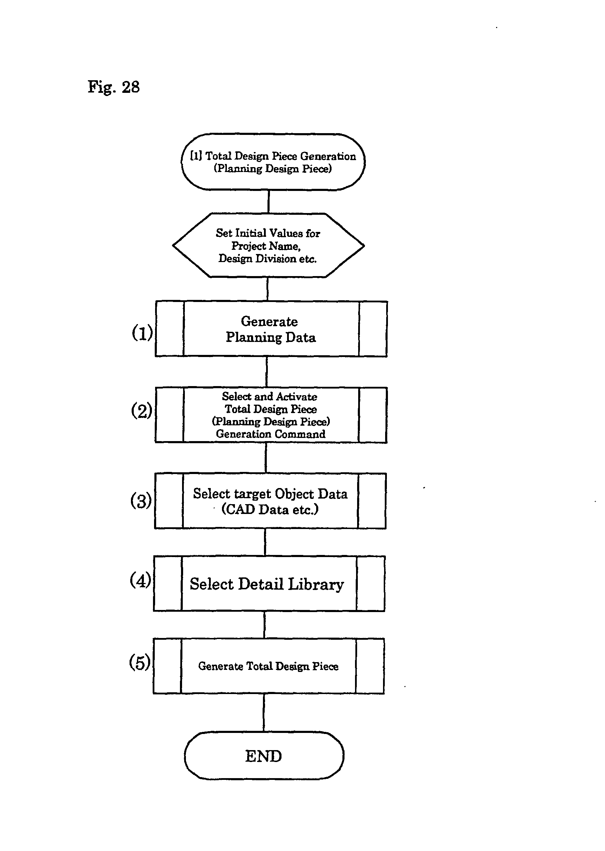

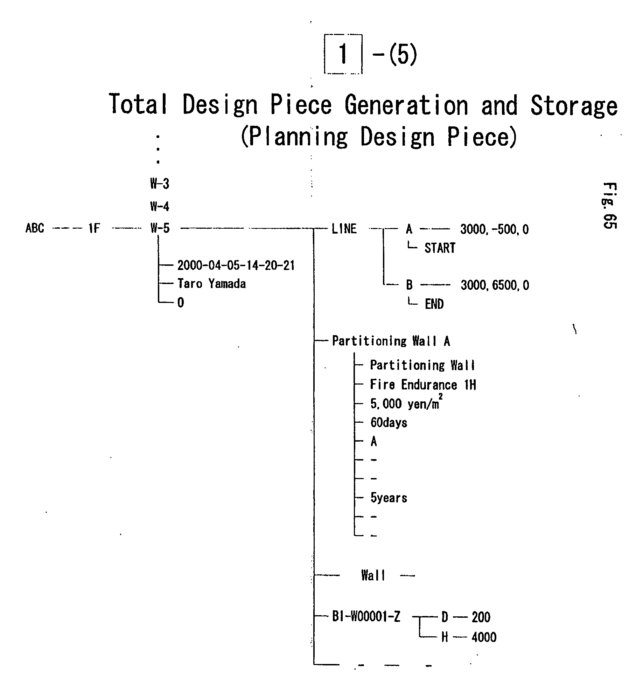

Figure 28 is a flow chart to show the generation process for total design pieces (planning design pieces) in Fig. 26 (1). Firstly, the project name, design part (such as floor 1, F1, or floor 2, F2) and designer's name are set as initial values. Then the following processes (1) to (5) are followed;
(1) The designer generates planning data pieces (figure pieces such as segments and their placing point information) by using the external application software such as a CAD program or by using the CAD function included in the system. (Figures 61 to 63).
(2) A generation command is selected from processing menus for total design pieces (planning design pieces).
(3) Select one of the planning data pieces generated (a segment corresponding to a wall) (Fig. 64). The selection may be either one or more.
(4) A menu of DLs for "a column", "a floor" and "a wall" are displayed on a screen, and if the designer selects the "wall" in the menu, then a menu such as showing "an outer wall" and "an inner wall (a partition wall") is displayed on the screen. Similarly, if the "inner wall (a partition wall) is selected, then "RC", "LGS" and "an un-determined wall" are displayed, and if the "un-determined wall" is chosen, then the DL that corresponds to the planning data that is selected at the procedure (3).
(5) Generate a total design piece (a planning design piece) from the planning data piece information selected by (3) and from the DL information selected by (4), and store (register) the result in the total design piece (planning design piece) DB. Processes (3) to (5) are iterated (Fig. 65). Contents of each generated total design piece (planning design piece) data are made up from information explained in the following. Figures 6 and 7 are the relational data base format expression of the total design piece (planning design piece), and Fig. 54 is the tree format expression of the same contents. "Project name" and "design connection" are stored by referring to the information set at the initial definition. A series of names are initially given by the system as the "total design piece management name", but they can be changed later. "Figure piece", "coordinate", and "relationship" are stored by referring to the planning data piece selected by (3). For example, when a line segment is generated, the "figure piece" becomes "LINE" and the "coordinate" is stored as a real three-dimensional value set of (x, y, z). The "relationship" shows the relationship between coordinates of the figure piece. In the case of a line segment, for example, the origin point and the destination point are stored as "START" and "END". A series of "coordinate names" are initially given by the system, but can be changed by later. The initially-set information of the "designer information" and the "design date" is obtained from the system and stored as the design record information. "Requirement information", "weight information and "DL information" are initially stored by referring to the default information selected by (4), but can be changed later.

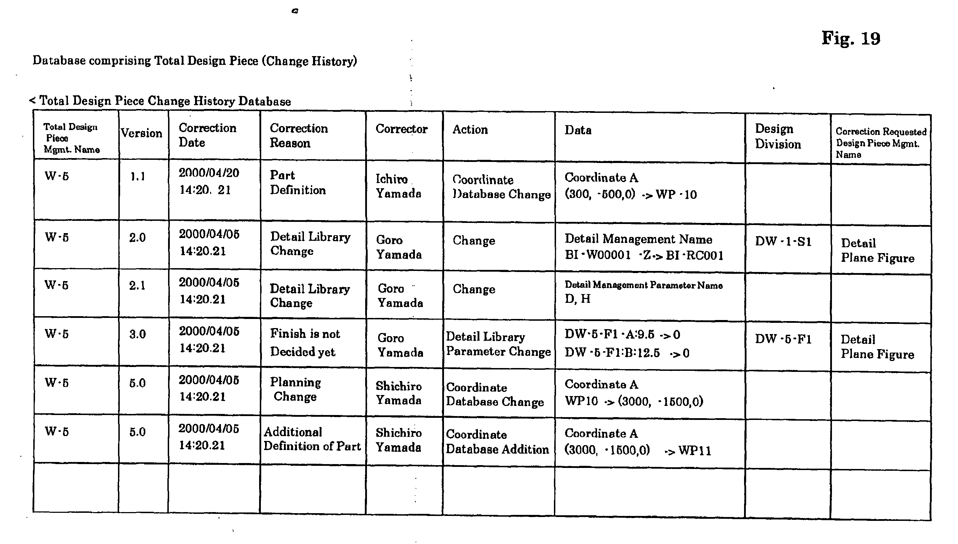

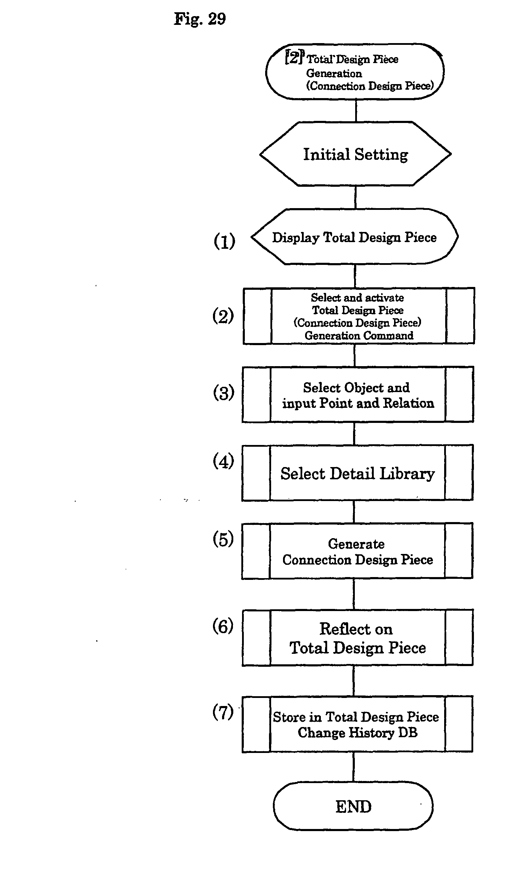

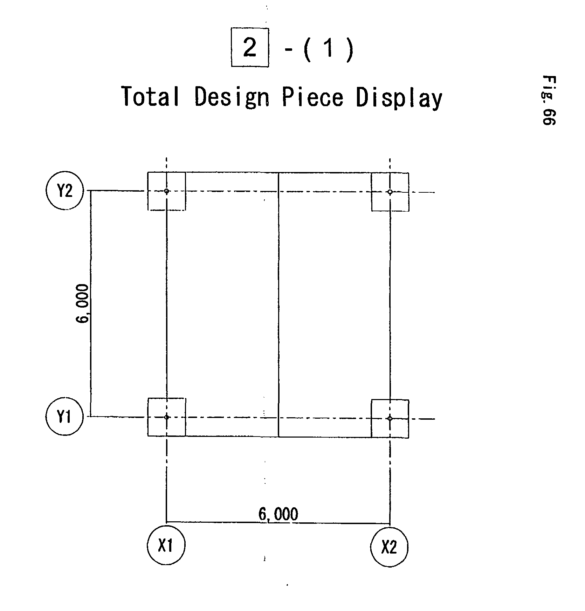

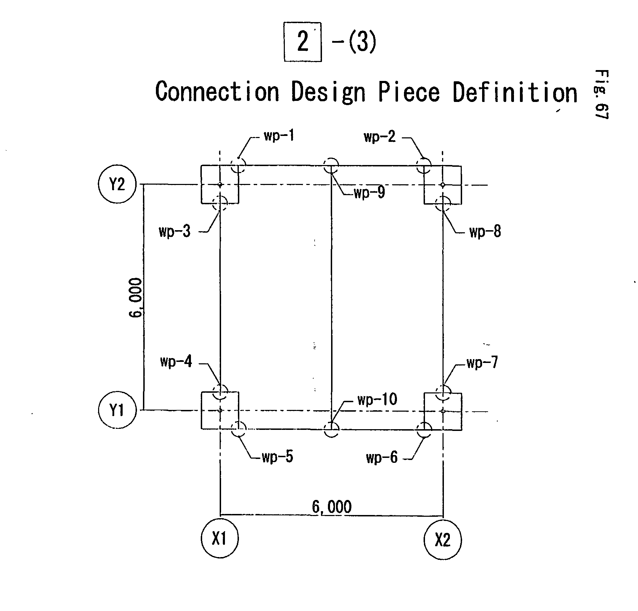

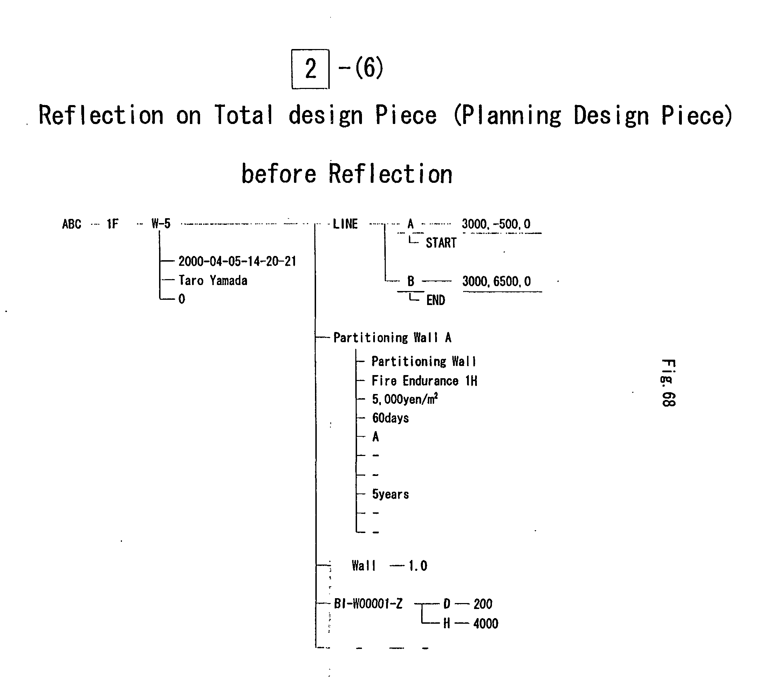

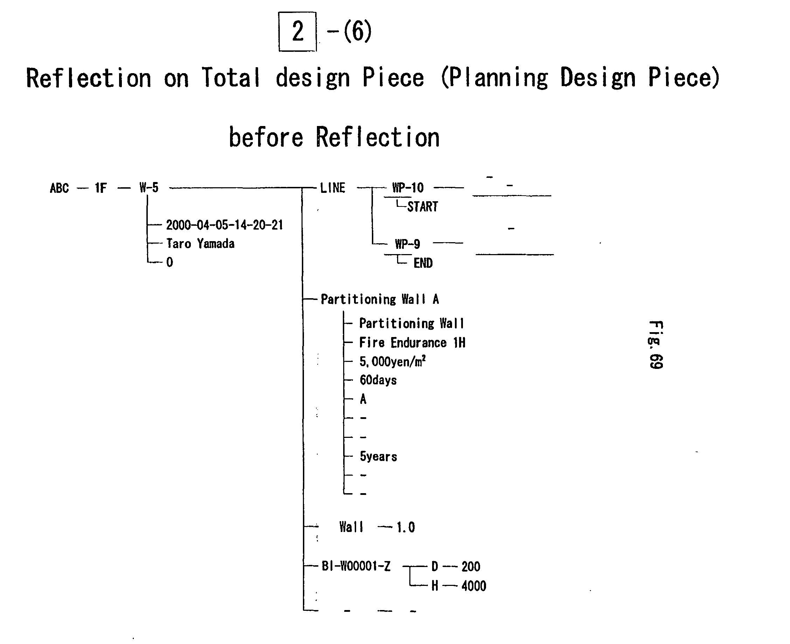

Figure 29 shows a flow chart to show the generation process for the total design pieces (connection design pieces) in Fig. 26 (2).
(1) Display the total design pieces generated by (1). (See Fig. 66)
(2) Select appropriate generation commands among process menu related to total design elements (connection design elements).
(3) Select objects that are related to a target total design piece (connection design piece) among total design pieces (planning design pieces), and input the point information of the target total design piece (connection design piece), the relationship between the point and the objects (such as the median point) and the relationship between the objects (such as an intersection, "INT"). (See Fig. 67)
(4) Select a DL corresponding to the connection chosen by (3). There are options such as "column-wall" and "wall-wall" among the connection DL generating menu. When the "wall-wall" is selected, the next menu showing "1obj-end", "2obj-2way", and "2obj-3way" is displayed. The designer then selects "2obj-3way", for example, which means that the design piece consists of two objects and develops into three directions as a so-called "T shape", for example.
(5) Make up a total design piece (connection design piece) from the total design piece (planning design piece) information, the point information of the connection design piece, the point-object relationship information and object-object relationship information which are selected and entered by (3), and from the DL information selected by (4). Then relates it to the total design piece (planning design piece) and store (register) it in the total design piece (connection design piece) DB. Contents of each generated total design piece (connection design piece) data are made up from information explained in the following. Figures 8 is the relational data base format expression of the total design piece (connection design piece), and Fig. 55 is the tree format expression of the same contents. "Project name" and "design part" are stored by referring to the information set at the initial definition. A series of names are initially assigned by the system for the "total design piece management name" and the "positioning coordinate name", but they may be changed later. The "coordinate" is stored as a real three-dimensional value set of (x, y, z) of the coordinates that are entered by (3). Similarly, relationship between objects that is entered by (3) is stored for "relationship" (the intersection, "INT", for example). The information such as "2obj-3way" that is selected from the menu by (4) is stored as the "relation piece", the total design piece (planning design piece) management name selected by (3) is stored as the "related total design piece management name" and the relationship between the total design piece (planning design piece) and the point of the connection design piece that is selected and entered by (3) is stored as the "related coordinates". For example, "MID(A,B)" means the median point of the line segment between the coordinate A and the coordinate B. "Designer information" and the "generation date" are obtained from the system and stored as the generation history information. "Requirement information", "weight information" and "DL information" are referred from the default values of the DL information selected by (4), but may be changed later.
(6) Reflect the contents of the total design pieces (connection design pieces) generated by (5) upon the total design pieces (planning design pieces). Pick up the total design piece (planning design piece) management name from the "related total design piece management name" of the total design piece (connection design piece) generated by (5), decide whether it has influence on the coordinate database or not referring to the "related coordinates" and return to (3) if it hasn't influence. For example, the median point doesn't have influence on the coordinate database, since the median point has no coordinates. In the case where it has influence, pick up the "coordinate name", search the coordinate record from the coordinate database of the total design pieces (planning design pieces) by the "coordinate name" and then delete the record. Then search the "coordinate relation database" of the total design piece (planning design piece) by the "coordinate name" to replace the searched "coordinate name" by the total design piece (connection design piece) management name. Similarly, search the total design piece relation database of the total design piece (connection design piece) by the coordinate name to replace the searched coordinate name of the related coordinate by the total design piece (connection design piece) management name, if a coordinate name at related coordinates is found. Relationship between the total design pieces (planning design pieces) and the total design pieces (connection design pieces) is defined through these processes, and the coordinate management is transferred from the total design piece (planning design piece) coordinate management to the total design piece (connection design piece) coordinate management (See Figures 68 and 69).
(7) Store the contents change of the total design piece (planning design piece) made by (6) based on the definition of the total design pieces (connection design pieces) defined by (5) into the change history database for the total design pieces. Define all of the total design pieces (connection design pieces) required, through recurring steps (3) to (7) (see Fig. 19).

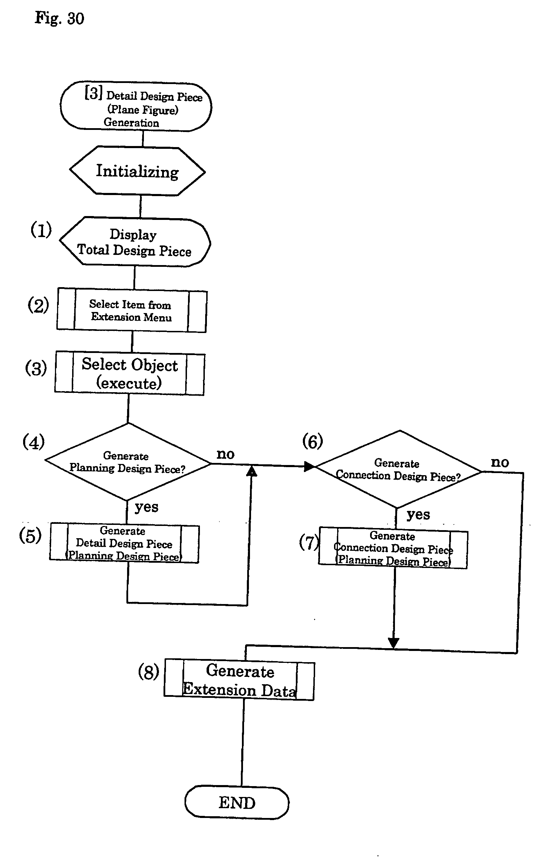

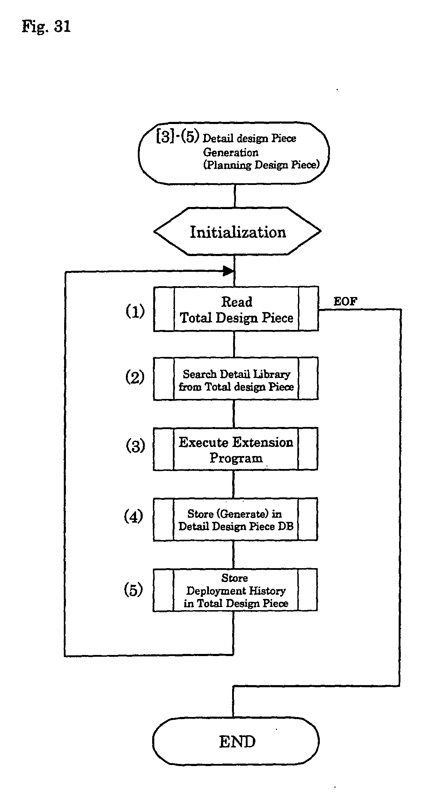

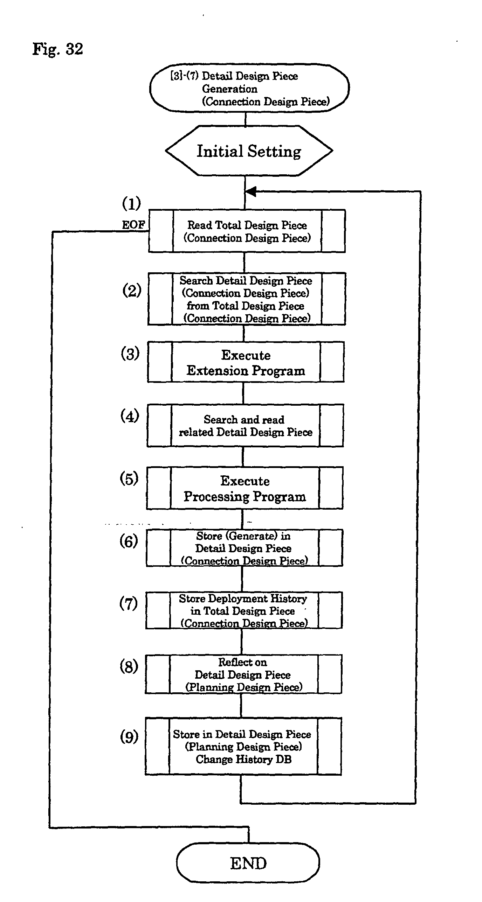

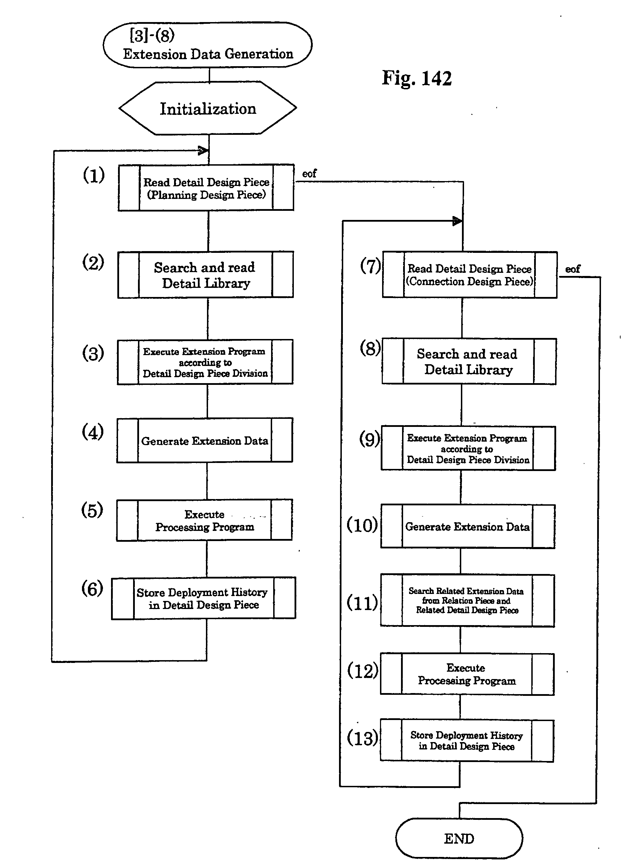

Figure 30 is a flow chart to show the generation process for the detail design pieces in Fig. 26 (3). Processes of Fig. 26 (5) and (6) are the same as this process, except for that the categories of the output detail design pieces are different.
(1) Display a total design piece after setting initial values.
(2) The designer selects one item (command) from the extension menu. There are a "general figure" and a "detail figure" on the menu to output, and there are a "plane figure", an elevation figure" and a "section figure" under the "general figure" as items of the lower layer menu. Similarly, there are items such as a "planning design piece", a "connection design piece" and "planning, connection" under the "plane figure", as items of the further lower layer menu. The selection of a "general figure", a "plane figure" and "planning, connection" by the designer is shown in this example. This is a selection to output a plane figure of a general figure (a figure to show the rough total plan of the project) that is generated at the basic design stage. By these commands, the planning design pieces and the connection design pieces for the detail design pieces, and then the extension data as the output figure data, are generated.
(3) Select one or more objects for which the detail design pieces and the extension data should be generated from total design pieces displayed on the screen (See Fig. 70).
(4) Check whether commands to generate the detail design pieces (planning design pieces) are entered or not. If they are entered, then go to (5).
(5) Generates the detail design pieces (planning design pieces) as shown in Fig. 31.
(6) Check whether commands to generate the detail design pieces (connection design pieces) are entered or not. If they are entered, then go to (7).
(7) Generates the detail design pieces (connection design pieces) as shown in Fig. 32.
(8) The system generates the extension data that are the figure data of the plane figure, by using the DL (extension program), as shown in Fig. 142.

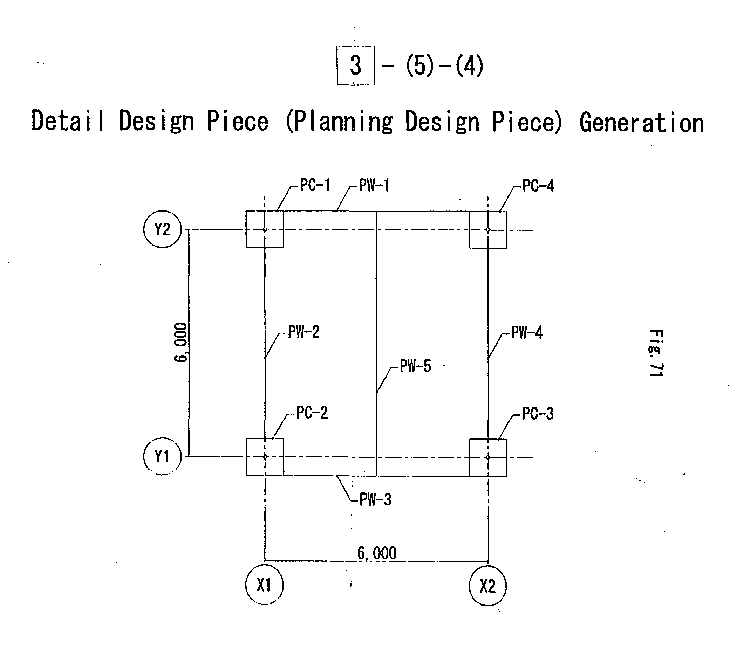

Figure 31 is a flow chart to show the detail of the process (5) in Fig. 30. Initial setting of the file name of the detail design pieces (planning design pieces) of the plane figure and designer's information is carried out first. Then the following steps are followed.
(1) Read total design pieces (planning design pieces) selected by Fig. 30 (3) one by one until all required data are entered.
(2) Search and read the target data library of the project libraries among the data of total design pieces (planning data pieces) that are entered by (1), referring the name of the detail library.
(3) Execute the extension program (generation of planning design elements of detail design elements) of the DL that is entered by (2).
(4) Generate the detail design pieces (planning design pieces) from the total design piece (planning design piece) information read by (1) and the DL information read by (2), relate them to the total design pieces (planning design pieces) and store (register) them in the detail design piece (planning design piece) DB.
   Data of the generated detail design pieces (planning design pieces) are made up by the following information. Figures 9 and 10 are the relational data base format expression of the detail design piece (planning design piece), and Fig. 56 is the tree format expression of the same contents. The "project name", the "design part" and the "total design management name" are stored by referring to the total design piece (planning design piece) information, and the "plane figure" is stored by the menu item selected by Fig. 30 (2). A series of names are initially given by the system as the "detail design piece management name", but they can be changed later.
   For "figure pieces", "coordinates" and "relationship", the extension program (generation of planning design pieces for detail design pieces) processes the input data of the total design pieces (planning design pieces) and outputs the necessary data. When a figure piece as the total design planning piece (planning design piece) is defined as a "LINE" that shows a segment of a line, the detail design piece (planning design piece) is also a segment of a line usually. But in a case where the same patterns of a shape (such as a wave shape) are linearly iterated, the figure piece as the total design piece (planning design piece) is the "LINE" as a segment of a line, but the detail design piece (planning design piece) becomes a series of the recursive patterns of that shape, which indicates that the shape of a detail design piece (planning design piece) not always coincides to the shape of the total design piece (planning design piece). Also the "coordinates" and the "relationship" differ also between the total design piece and the detail design piece. In the building production support system of this invention, however, extension programs are provided to have close relationship with DLs, so that it becomes possible to define building design or artistic design by DLs and make their extension programs for development or processing to be prepared flexibly according to their purposes and requirements.
   Contents of "detail library name", "parameter name" and "parameter contents" are similarly made from the DL input information of the total design piece (planning design piece), stored and outputted as "detail library name", "parameter name" and "parameter contents" that means those of the required detail planning pieces (planning design pieces), plane figures for example, in the layer of total design pieces (planning design pieces), by using the extension program (generation of planning design pieces for detail design pieces).
   The outputted "detail library name", "parameter name" and "parameter contents" as the detail design pieces (planning design pieces) are related to the total design piece (planning design piece) management names that are inputted by (1), and stored in the "detail management parameter database" of the total design pieces (planning design pieces) to be managed as unified information.
   "Requirement information" and "weight information" are generated and stored by referring to the DL default values outputted by the extension program ("planning design piece generation for detail design pieces") at the initial generation, but they may be changed later. Such initial information as "designer information" or "generation date" is provided by the system and stored as the generation history information (see Fig. 71).
(5) Store the "detail design piece deployment part" and the "file name" into the "detail design piece deployment history DB" for the total design pieces (planning design pieces) that are entered by (1). Using this information and the "total design piece management name" that is stored by (4), the total design pieces (planning design pieces) are related to the detail design pieces (planning design pieces).

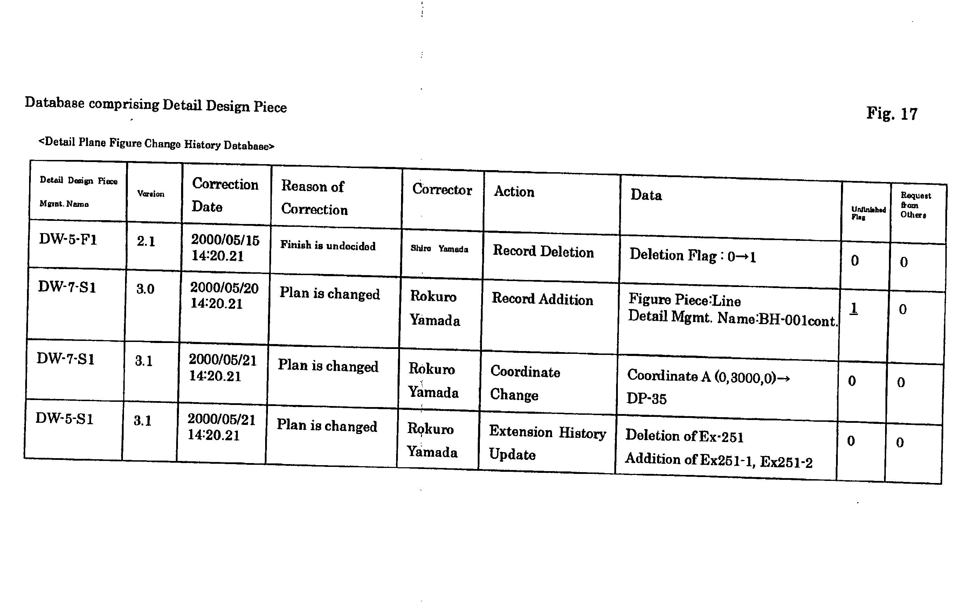

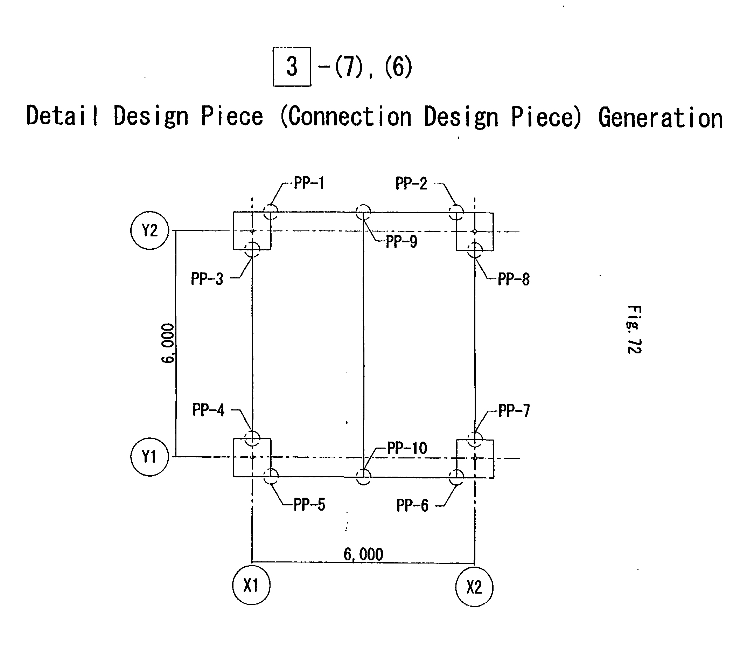

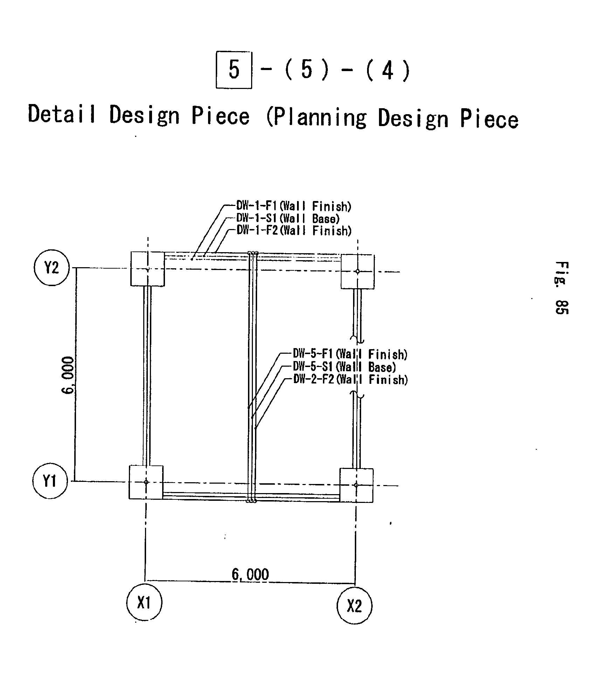

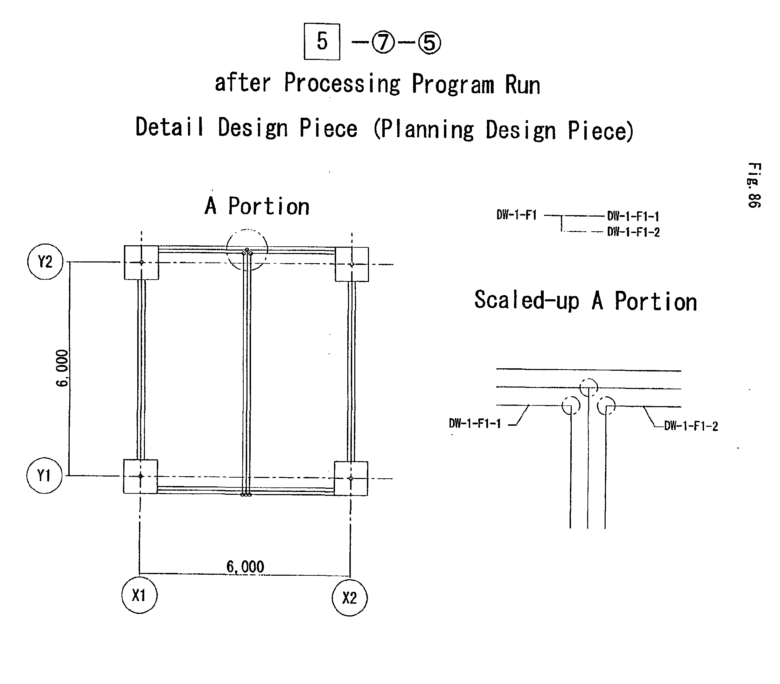

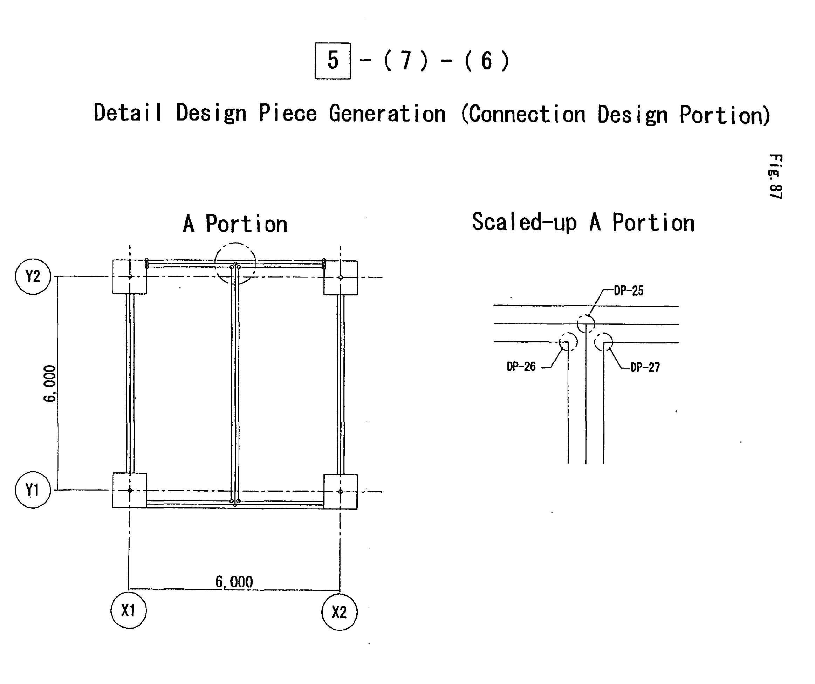

Figure 32 is a flow chart to show the detail of the process (7) in Fig. 30. After the initial setting of file names and designer's information, the following steps are carried out.
(1) First read all data of the total design pieces (planning design pieces) selected by Fig. 30 (3) and store them in the memory of the system. Then search the total design piece (connection design piece) management name from the "total design piece relation DB" of the total design pieces (connection design pieces) by using the total design piece (planning design piece) management names. Then read the total design pieces (connection design pieces) using the total design piece (planning design piece) management names one by one, and finish when all data are processed.
(2) Read the target DL from the project DL, by referring to the detail library name in the total design pieces (connection design pieces) that are inputted by (1).
(3) Execute the extension program (generation of the connection design pieces of the detail design pieces) that are entered by (2).
(4) Refer to the related total design piece management names among the "total design piece relation DB" of the total design pieces (connection design pieces). Then find the "file names" from the "detail design piece deployment history DB" by using the "total design piece management name" and the "detail design piece part" that is the menu information selected by Fig. 30 (2). Next, find the related detail design pieces (planning design pieces) by using the "total design piece management name" among the detail design pieces (planning design pieces) as the "file names".
(5) Carry out the DL processing program that is entered by (2) by using related detail design pieces that are entered (4). The "processing program" for "connection design pieces" is a program to include the crossing parts of the walls, for example. The weight value of each wall segment is defined as weight information. Inclusion process of the cross point by one wall is carried out if the weight values are the same for both walls, considering that the material is the same for the both walls. While, if the weight values are different for each wall, a decision that inclusion by one is not carried out considering that the stuffs are not the same for both walls, or a decision of which wall wins, is carried out (see figures 85 and 86).
(6) Generate detail design pieces (connection design pieces) from the total design piece (connection design piece) information entered by (1), the DL information entered by (2) and processing information by (5). Then relate the detail design pieces (connection design pieces) with total design pieces (connection design pieces) and detail design pieces (planning design pieces), and store (register) the results in the detail design piece (connection design piece) DB. Data of the generated detail design pieces (connection design pieces) are consist of the following information. Figures 9 and 10 are the relational data base format expression of the detail design piece (planning design piece), and Fig. 56 is the tree format expression of the same contents. The "project name", the "design part" and the "total design management name" are stored by referring to the total design piece (connection design piece) information, and the "plane figure" is stored by the menu item selected by Fig. 30 (2). A series of names are initially given by the system as the "detail design piece management name" and the "place coordinate names", but they can be changed later.
   For "coordinates", "relationship", "relationship piece", "relational detail design piece management name" and "coordinate relation", the extension program (generation of connection design pieces for detail design pieces) processes the input data of the information of the processing program by
(5) and the total design pieces (connection design pieces) including the DL information, and then outputs necessary data. Similarly, for "detail library names", "parameter names" and "parameter contents",
   are made from the DL input information of the processing program by (5) and the total design piece (connection design piece), stored and outputted as "detail library name", "parameter name" and "parameter contents" that means those of the required detail planning pieces (connection design pieces), plane figures for example, in the layer of total design pieces (connection design pieces), by using the extension program (generation of connection design pieces for detail design pieces).
   The outputted "detail library name", "parameter name" and "parameter contents" as the detail design pieces (connection design pieces) are related to the total design piece (connection design piece) management names that are inputted by (1), and stored in the "detail management parameter database" of the total design pieces (connection design pieces) to be managed as unified information.
   "Requirement information" and "weight information" are generated and stored by referring to the DL default values outputted by the extension program ("planning design piece generation for detail design pieces") at the initial generation, but they may be changed later. Such initial information as "designer information" or "generation date" is provided by the system and stored as the generation history information (see Figures 72 and 87).
(7) Store the "detail design piece deployment part" and the "file name" into the "detail design piece deployment history DB" for the total design pieces (connection design pieces) that are entered by (1). Using the "total design piece management name" that is stored by (6), the total design pieces (connection design pieces) are related to the detail design pieces (connection design pieces).
(8) Reflect the contents of the detail design pieces (connection design pieces) generated by (6) upon the detail design pieces (planning design pieces). Pick up the detail design piece (planning design piece) management name from the "related detail design piece management name" of the detail design pieces (planning design pieces) generated by (6), decide whether it has influence on the coordinate database or not referring to the "related coordinates" and return to (1) if it hasn't influence. In the case where it has influence, pick up the "coordinate name", search the coordinate record in the coordinate database of detail design piece (planning design piece) by the coordinate name, and then delete the record. Then search the "coordinate relation database" of the detail design piece (planning design piece) by "the coordinate name" to replace the searched "coordinate name" by detail design piece (connection design piece) management name. Similarly, search the detail design piece relation database of the detail design piece (connection design piece) by the "coordinate name" to replace the searched "coordinate name" of the related coordinate by "detail design piece (connection design piece) management name", if a coordinate name at related coordinates is found. Relationship between the detail design pieces (planning design pieces) and the detail design pieces (connection design pieces) is defined through these processes, and coordinate management is transferred from the detail design piece (planning design piece) coordinate management to the detail design piece (connection design piece) coordinate management.
(9) Store the contents change of the detail design piece (planning design piece) made by (7) based on the definition of the detail design pieces (connection design pieces) defined by (6) into the change history database for the detail design pieces. Define all of the detail design pieces (connection design pieces) required, through recurring steps (1) to (7) (see Fig. 17).

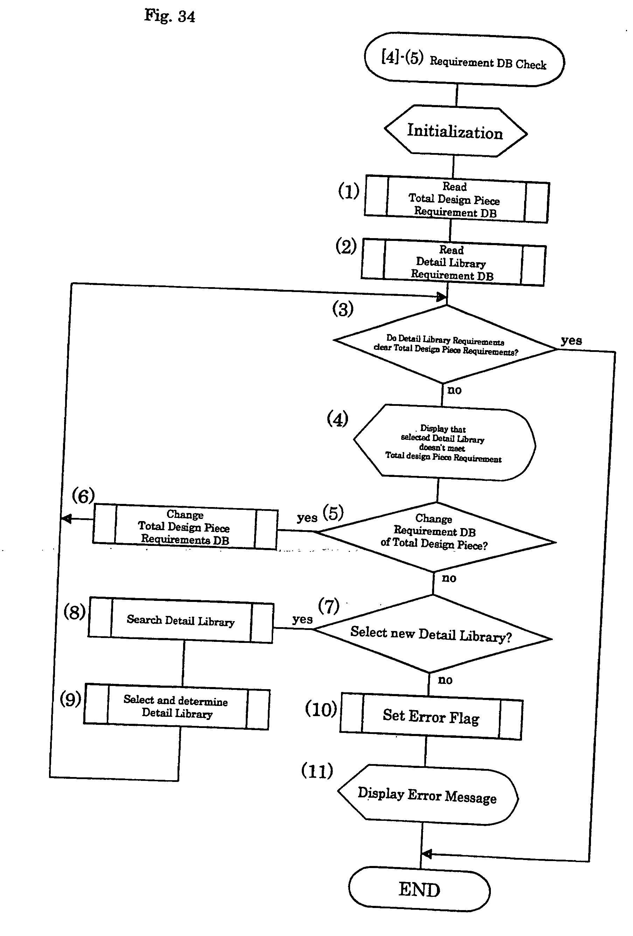

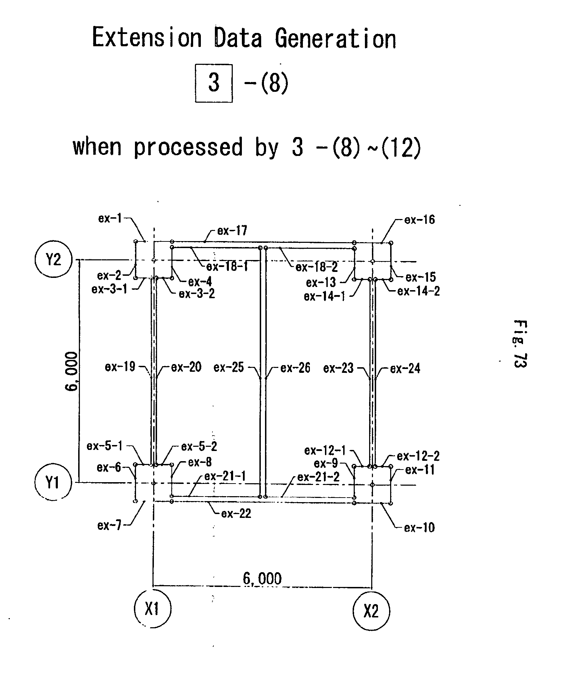

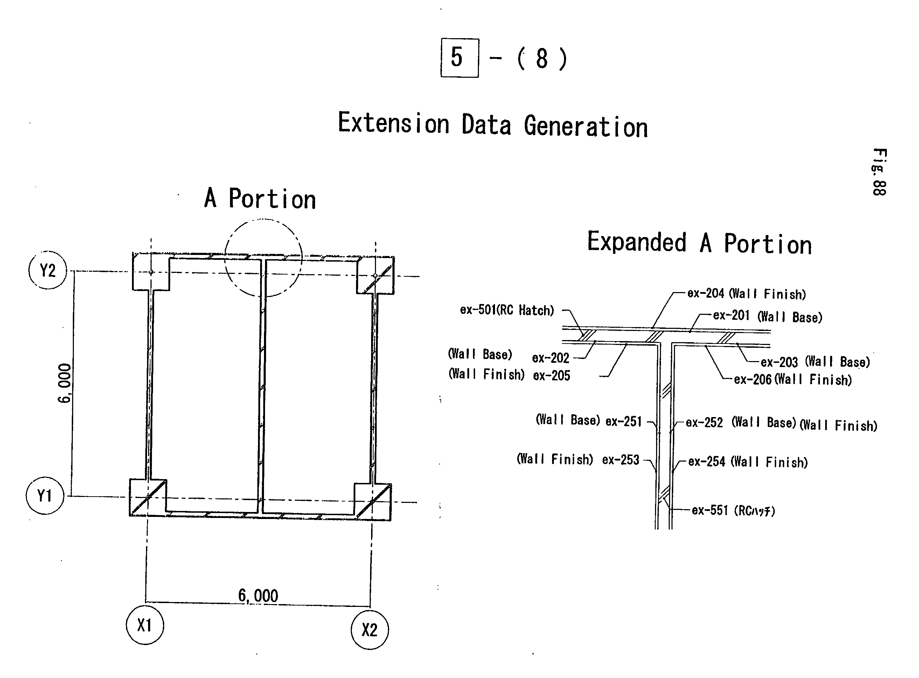

Figure 142 is a flow chart to show the details of process of (8) in Fig. 30. After carrying out the initial setting of the file name and the designer information, following steps follow.
(1) Read the detail design pieces (planning design pieces) generated by Fig. 34 (4) one by one, and go to (7) when all steps are finished.
(2) Search the target detail library among the project DLs referring to the detail library name from the detail design piece (planning design piece) data that are entered by (1), and read it.
(3) Execute the extension program (generation of extension data for the detail design piece part) for the DL that is entered by (2).
(4) Generate the extension data from the detail design pieces (planning design pieces) entered by (1) and the DL information entered by (2). The extension data are generated through steps in the following; Firstly, enter figure piece information, coordinate information and parameter information, by referring to figure pieces (such as "LINE") in the detail design pieces (planning design pieces), referring to coordinate information that represent positioning coordinates in the "coordinate relation DB" and the "coordinate DB" for the detail design pieces (planning design pieces), and then referring to the "detail management parameter DB" for the detail design pieces (planning design pieces). Inputted data are processed by the extension program to calculate and generate the placing coordinates as the output extension data. A series of "extension names" are attached to the outputted extension data (see Figures 73, 88 and 91).
(5) If an extension processing program is defined in the DL information entered by (5) and (2), the extension program carries out extension process and data output, using information obtained by (1), (2) and (4).
   An extension processing program for detail design pieces (planning design pieces) is such a program that a designer defines it in advance as a plug-in program to execute a complicated process, for example to use hatching on drawings to express a wall. The program calculates and outputs like step (4) the extension data from the basic information, or inputs the information obtained by (4), calculates and outputs the extension data. A series of "extension names" are attached to the outputted extension data (see "ex-551(RC hatch)" in Fig. 88, for example).
(6) Store the "extension names" and the "file names" of the extension data generated by (4) and (5), and the names of "detail design piece management names" of detail design pieces (planning design pieces) into the "extension DB" for detail design pieces (planning design pieces), then return to (1).
(7) Read the detail design pieces (connection design pieces) generated by step (6) in Fig. 32 one by one to repeat the same steps. When the processing for all data is finished, end the step.
(8) Search and read the target DL from the project DL by referring to the detail library name from the detail design piece (connection design piece) entered by (1).
(9) If an extension processing program is defined in the DL information entered by (2), carry out the extension program (extension data generation for detail design part).
(10) Generate extension data from the detail design piece (connection design piece) information entered by (7) and from the DL information entered by (8). The extension data are generated through the following steps; Firstly, search the coordinate information for placing coordinates among the "coordinate DB" referring to the place coordinate name of the detail design information (connection design information), and then search the parameter information among the "detail management parameter DB" for the detail design pieces (connection design pieces). By using the coordinate information and the parameter information obtained, the extension program calculates coordinates and others to get the output extension data. A series of "extension names" are attached to the outputted extension data. The extension data for connection design pieces are defined and managed for component information and others that cannot be expressed by positions, such as the competed area by two positions.
(11) Pick up the related detail design pieces (planning design pieces) management names among the "related detail design piece management names" by searching the "detail design piece relation DB" of detail design pieces (connection design pieces) referring to the detail design piece (connection design piece) management name of the detail design piece (connection design piece) that is entered by (7). Then pick up, enter and store in the memory the related extension data and file names, searching the "extension database" by the picked-up detail design piece (planning design piece) management names.
(12) If an extension processing program is defined in the DL information entered by (8), carry out the extension program such as extension data processing and output based on information obtained by (7), (8), (10) and (11). An extension processing program for the detail design pieces (connection design pieces) is such a program that a designer defines it in advance as a plug-in program to execute a complicated process, for example to include the competing area of two walls, or to decide which of two positions wins according to weights. The program calculates and outputs like step (10) the extension data from the basic information, or inputs the information obtained by (11), calculates and outputs the extension data. A series of "extension names" are attached to the outputted extension data.
(13) Store the "extension names" and the "file names" of extension data generated by (10) and (12), "file names" and "detail design piece management names" of the detail design pieces (connection design pieces) into the "extension DB" for the detail design pieces (connection design pieces), relating the detail design piece (connection design piece) and the extension data, then go back to (7).

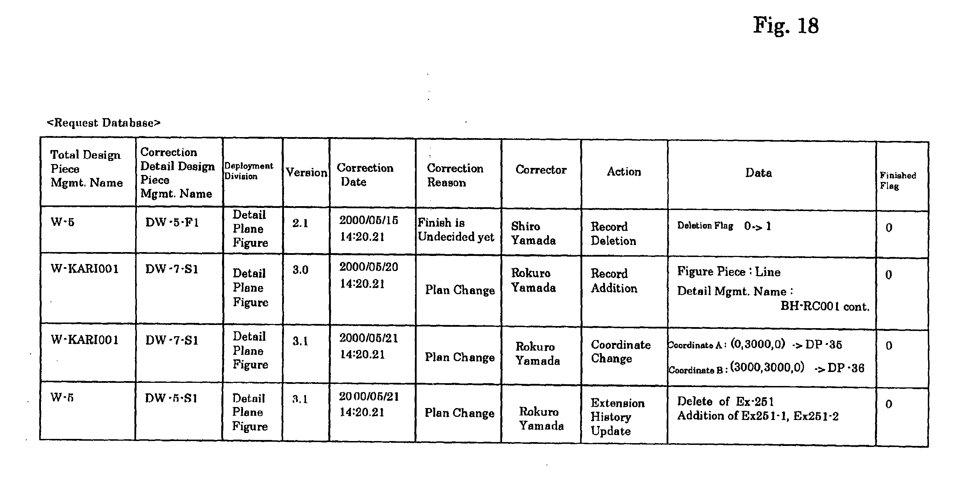

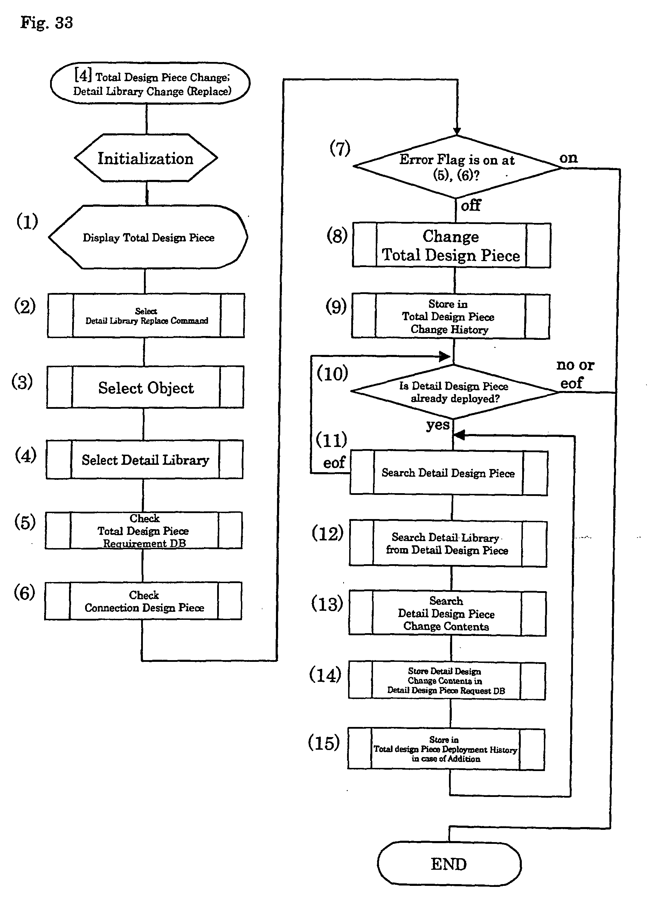

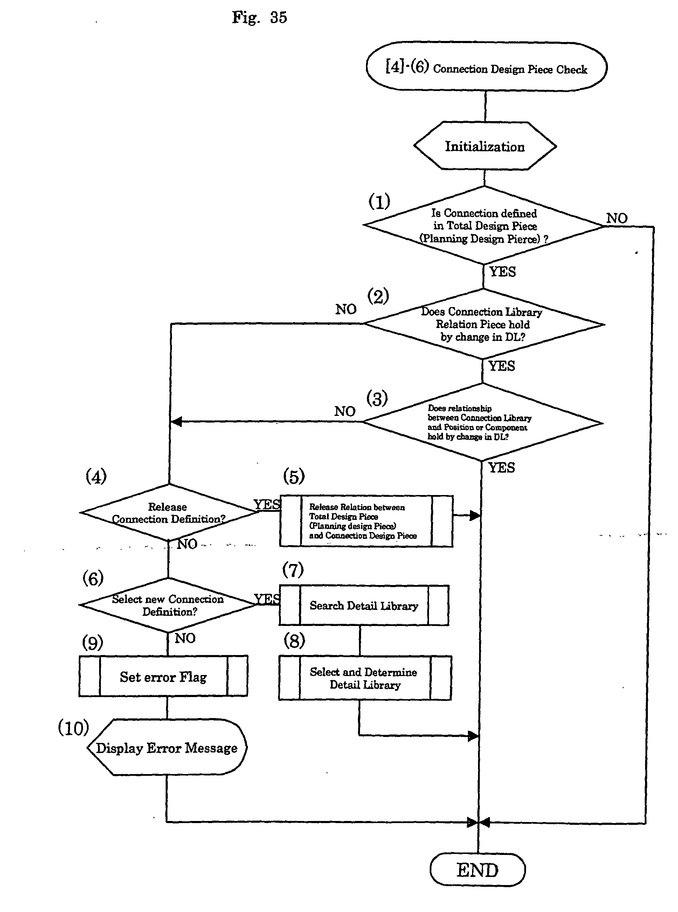

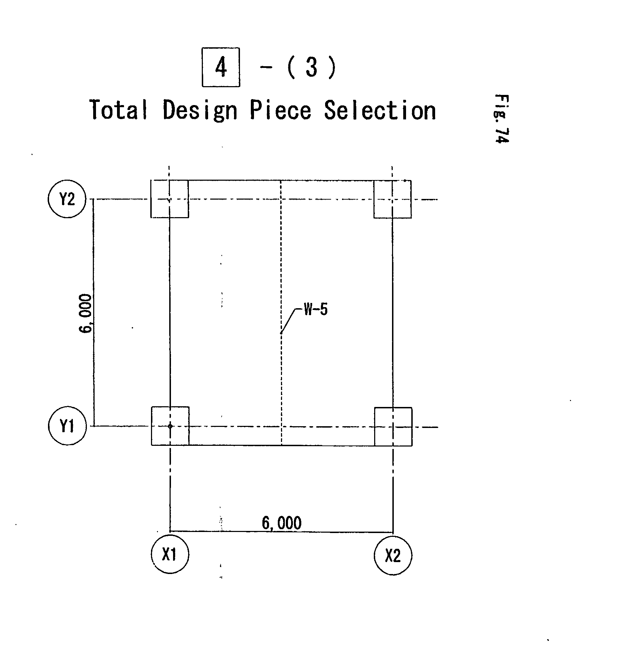

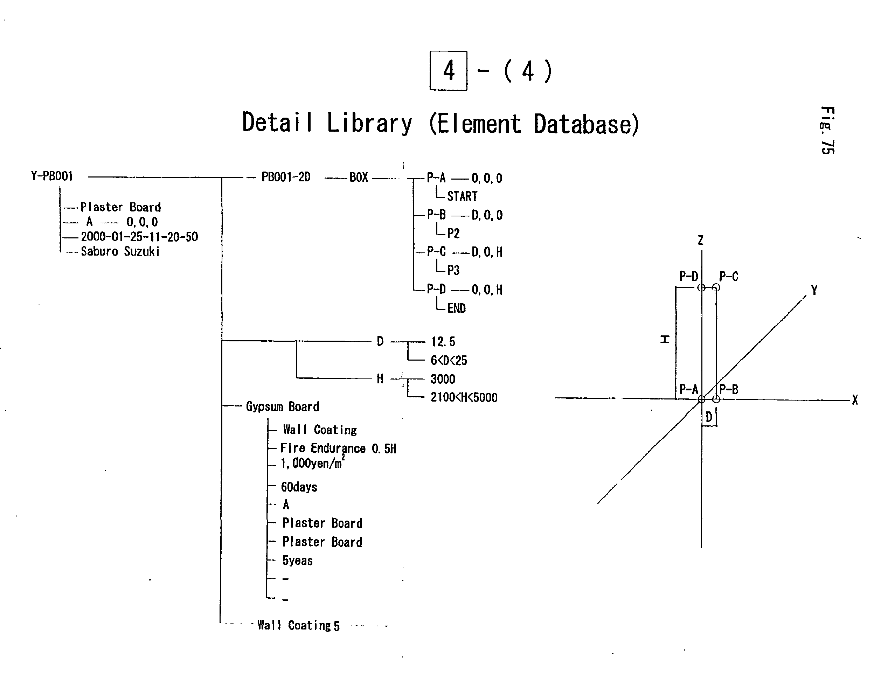

Figure 33 is a flow chart to show the total design piece change process and the DL change process for the process change from the basic design to the practical design, shown as Fig. 26 [4]. After initial value setting, follow the steps shown below;
(1) Display the total design pieces generated by processes up to [3].
(2) Select a required DL replacing command from the menu.
(3) Select an object displayed on the screen and then select one or more total design piece (planning design piece) (Fig. 74).
(4) Select the DL to be replaced among the DL menu. This corresponds to a procedure to determine undetermined elements at the transient from the basic design to the practical design. For example, specifications for the "wall" is not yet determined at the stage of the basic design, specifications for the wall base or finish, such as RC or LGC, are determined at the stage of practical design. DL replacement can be effectively applied to such a case as this. By replacing the DLs that are used in the basic design stage by DLs corresponding to the elements that are determined at the actual design stage, the DL information for the total design pieces is changed while other information is remain unchanged, thus the information deployment and extension over different stages can be realized smoothly. Figures 75 to 81 show the selected DLs.
(5) Check the request DB of the total design piece (planning design piece) whether the replacement is correctly done or not (see Fig. 34).
(6) Check the total design pieces (planning design pieces) whether the replacement is correctly done or not (see Fig. 35).
(7) Check whether an error flag is set or not in steps (5) and (6). If no, go to (8).
(8) Change the DL information and the weight information of the total design pieces (planning design pieces) by DL replacement. Replace the detail library information and the weight information of the total design pieces (planning design pieces) that are selected by (3) by the detail library information obtained by (4). Also, search the "detail management parameter DB" of total design pieces (planning design pieces) by the total design piece management name, and if found, remove the corresponding parameters and store the parameter information obtained by (4) instead (Figures 84 and 85).
(9) Store the record of the detail library information replacement for the total design pieces (planning design pieces) selected in (3) by the detail library selected by (4), into the total design piece change history DB.
(10) Search the "detail design piece deployment history DB" for the total design pieces (planning pieces) by total design piece names whether there are deployed detail design pieces or not, and if there are any, then go to (11). If no, then finish the step.
(11) Pick up the file of the deploying detail design piece (planning design piece) by using the detail design piece deployment history DB and the file name, and input the related detail design pieces (planning design pieces) by the total design piece management names .
(12) Input the DL information of the detail design piece (planning design piece) that are entered by (11).
(13) Search the elements of the detail design pieces and the extension data that are changed by the DL replacement of the total design pieces (planning design pieces).
(14) Store the contents of changes made on the detail design pieces and the total design pieces by (13) into the detail design piece request DB (see Fig 18 for the request DB).
(15) If the change made i9s an addition, then record the addition by (14) in the request DB, and also in the total design piece deployment history DB.

Figure 34 is a flow chart to show the detail of the process (5) in Fig. 33. After initial value setting, steps in the following follow;
(1) Read the total design piece request DB.
(2) Read the request DB of the DL that is selected by Fig. 33 (4).
(3) Check whether the newly selected requirements meet the requirements defined by the total design piece or not, and if no, go to (4). If yes, finish the step.
(4) Display that the newly selected requirements do not meet the requirements defined by the total design piece.
(5) Decide whether a command is entered to alter the request DB of the total design piece or not. If yes, go to (6).
(6) Alter the request DB of the total design pieces, and go back to (3).
(7) Decide whether to select another DL again or not. If yes, go to (8).
(8) Search among the project data libraries for a DL that meets the requirements of the total design pieces, by using the DL search program.
(9) The designer can either display searched DLs on the two-dimensional screen and select one among them, or choose another on the menu. After the selection, go back to (3).
(10) Set the error Flag.
(11) Finish the step after displaying the error.

Figure 35 is a flow chart to show the detail of the process (6) in Fig. 33. After initial value setting, follow the steps shown below;
(1) Decide whether the "connection design piece" is defined for a total design piece (planning design piece) or not. If yes, then go to (2).
(2) Decide whether the "relation piece" relationship of the total design piece (connection design piece) information, such as "2obj-3way", holds or not as the result of the DL replacement for the total design piece (planning design piece). If it holds, then go to (3) and if no, go to (4). In such a case where the former wall DL is changed by the DL replacement to other DL having a different meaning other than a wall, the "relation piece" relationship may not holds.
(3) Decide whether the DL information (relationship between the position and the components) for the total design piece (planning design piece) holds or not as the result of the DL replacement for the total design pieces (planning design pieces). If it doesn't hold, go to (4).
(4) Decide whether to release the definition of the total design piece (connection design piece) or not. If decision is to release, then go to (5) and not, go to (6).
(5) Release the relationship between the total design piece (planning design piece) and the connection design piece.
(6) Decide whether to select another definition for the total design piece (planning design piece) or not again. If yes, then go to (7) and no, go to (9).
(7) Search a DL among the project DLs that satisfies requirements and relationship of both changed total design piece (planning design piece) information and the total design piece (connection design piece).
(8) In (7), the designer can either display searched DLs on the two-dimensional screen and select one among them, or choose another on the menu. After the selection, go back to (3).
(9) Set the error Flag.
(10) Display the error message.

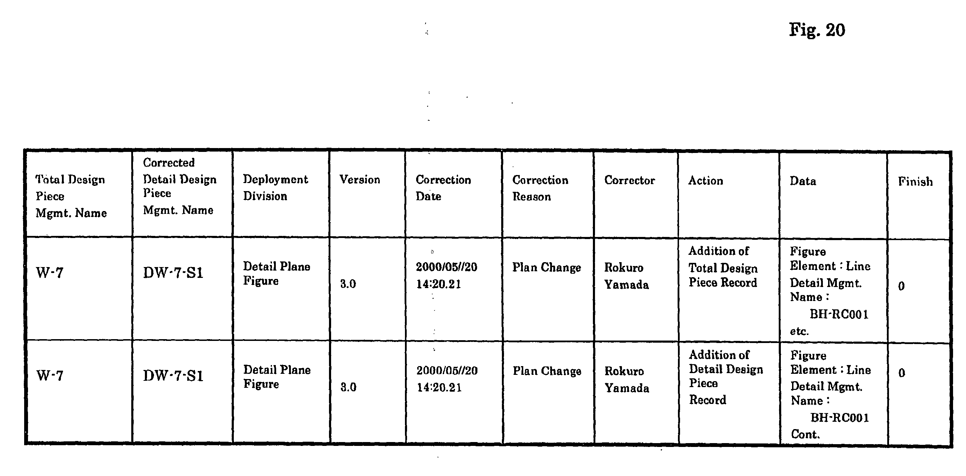

Figure 36 shows an explanation figure to show the change process for detail design pieces in Fig. 26 [7]. Figure 17 is an explanation figure to explain data examples in the change history DB for a detail plane figure. Figure 18 is an explanation figure to explain data examples in the request DB. Figure 19 is an explanation figure to explain data examples of the total design piece change history DB. Figure 20 is an explanation figure to explain data examples of the total design piece process waiting history DB.

For the total design piece and for each of three detail design pieces corresponding to each different figure (extension data), there is each "request DB" respectively. A "process waiting DB" also exists for the total design piece.

In the stage of [7-1], processes such as data addition, change and deletion for extension data and detail design pieces are carried out. This step is a work stage where design is carried out by each engineer in each section (the diversified design stage), in the design work process (see Fig. 27). The extension data and detail design piece data are processed at this step, and the processed results are stored in the change history DB for the detail design piece.

In [7-2], upon a change or deletion on the detail design piece carried out by [7-1], checks whether there are any other requests from other detail design pieces or not, by searching the request DB during the detail design piece change or deletion process. If there is any request, decision is made on how to treat it. The same process is carried out in [7-5] also. The process is to check and consider at an early stage of designing whether there has been already made any request for change on the detail design piece during the stage [7-1] by other designers or sections.

In [7-3], contents of the change history DB that is stored in [7-1] is searched for a change in the same detail design piece. If there are no changes, register the contents of the change history DB in the request DB for the total design piece. If there are any, then register the latest revision contents into the request DB for the total design piece (in case of wall thickness design process where the initial thickness of 100 is changed to 150 and then finally changed to 200, for example, the last number 200 is stored in the request DB for the total design piece.

In [7-4], a change request is read from the request DB for the total design. The requesting person is identified and is checked whether the person is authorized to change or not by verifying the priority order DB. If the person is cleared for authorization, the requested correction is made on the total design piece, the contents of the change are stored in each request DB for each detail design piece other than the requester's. If the requester is not authorized, then register the contents of the change into the unfinished DB, and also register them in the other designer's request DB for the detail design piece that the other designer is permitted to change.

In [7-5], a change request is read from the request DB for the detail design. Whether the change should be made or not is decided, and if yes, the detail design piece is changed as requested, and the demand DB and the unfinished DB are renewed. If the request is not accepted, the contents of the unfinished DB is deleted, and a counter request is sent to the requester's request DB, demanding to change its contents to the same contents of the request DB of the authorized designer.

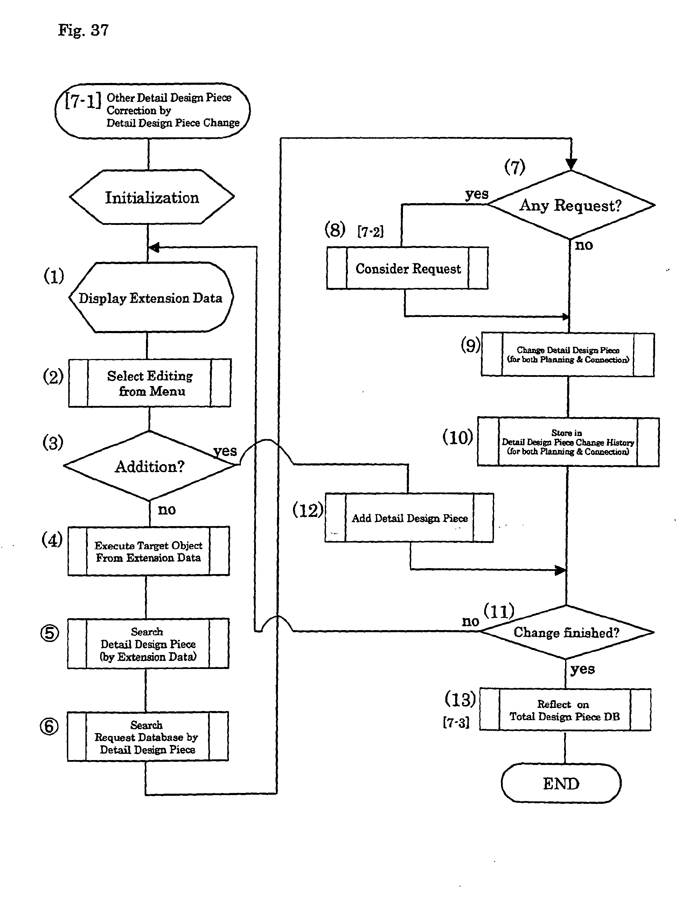

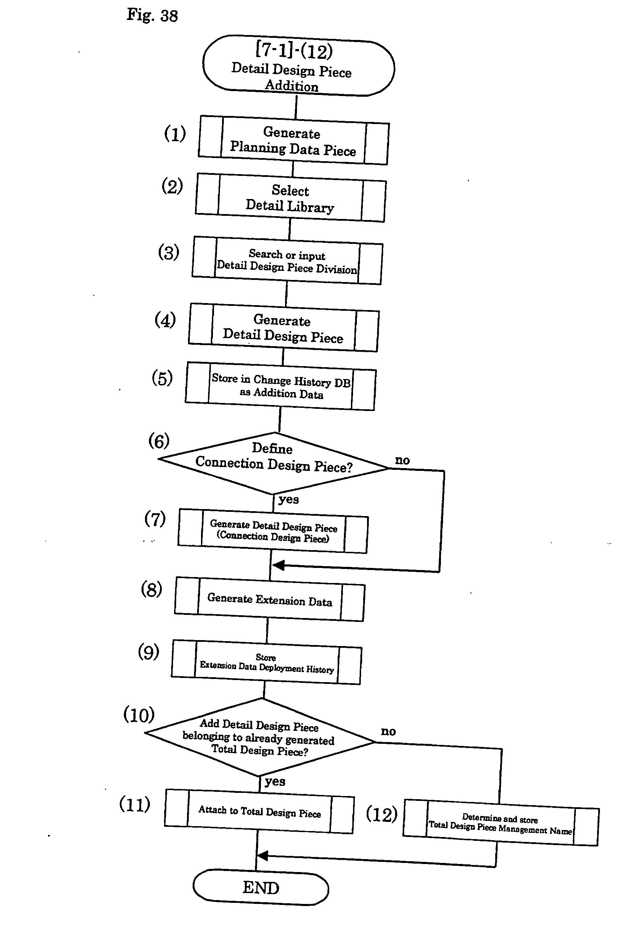

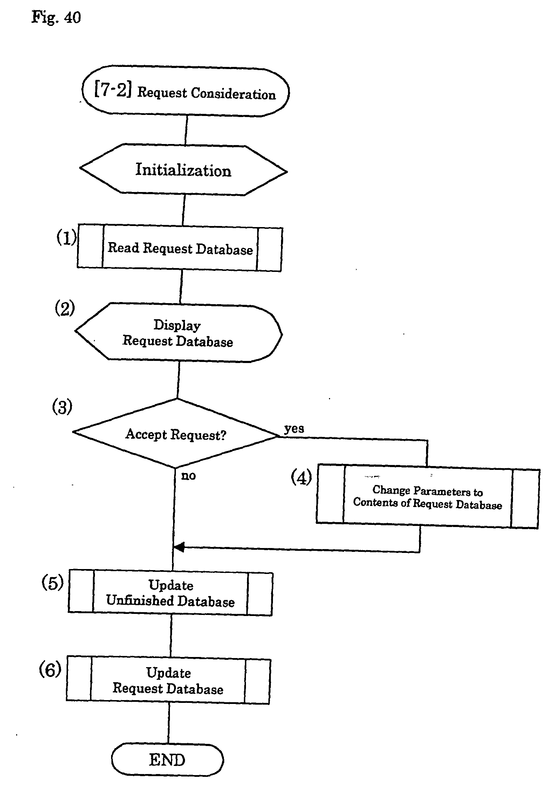

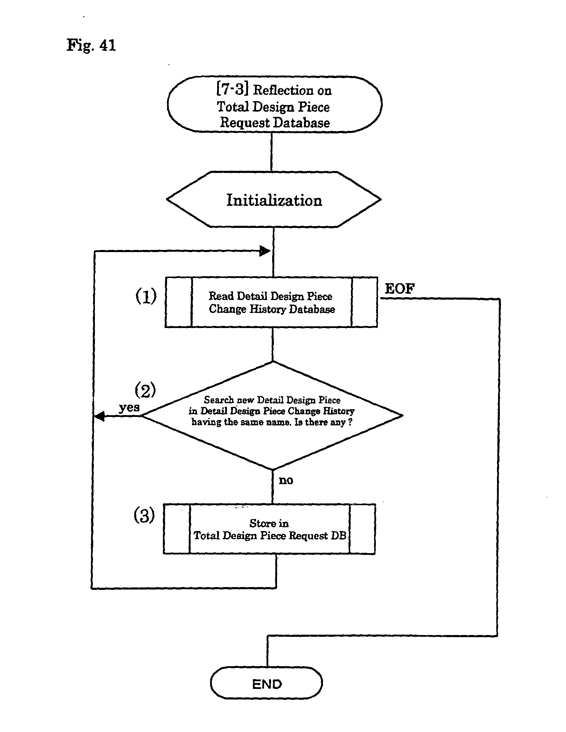

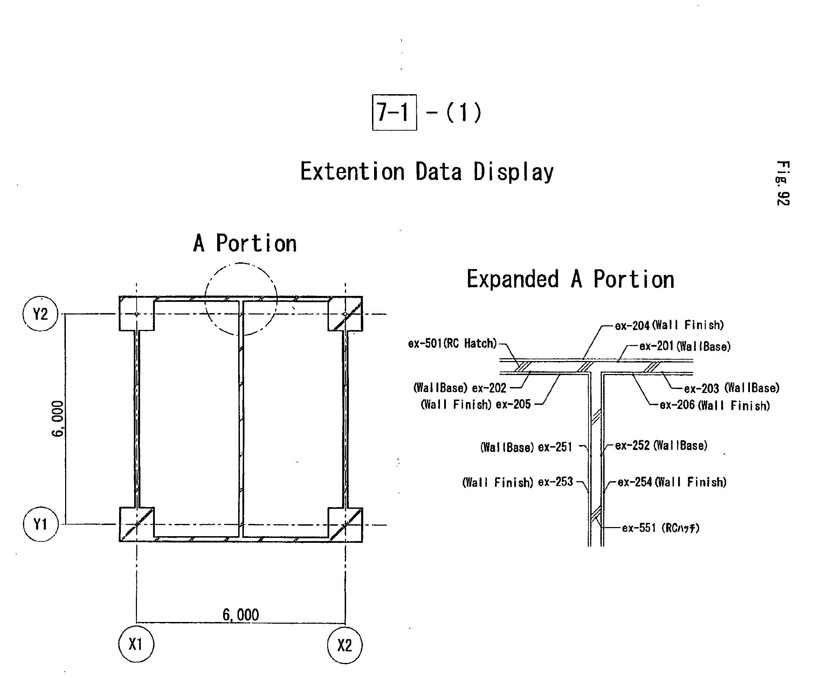

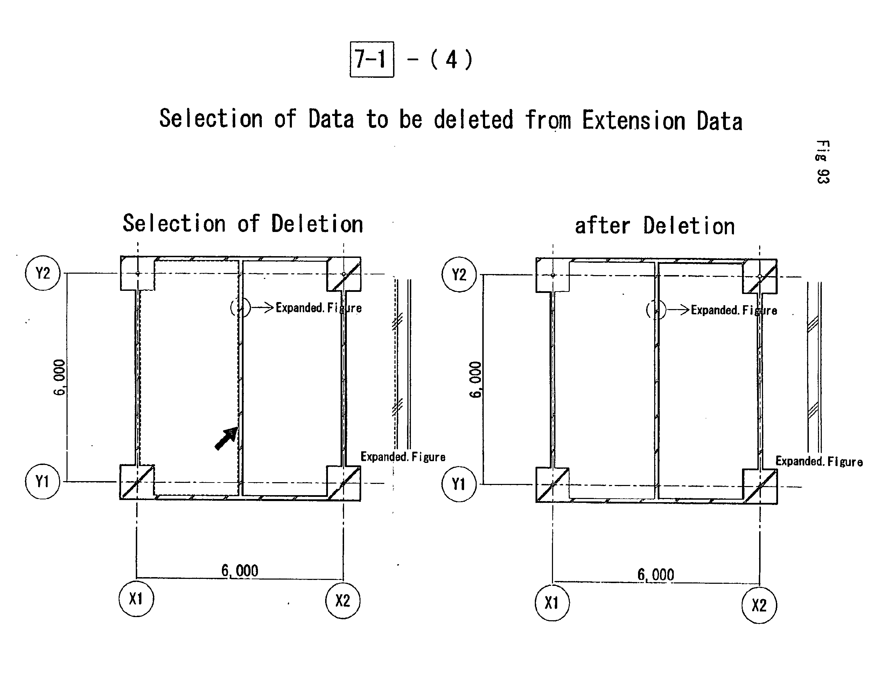

Processes that are shown by [7-1] ~ [7-5] in Fig. 36 are explained in the following. Figure 37 is a flow chart to show the detail design piece change process in [7-1] of Fig. 36. After initial value setting, follow the steps shown below;
(1) Display the extension data to be changed (Fig.92).
(2) Select the necessary processing item ("delete", for example) among the edition menu.
(3) Check whether the selected item is new detail design piece addition or not. If it is new addition, then go to (12). If no, go to (4).
(4) Select the target object ("delete", for example) from the extension data and execute it (Fig. 93).
(5) Search the "extension database" of the detail design piece (planning design piece) by using the extension name of the extension data to get the managed detail design piece (planning design piece).
(6) Search the "request DB" to know if there are any change requests for detail design piece (planning design piece) that is searched in (5).
(7) Check whether there is a request or not, and if yes, go to (8). If no, go to (9).
(8) Execute decision process whether to accept the request or not in [7-2] of Fig.40.
(9) Execute the change process for the detail design piece. In case of deletion, for example, delete the record of the targeted detail design piece (planning design piece) and release the detail design pieces (connection design pieces) that are related to that detail design piece (planning design piece).
(10) Record the contents of the change made by (9) into the detail design piece change history DB (for both planning design piece and connection design piece).
(11) Decide whether the process is finished or not. If it is not finished, return to (1).
(12) Add a new detail design piece (Fig. 38).
(13) Execute the reflection process of [7-3] (Fig. 41) to reflect the change result on the total design piece request DB.

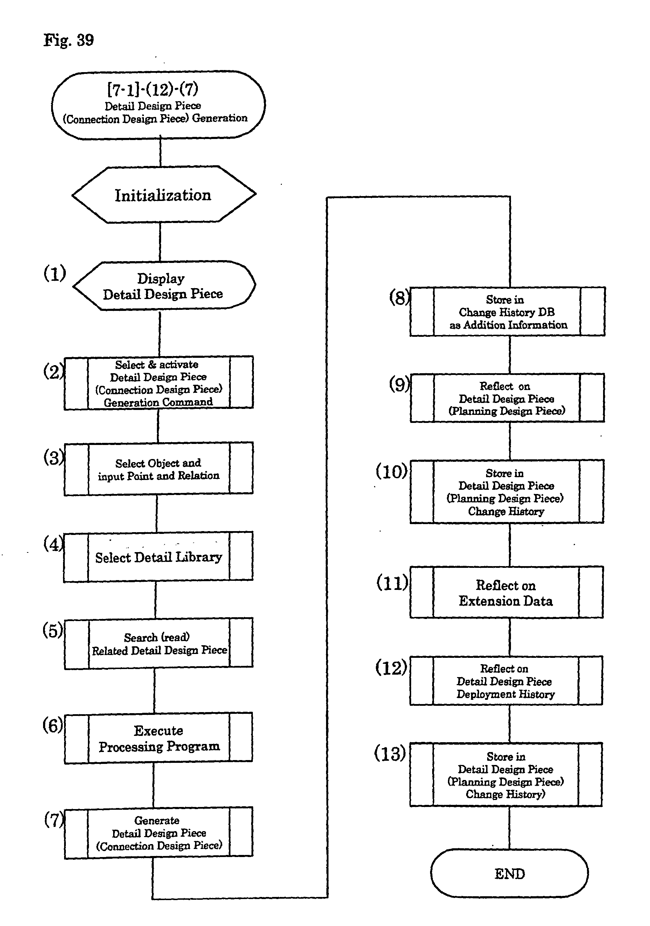

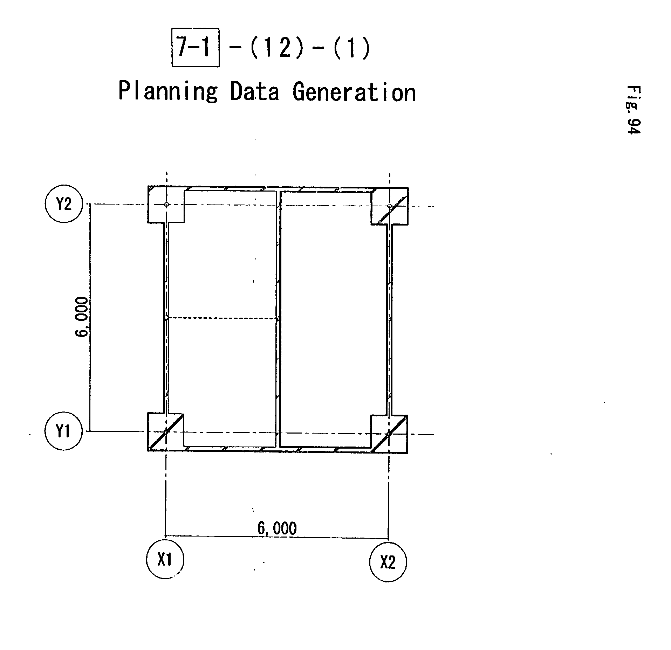

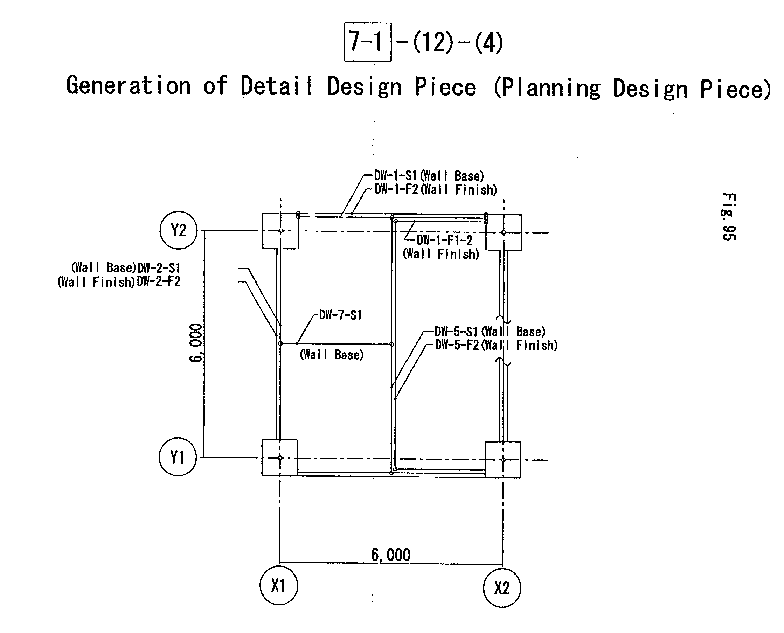

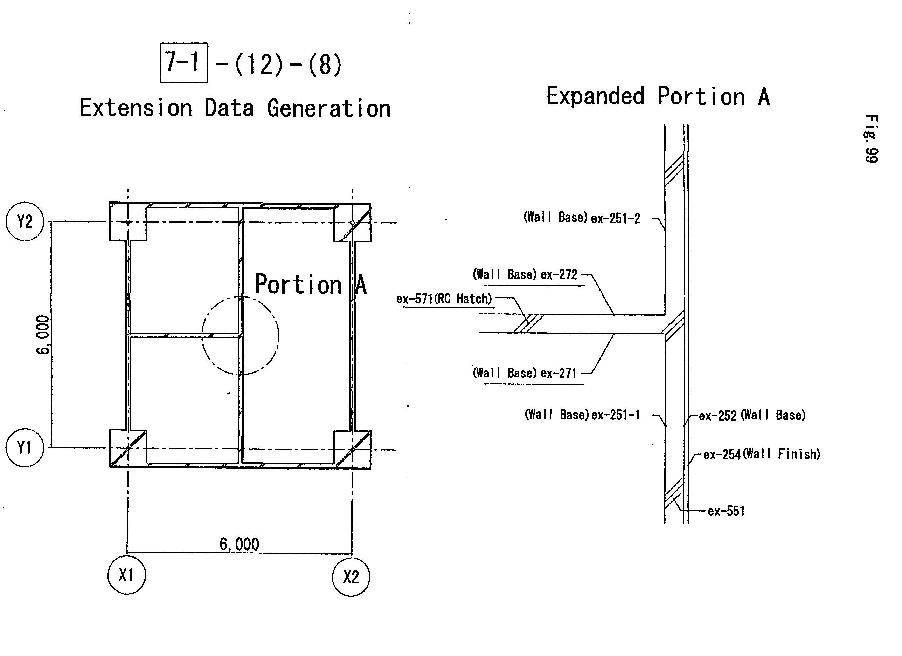

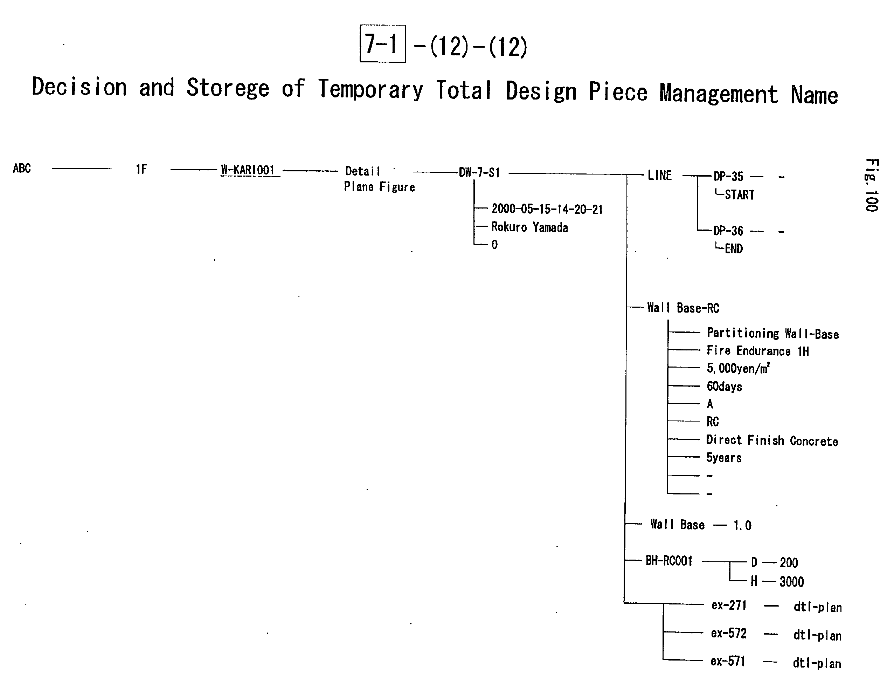

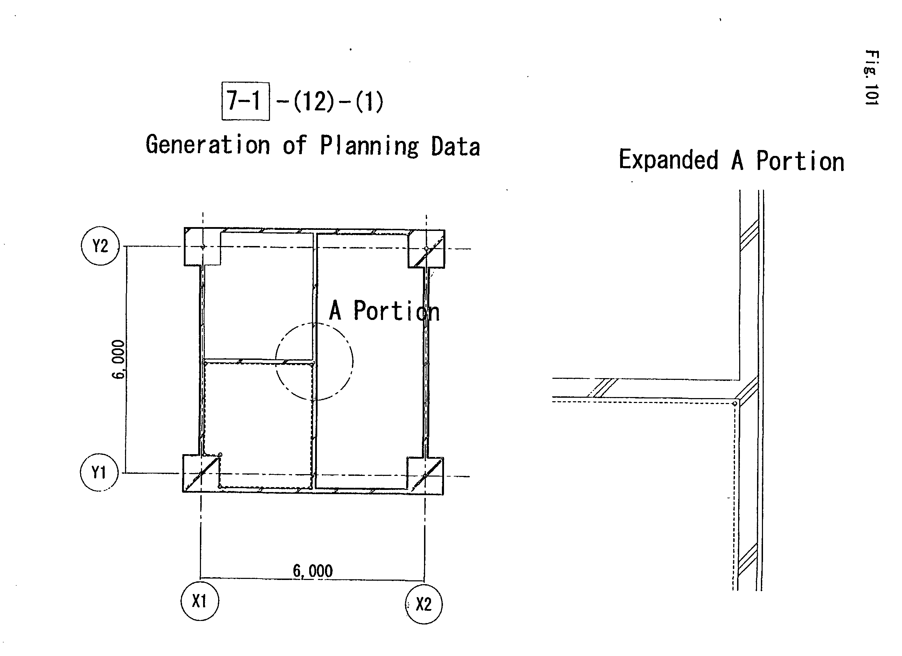

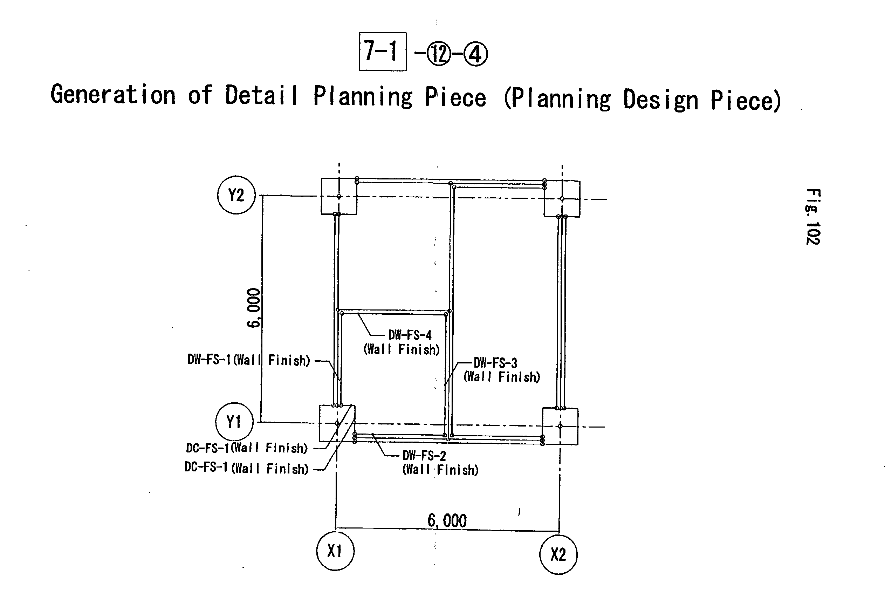

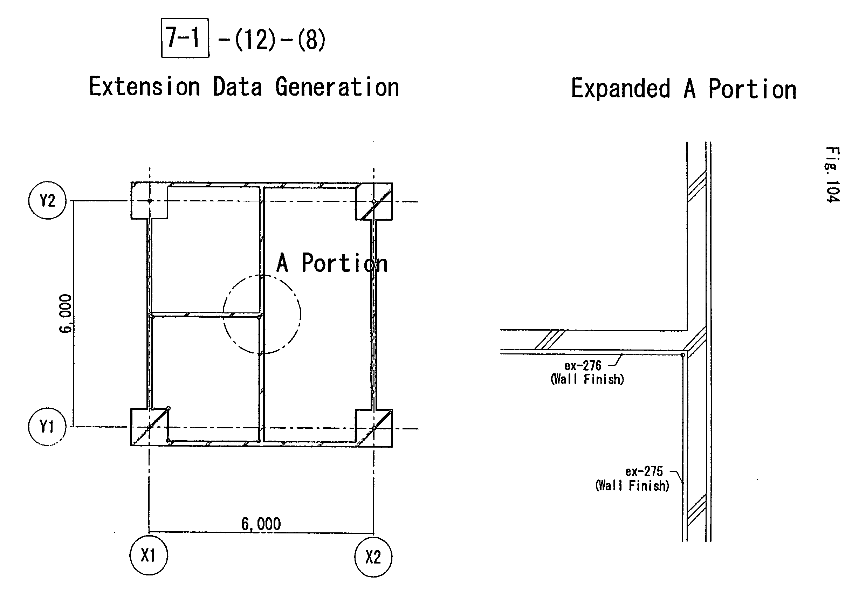

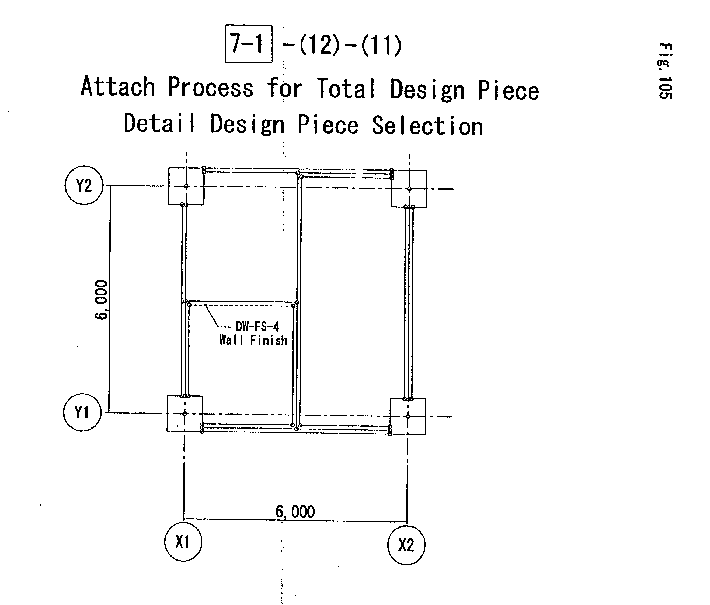

Figure 38 is a flow chart to show the detail of the process (12) in Fig 37. After initial value setting, follow the steps shown below;
(1) Generate a planning data piece (a portion of a wall, for example). See Figures 94 and 101.
(2) Select the DL to be related.
(3) Either input a new detail design piece division (a plane figure, for example), or search and select a detail design piece from the other extension data.
(4) Generate the additional detail design piece (planning design piece) using information of (1), (2) and (3). (Figures 95 and 102)
(5) Store this addition information in the detail design piece change history DB.
(6) Decide whether to define a connection design piece or not. If yes, go to (7), and if no, go to (8).
(7) Generate a detail design piece (connection design piece). (Fig. 39)
(8) Generate the extension data using information obtained by (4) and (7). See Figures 99 and 104.
(9) Store the deployment history of the extension data generated by (8) in the "extension DB" of the detail design piece (planning design piece).
(10) Decide whether this is an addition of a detail design piece belonging to an already generated total design element or not. If yes, then go to (11). If no, go to (12). Since any already-generated total design piece is not related to the newly-added detail design piece at this step, decision is made on whether this new detail design piece belongs to the existing total design piece or it is an independent detail design piece. If the detail design piece belongs to one of already generated total design pieces, relates it to the total design piece that it belongs. If it is a detail design piece belonging to none of the existing total design pieces, attach it a temporary total design piece management name.
(11) Relate the newly-added detail design piece to the total design piece (Figures 105, 106 and 107).
(12) Assign a temporary management name as the total design piece management name of the newly-added detail design piece. (Fig. 100)

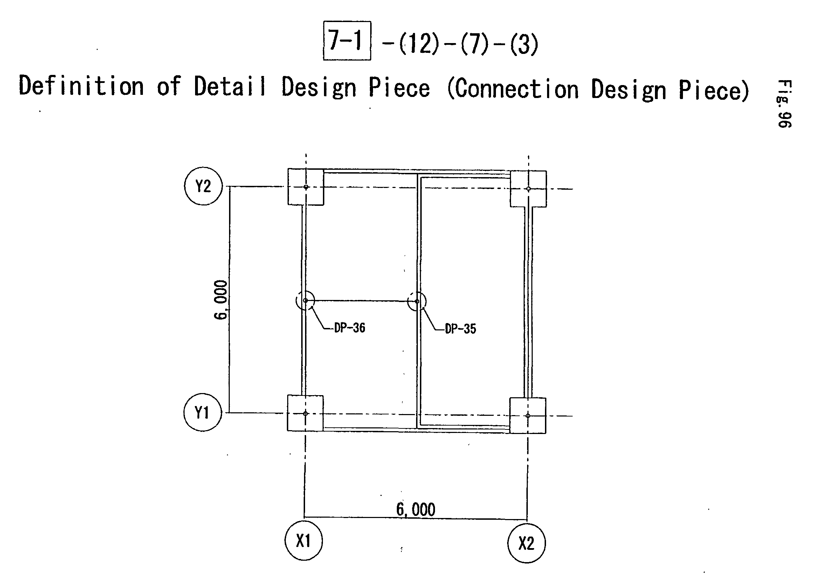

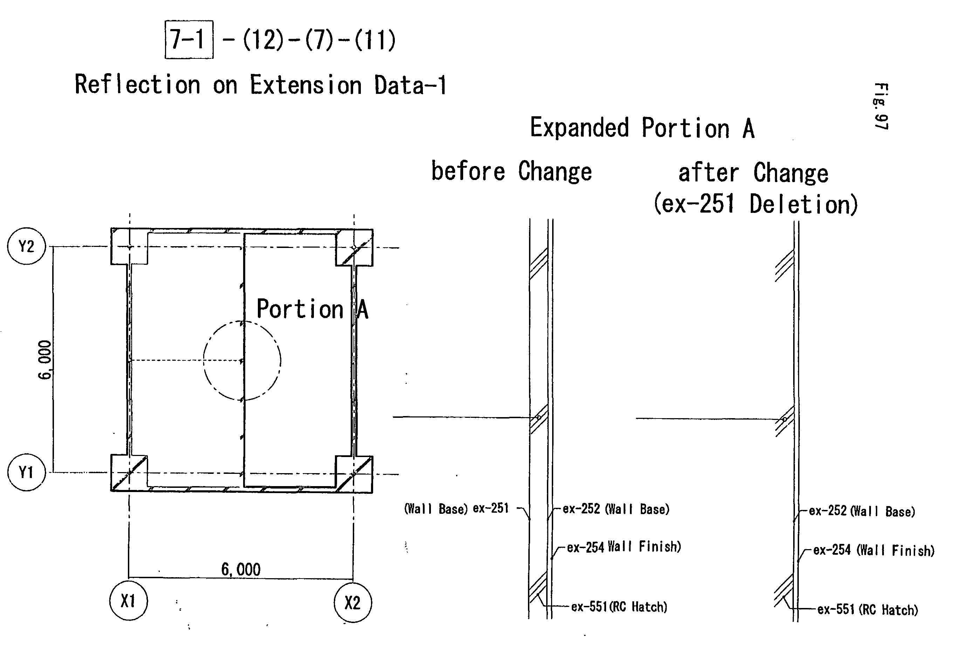

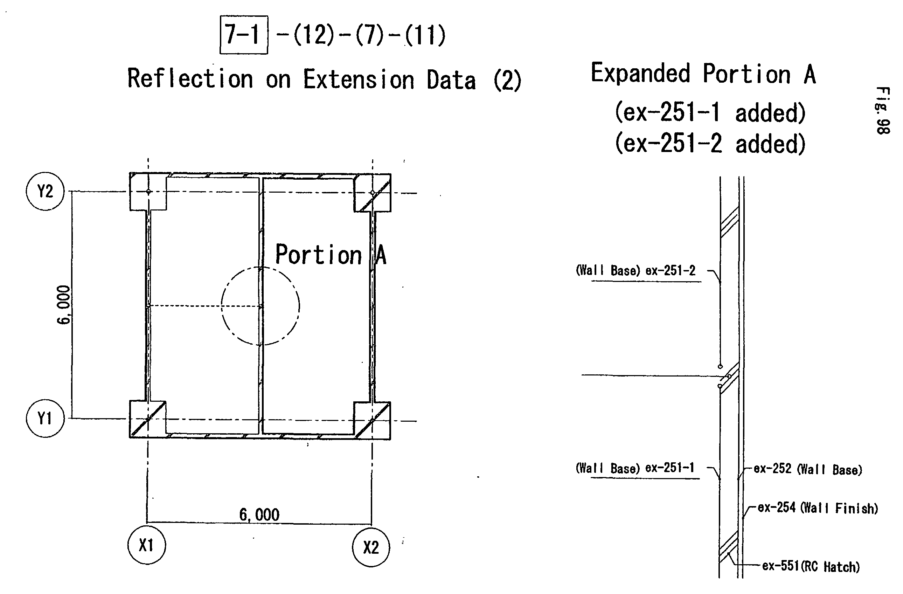

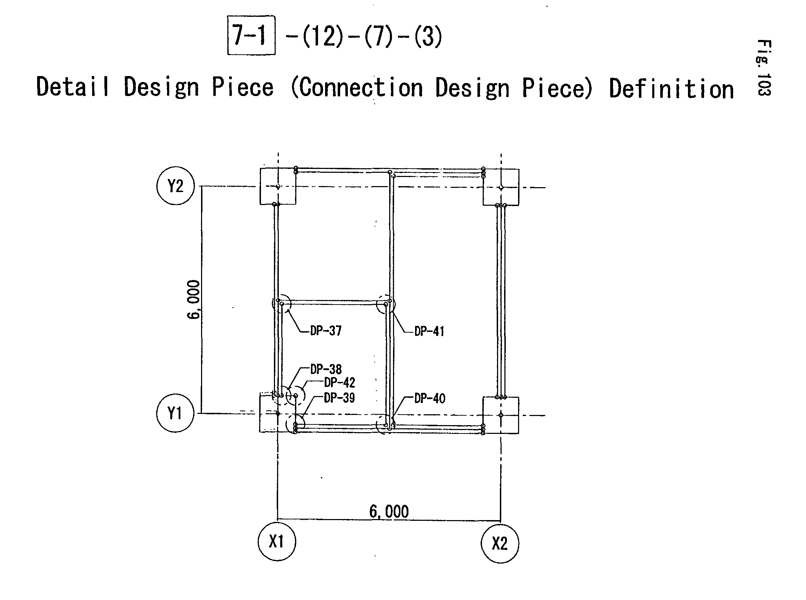

Figure 39 is a flow chart to show the detail of the process (7) in Fig 38. After the initialization follow the steps shown below;
(1) Display the detail design piece input screen.
(2) Select a generation command for a detail design piece (connection design piece) and activate it.
(3) Select the detail design piece (planning design piece) having relationship to the added detail design piece, and input its point coordinate information and relationship information. (Figures 96 and 103)
(4) Select the target DL.
(5) Search and read the relating detail design piece (planning design piece) selected by (3).
(6) Execute the processing program for the DL information selected by (4).
(7) Generate the detail design piece (connection design piece) by using information obtained by (3), (4) and (5).
(8) Store this addition information to the detail design piece change history DB.
(9) Reflect the detail design piece (connection design piece) information on the detail design information (planning design information).
(10) Store the contents of the change made by (9) in the change history DB for the detail design piece (planning design piece).
(11) If the existing extension data related to the detail design piece (planning design piece) that is selected by (3) are affected by the above definition of the detail design piece (connection design piece), search the extension data in the extension DB for the detail design piece (planning design piece and execute the change process (Figures 97 and 98).
(12) If there are any changes by (11) in the existing extension data, reflect the change on the detail design piece deployment history DB that is related to said existing extension data.
(13) Store the contents of the change made by (11) in the detail design piece (planning design piece) change history DB.

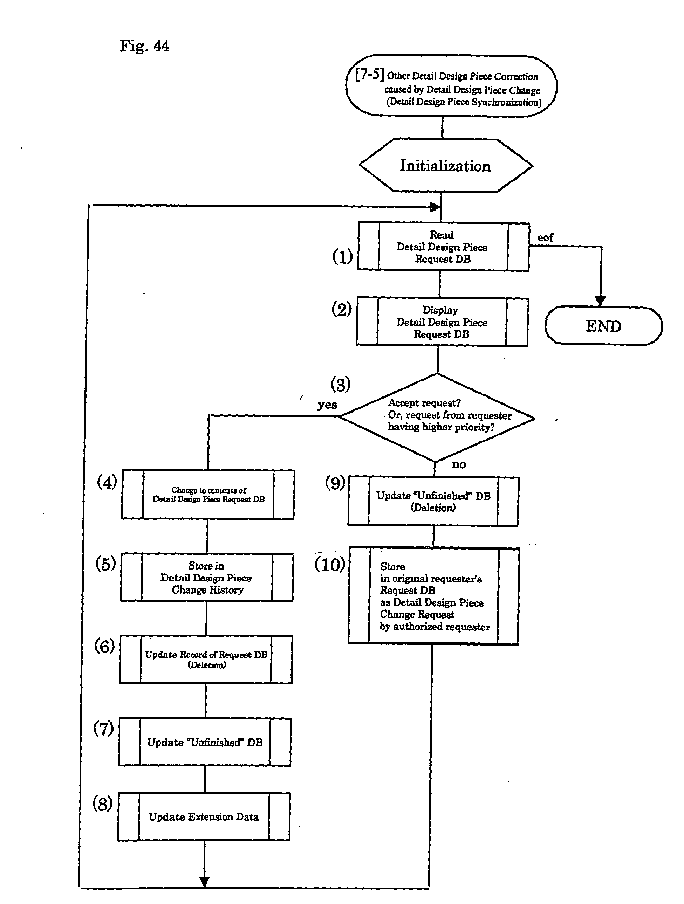

Figure 40 is a flow chart to show the request consideration process that is shown as [7-2] in Fig. 36 (Fig. 37). This process is the same as one shown as [7-5] in Fig. 44. After initial value setting, follow the steps shown below;
(1) Read the request DB.
(2) Display the request DB.
(3) If the request is to be accepted, then go to (4). Otherwise, go to (5).
(4) Change parameters of the detail design piece to the request DB contents.
(5) Renew the unfinished DB.
(6) Renew the request DB.

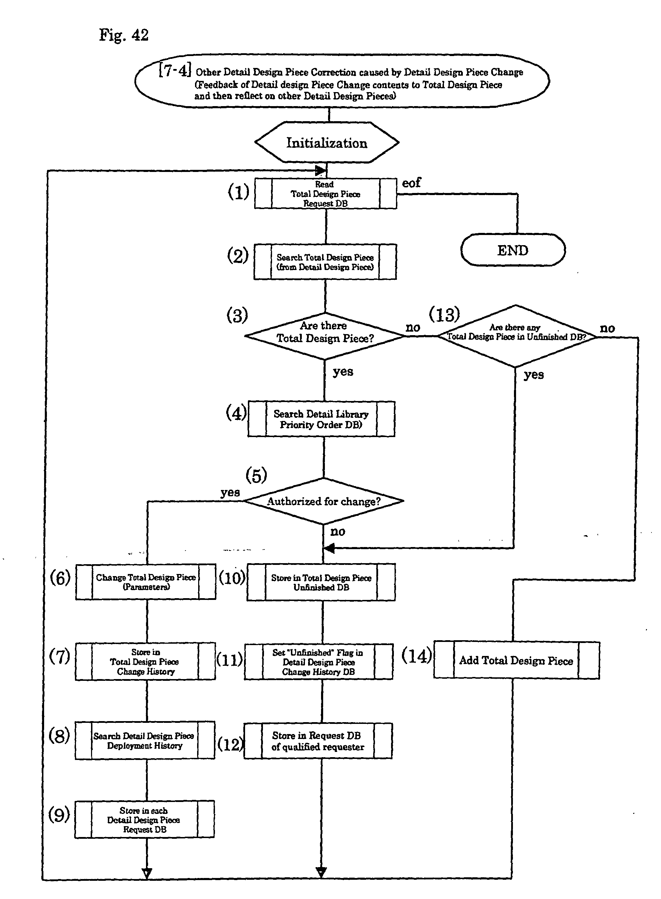

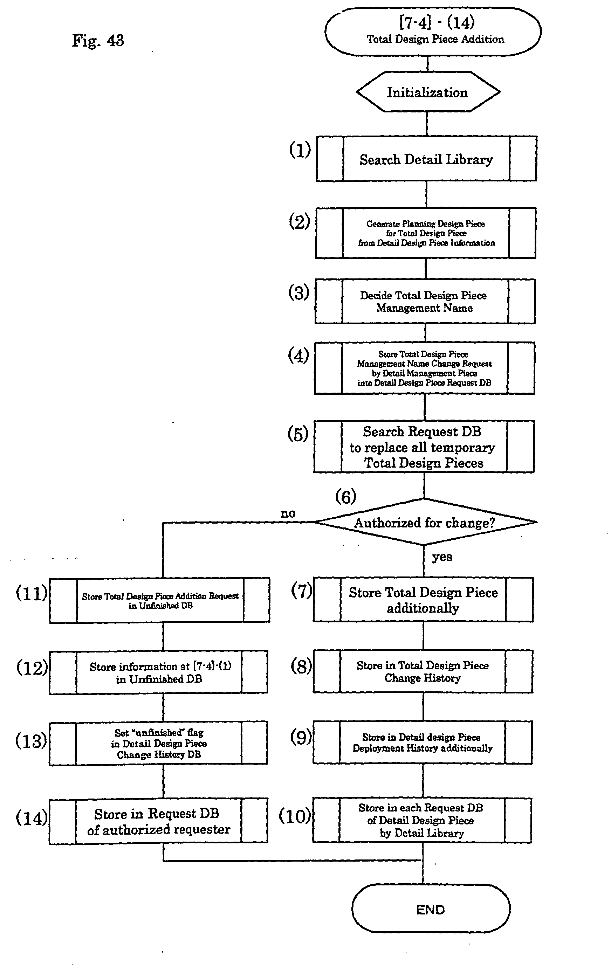

Figure 42 is a flow chart to show the process of handling a change request to the other detail design piece shown as the process [7-4] in Fig. 36. After initial value setting, follow the steps shown below;
(1) Read the "request EDB" for the total design piece.
(2) Search a total design piece by using the total design piece management name that is inputted by (1).
(3) Check whether there are any total design pieces according to the result of (2). If there are any, then go to (4). Otherwise, go to (13).
(4) Search the "priority order DB" for DL information by using the detail management name for the total design piece information that is searched in (2), and read it.
(5) Decide whether the request is accepted or not by using the "deployment division" information for the request DB inputted in (1) and by using the "priority order DB inputted (4). If the request is accepted, go to 6. Otherwise go to (10).
(6) If there should be any changes in the "detail management parameter database" or in other total data piece information because of the total design piece change, execute the change process.
(7) Store the contents of the change by (6) in the total design piece change history DB.
(8) Search an already deployed "detail design piece" by using the "detail design piece deployment history DB" for the total design piece.
(9) Store the change request in the "request DB" for each of the detail design piece that is searched by (8).
(10) Store the change request in the "unfinished DB" for the total design piece.
(11) Identify the detail design piece that requested the "request DB" of the total design piece, by referring to the "total design piece management name", the "correction detail design piece management name", the "deployment division" and "Vcr" in the "request DB" that is inputted in (1). Then, set an "unfinished" flag in the record of the "change history DB" for the detail design piece that made the change request.
(12) Identify the qualified person for the change by checking the "priority order DB" that is inputted by (1), and then store the change request to the "request DB" for the detail design piece that corresponds to both of the qualified person and the "detail design piece deployment division".
(13) Search an "unfinished DB" for the total design piece by using "total design piece management name" in the "request DB" that is inputted by (1). If such one is found, search the DL by using the detail management name for the total design piece information that was searched by (2), search the "priority order DB" of the DL, read it and then go to (10). If no, go to (14).
(14) Execute the addition process for the total design piece (Fig. 43).

Figure 43 is a flow chart to show the detail of the process (14) in Fig. 42. Followings are the steps of the process.
(1) Identify the detail design piece by using the "correction detail design piece management name" and the "deployment division" of the "request DB" that is inputted by (1) in Fig. 42. The search the DL by using the detail management name of the detail design piece information.
(2) Generate the total design piece information from the detail design piece information and the DL information.
(3) A series of total design piece management numbers is attached to each generated total design piece by the system, but they can be changed later.
(4) Identify the detail design piece by using the "correction detail design piece management name" and the "deployment division" of the "request DB" that is inputted by (1) in Fig. 42. Then store a request to replace the temporarily assigned total design piece management name by the total design piece management name that is determined by (3), into the "demand DB" for the identified detail design piece.
(5) Search the "demand DB" of the total design piece to replace the total design piece management name by the total design piece management name determined by (3).
(6) Search the DL "by using the detail management name of the total design piece that is generated by (2), refer to the "priority order DB" of the searched DL information and read it. Then, decide whether the request to update is to be allowed or not according to the "priority order DB" and the "deployment division" of the request DB that is entered by (1) in Fig. 42. If yes, go to (7), and otherwise go to (11).
(7) Store the added total design piece.
(8) Store the contents of the change into the total design piece change history DB.
(9) Generate a detail design piece deployment history of the total design piece to relate the total design piece and the detail design pieces.
(10) Store the request to generate detail design pieces according to the detail design deployment division which is accompanied with the addition of a total design piece, into the request DB of each detail design piece (except for request DB of the detail design piece that made the request).
(11) Store the total design piece addition request in the unfinished DB.
(12) Store the information entered by the process (1) of Fig. 42 into the unfinished DB.
(13) Set an unfinished flag in the detail design piece change history DB.
(14) Store the addition request in the request DB of qualified designers.

Fig. 44 is a flow chart to show the detail design piece synchronization process shown as [7-5] in Fig. 36. After initial value setting, follow the steps shown below;
(1) Read the detail design piece request DB.
(2) Display the detail design piece request DB.
(3) Decide whether the change request is accepted as the original request, or is not accepted as the original but is the change request from a qualified designer with higher priority order. If the decision is the former, go to (4), and the latter, go to (9).
(4) Change the detail design piece to the changed contents of the detail design piece request DB.
(5) Store the contents of change into the detail design piece change history.
(6) Update the request DB record (set the finished flag).
(7) Update the unfinished DB (set the finished flag).
(8) Update the extension data.
(9) Update the unfinished DB (set the completed flag).
(10) Store the same detail design piece contents as the qualified designer's into the "request DB" of the designer who made the original request.

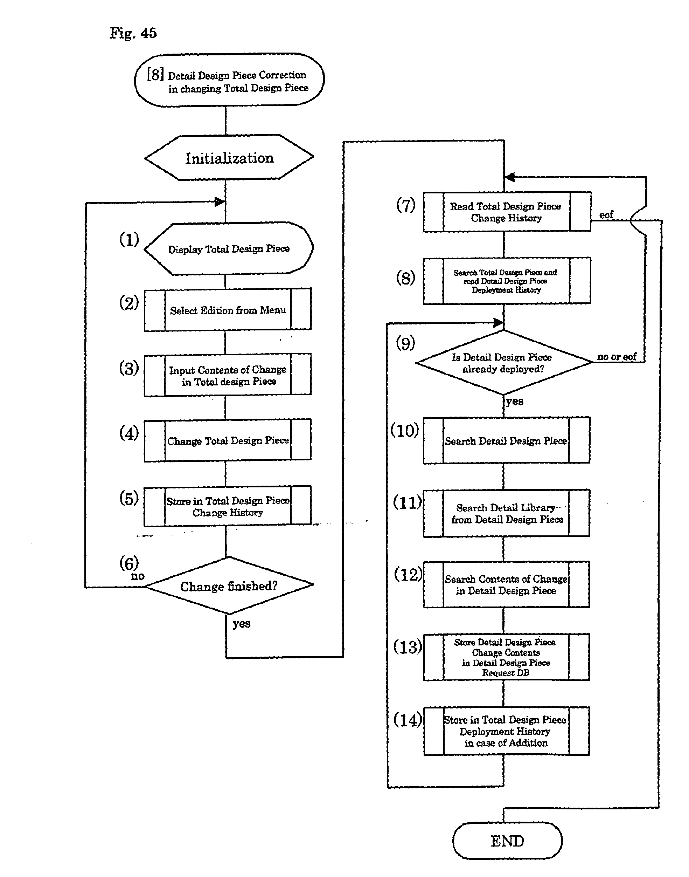

Figure 45 is a flow chart to show the correction process for a detail design piece in changing a total design piece explained in [8] of Fig. 26. After the initialization follow the steps shown below;
(1) Display a total design piece.
(2) Select an editing command in the menu.
(3) Input the change contents to the total design piece.
(4) Execute the change process for the total design piece.
(5) Store the change contents into the total design piece change history.
(6) Check whether the change process is finished or not. If finished, go to (7). Otherwise, return to (1).
(7) Read the total design piece change history. Finish reading when all the data are entered.
(8) Read the "detail design piece deployment history DB" by using the "total design piece management name" of the total design piece change history information that is inputted by (7).
(9) Check whether the detail design pieces are already deployed or not. If yes, go to (10). If no, or if data reading is finished, then go to (7).
(10) Identify the detail design piece that is affected by the total design piece change, by using the "detail design piece deployment history DB" and the "total design piece management name" of the total design piece inputted by (8).
(11) Search and input the DL information from the detail design piece information that is identified by (10).
(12) Identify the change contents in the detail design piece by using the total design piece change contents inputted by (7), the total design piece DL information and the detail design piece DL.
(13) Store the total design piece change contents identified by (12) into the "request DB" for the detail design piece.
(14) If the change is addition, Store this addition in the total design piece deployment history.

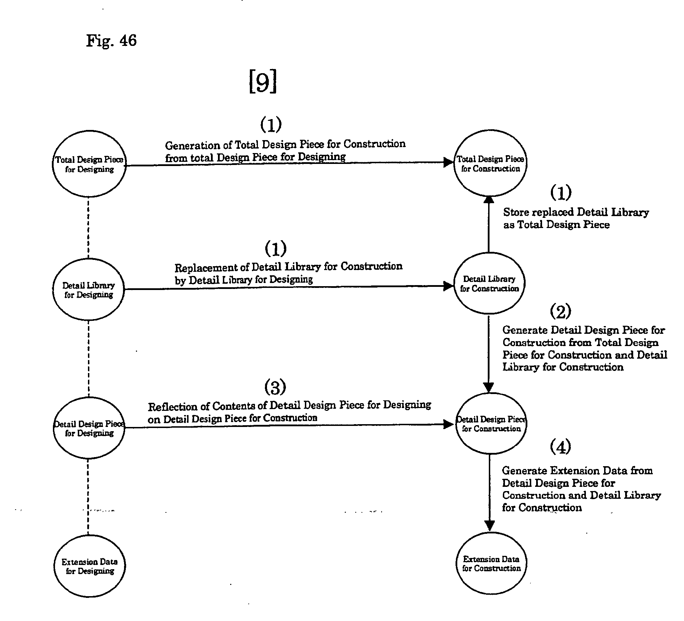

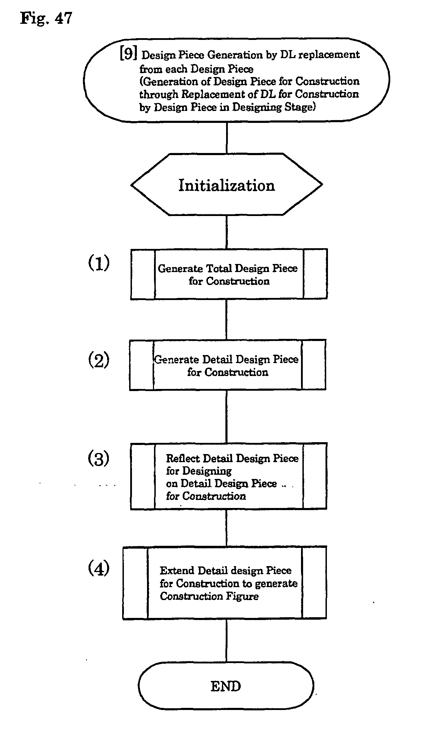

Figure 46 is an explanation figure to show the construction design piece generation process through DL replacement shown as [9] in Fig. 26. Also, Fig. 47 is a flow chart to show the construction design piece generation process through DL replacement shown as [9] in Fig. 26. As shown in Fig. 46, there is a DB for a designing DL and a DB for a construction DL, as a DB for a DL. For one designing DL, one construction DL wearing the same name is assigned. Or in some cases, there are several construction DLs assigned to one designing DL.
(1) Search the construction master DL having the same meaning (name) as the designing DL for the total design piece, and replace the former by the latter. For searching and replacing the DL having the same meaning, searching DL information such as requirement information may be used. Then, generate the total design piece for construction from the contents of the total design piece for designing and from the construction DL.
(2) Generate the detail design piece for construction from the total design piece for construction and the construction DL.
(3) Reflect the contents of the detail design piece for designing on the detail design piece for construction.
(4) Generate the extension data for construction from the detail design piece for construction and the construction DL.

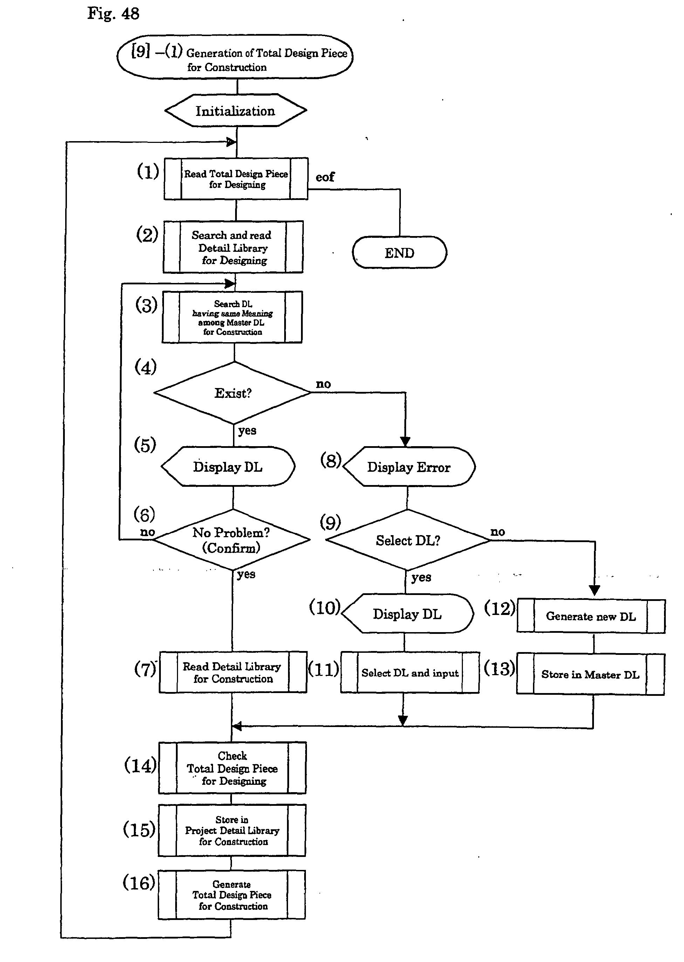

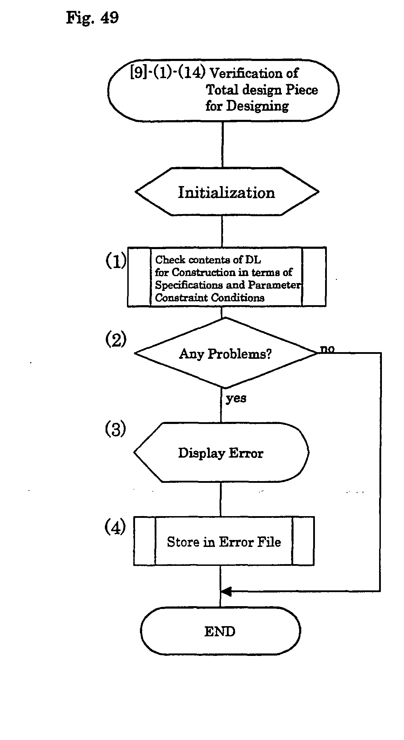

Figure 48 is a flow chart to show the detail of the process of (1) in Fig. 47.
(1) Read a total design piece for designing.
(2) Search the designing DL and read the contents.
(3) Search for a construction DL having the same meaning as the designing DL.
(4) Check whether there are any construction DL corresponding to (3). If there is one, then go to (5). Otherwise, go to (8).
(5) Display the DL.
(6) The designer checks whether there are any problems in the DL. If there is, go to (3). Otherwise, go to (7). By repeating (3) to (6), the best DL is chosen by the designer if there are some corresponding DLs for construction.
(7) Read the construction DEL.
(8) Display an error message.
(9) Decide whether to select the DL or not. If yes, then go to *(10).* Otherwise, go to (12).
(10) Display the chosen DL.
(11) Choose and input the chosen DL.
(12) Generate a new DL.
(13) Store the new DL into the master DL.
(14) Verify the total design piece for designing (Fig. 49).
(15) Store the DL into the project DL for construction.
(16) Generate the total design piece for construction.

Fig. 49 is a flow chart to show the detail of the process of (14) in Fig. 48.
(1) After initial setting, verify the contents of the DL for construction with requirements for the total design piece for designing or constraint conditions for the parameters.
(2) Check whether there are any problems or not. If there is, go to (3).
   Check whether there are any problems or not. If there is, go to (3).

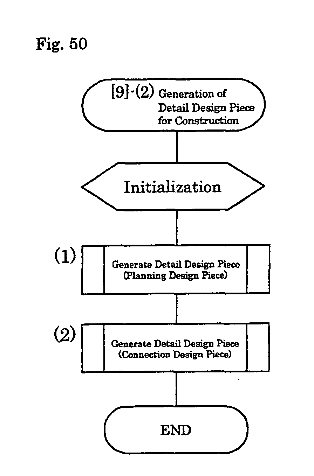

Figure 50 is a flow chart to show the detail of the process of (2) in Fig. 47.
(1) After initialization, generate a detail design piece (planning design piece) for construction from the total design piece for construction and the construction DL.
(2) Generate a detail design piece (connection design piece) for construction from the total design piece for construction and the construction DL.

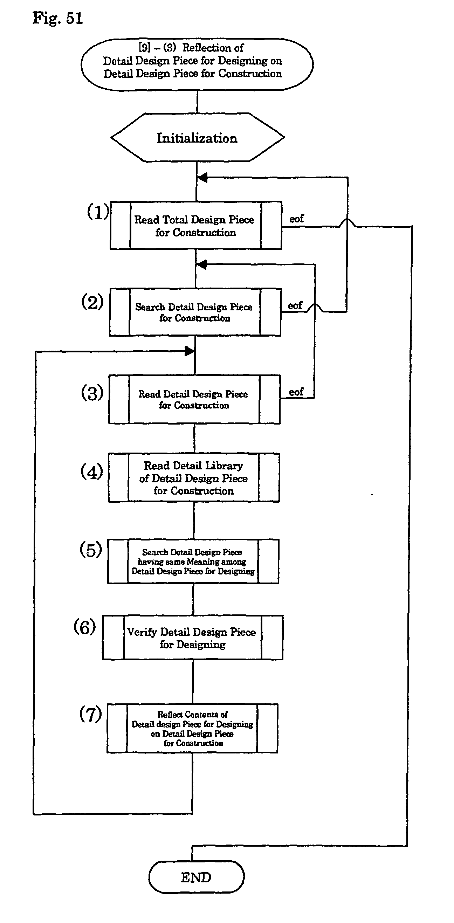

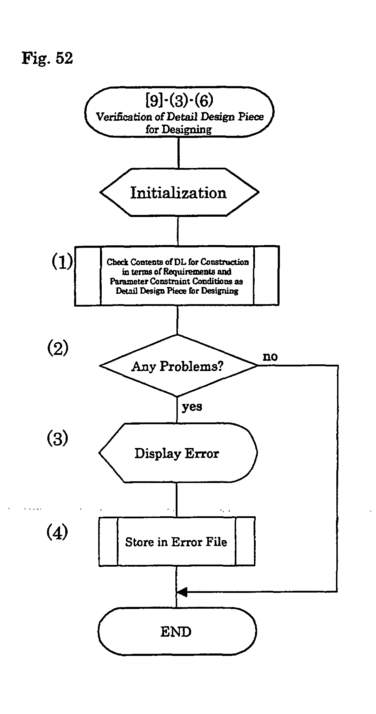

Figure 51 is a flow chart to show the detail of the process of (3) in Fig. 47.
(1) Read a total design piece for construction. If all input data are read, finish the process.
(2) Search the detail design pieces for construction. If all data are searched, go back to (1).
(3) Read the searched detail design piece for construction. If all data are read, go back to (2).
(4) Read the DL of the detail design piece for construction inputted by (3).
(5) Search the detail design piece for designing having the same meaning with the detail design piece for construction.
(6) Verify the searched detail design piece for designing (Fig. 52)
(7) Reflect the contents of the detail design piece for designing on the detail design piece for construction.

Figure 52 is a flow chart to show the detail of the process of (6) in Fig. 51.
(1) Verify the contents of the construction DL with requirements and constraint parameters of the detail design pieces for designing.
(2) Check whether there are any problems or not. If there is, go to (3).
(3) Display an error message.
(4) Record the error in the error file.

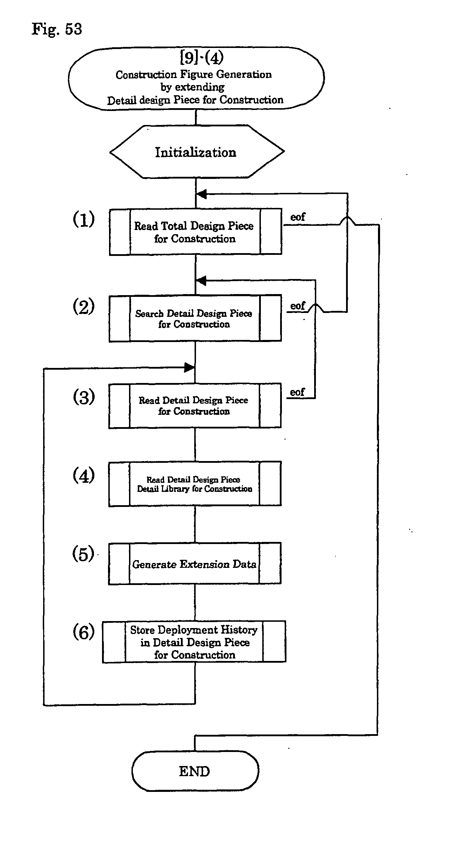

Figure 53 is a flow chart to show the detail of the process of (4) in Fig. 47.
(1) Read a total design piece for construction. If all input data are read, finish the process.
(2) Search the detail design pieces for construction. If all data are searched, go back to (1).
(3) Read the searched detail design piece for construction. If all data are read, go back to (2).
(4) Read the DL of the detail design piece for construction inputted by (3).
(5) Generate the extension data.
(6) Store the deployment history in the detail design piece for construction.

Several design examples are shown in the following explanation. Numbers in rectangular boxes or parentheses shown in figures cited in the explanation below correspond to the processes wearing the same numbers in flow charts shown in Figures 26 to 53.

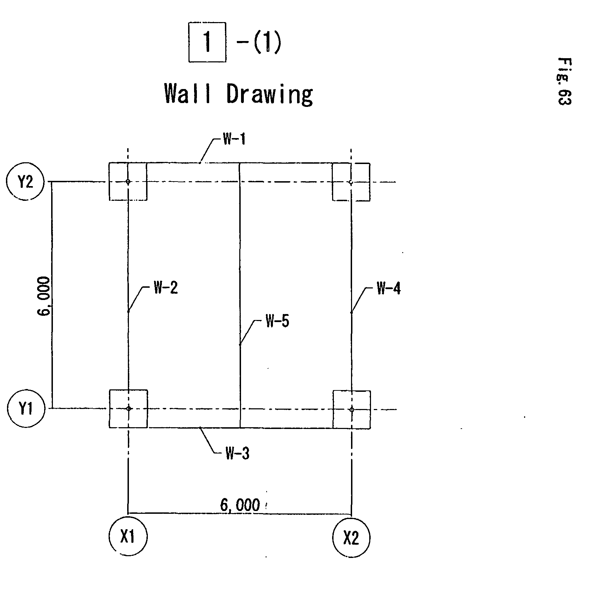

Figures 61 to 63 are explanation figures to show generated examples (1) to (3) of a total design piece (a planning design piece). In this example, the designer draws a figure of a service duct, columns and walls as planning data pieces, by using external application software such as a CAD or by using the CAD function contained in the system of this invention. Although these are basic design examples, if such figures as these (planning figures drawn using single lines) are already drawn by using a CAD or the like, the same figures can be used for the basic design. The process here corresponds to the process of [1] - (1) in Fig. 28.
Symbols of W-1 ∼ W5 in Fig. 63 are illustrated on the figure just for later explanation. These are undefined at this moment.

Figure 64 is an explanation figure to show a generated example (4) of a total design piece (a planning design piece). In this example, the wall in the center W-5 (where the name of W-5 is still undefined actually) is selected as the target object.

Figure 65 is an explanation figure to show a generated example (5) of a total design piece (a planning design piece). In this example, W-5 is a total design piece management name that the system of this invention attached as a serial management name to this total design piece. The position data DL (the DL name is "BI-W00001-Z") is selected from DLs, and default values of 200 and 400 in the DL for parameters "D" and "L", respectively, are referred and stored as initial values. A line segment which is a figure piece to express the selected object is memorized as a "LINE", and coordinates of the origin and the termination of the line segment are stored by real numbers as "3,000, -500, 0" and "3,000, 6,500, 0". Names "A" and "B" are attached to the coordinates, respectively, by the system. The origin point and the termination of the segment that show the relationship between the figure piece of the selected object and its coordinates are memorize as "START" and "END". Additionally, requirement names, requirements, a weight name and the weight value are memorized by referring to the default numbers of the DL. The generation history information such as "Taro Yamada" or "2000-04-05-14-20-21" is memorized by referring to the initial setting or the system information. In such a way as explained above, the total design piece (planning design piece) "W-5" is generated and stored.

Figures 66 to 69 are explanation figures to show generated examples of a total design piece (a connection design piece). A total design piece is displayed first as shown in Fig. 66. Then areas where two walls or a wall and a column compete are defined in Fig. 67 as total design pieces (connection design pieces) "WP-1" to "WP-10". The total design piece "WP-9", for example, consists of the total design pieces (planning design pieces) "W-1" and "W-5" (see Fig. 63). Definitions as the total design piece (connection design piece) become "2obj'-3way" as a "relation piece", the "related total design piece management names" as "W-1" and "W-5" and the "related coordinates" as "MID(C,D)" and "END (B)". Thus, it becomes possible to manage real coordinate values of the total design piece (connection design piece) "WP-9" and to memorize the total design pieces (planning design pieces) relating to those areas and the relationship concerning those areas (the center of a wall or the comer of a column, for example), making it possible to define and manage data logically, in order to develop logical ideas and processes in design. Then, the connection data are selected from DLs to be related each other, the total design pieces (connection design pieces) are generated and reflected to the total design pieces (planning design pieces). Coordinate values for coordinates "A" and "B" corresponding to the center partitioning wall "W-5" are "3,000, -500, 0" and "3,000, 6,500, 0" before the reflection (Fig. 68), and these temporary names are changed to the total design piece (connection design piece) management names of "WP-9" and "WP-10". In this way the total design pieces (planning design pieces) are connected to the total design pieces (connection design pieces) and coordinate management by the total design pieces (connection design pieces) becomes possible. Through definition of the connection design pieces (planning design pieces), the contents of total design piece (planning design piece) change is stored in the total design piece change history DB. Thus, by relating total design pieces (planning design pieces) and total design pieces (connection design pieces) and by referring to DLs that manages meaning of each design piece, a shape and composing elements of a building space (the shape and the composing elements of a living space, for example) and the relation between them can be managed, enabling calculation and management of each room area and a zoning or a blocking area based on attributes of each design piece, as well as calculation of an area using wall surface sizes or calculation and management of an effective area using wall depth center sizes.

Figures 70 to 73 are explanation figures to show a generated example of a detail design piece (a plane figure). Firstly a total design piece is selected (Fig.70), then PC-1 to PC-4 and PW-1 to PW-5 as detail design elements (planning design elements) are generated (Fig. 71). Next, PP-1 to PP-10 as detail design pieces (connection design pieces) are generated for the competing portions (Fig. 72). Finally, extension data (ex-1 to ex-26) are generated from the detail design pieces (Fig.73). In a plane figure at basic design stage, a "wall" or a "partitioning wall" is expressed by a line segment. In generating detail design pieces and extension data, DLs having the meaning of "walls" and "partitioning walls" in the total design piece (planning design piece) layer are related to the detail design pieces (planning design pieces). Then, detail design pieces and extension data are deployed by using extension programs and processing programs. Similar processes are carried out for the connection design pieces.

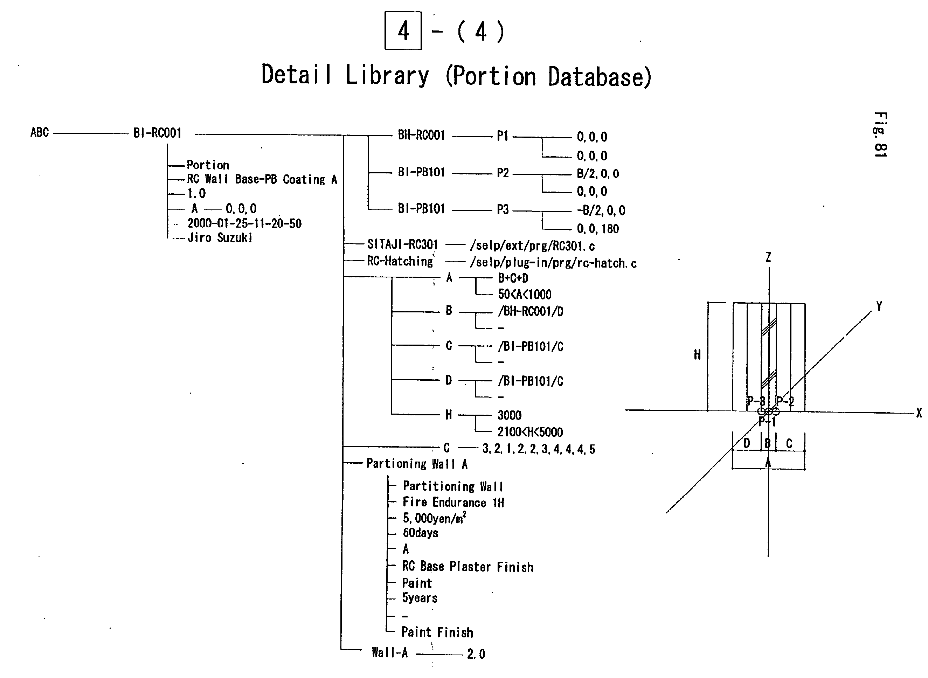

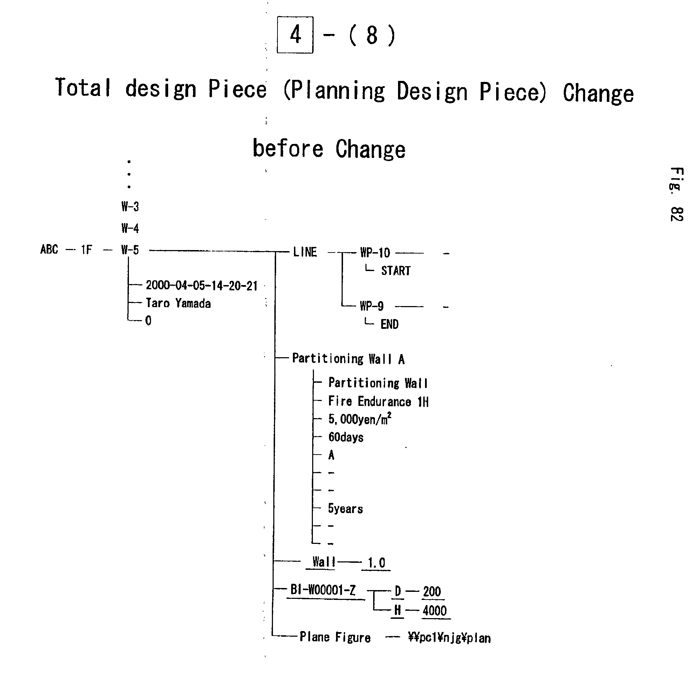

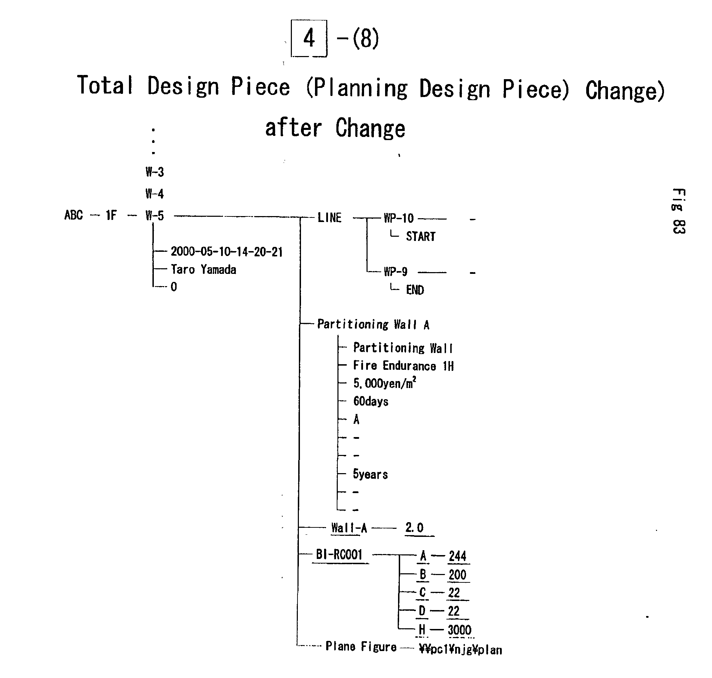

Figures 74 to 83 are explanation figures to show examples of total design piece change (DL change). At this processing step, DL data for total design are replaced by data for practical design according to the design progress from basic design to practical design. Firstly, a total design piece (W-5) is selected (Fig. 74). Next, the DL data of this total design piece (BI-W00001-Z in Fig. 82) is related to the position data of the wall in Fig. 81 (BI-RC001) by DL replacing (Fig. 83).

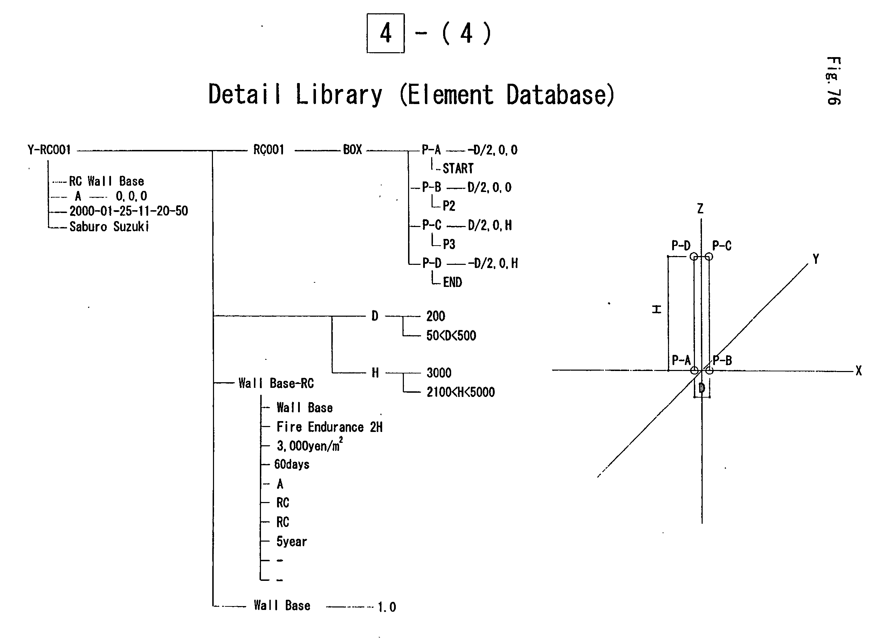

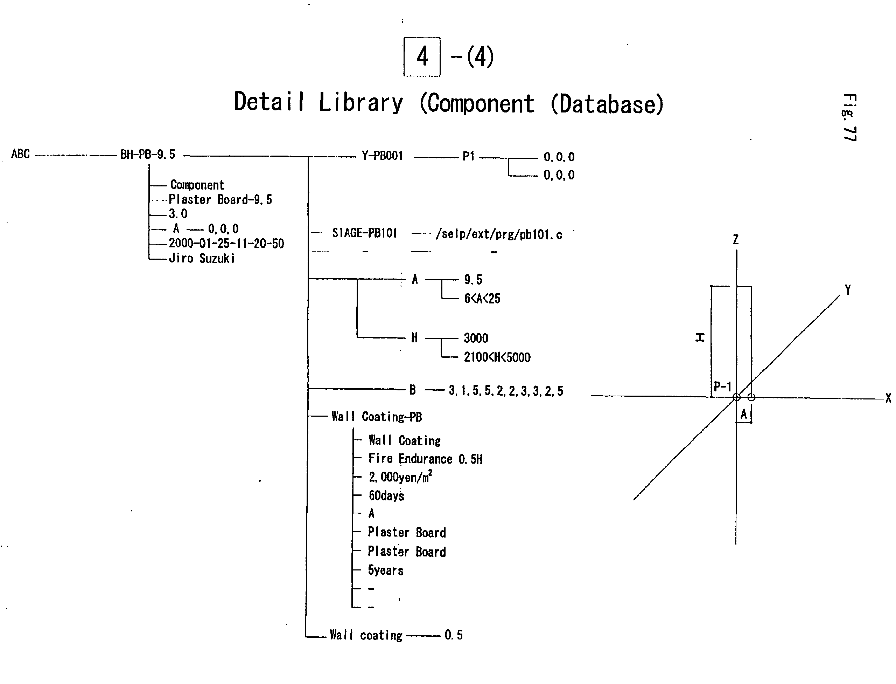

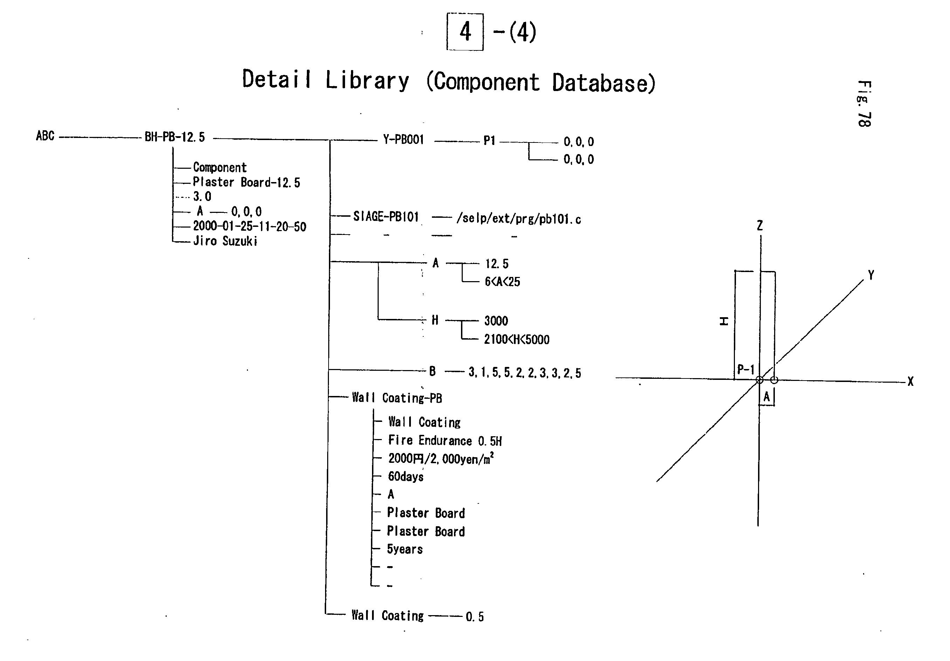

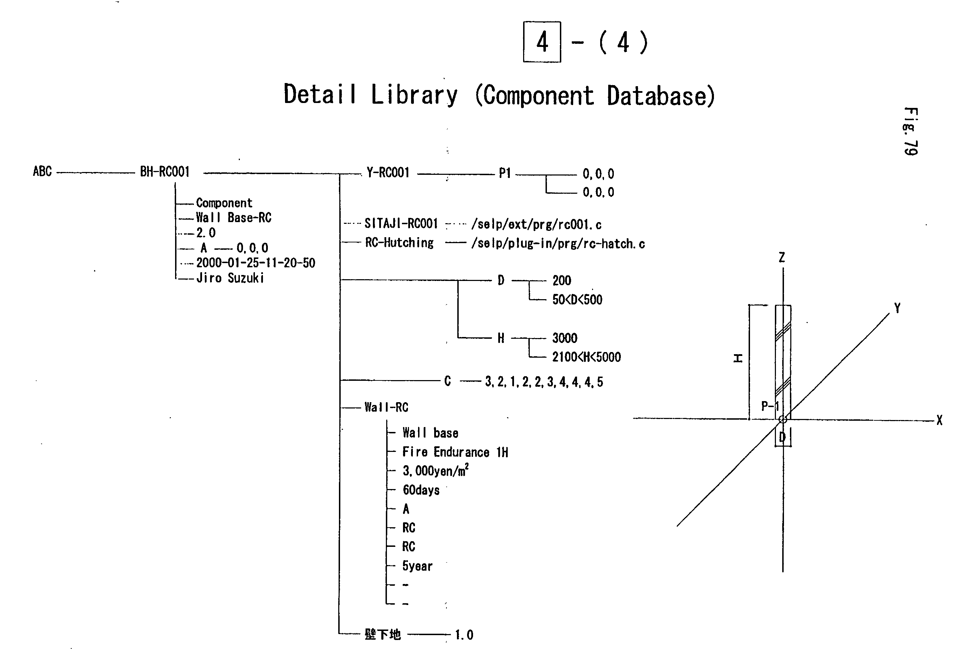

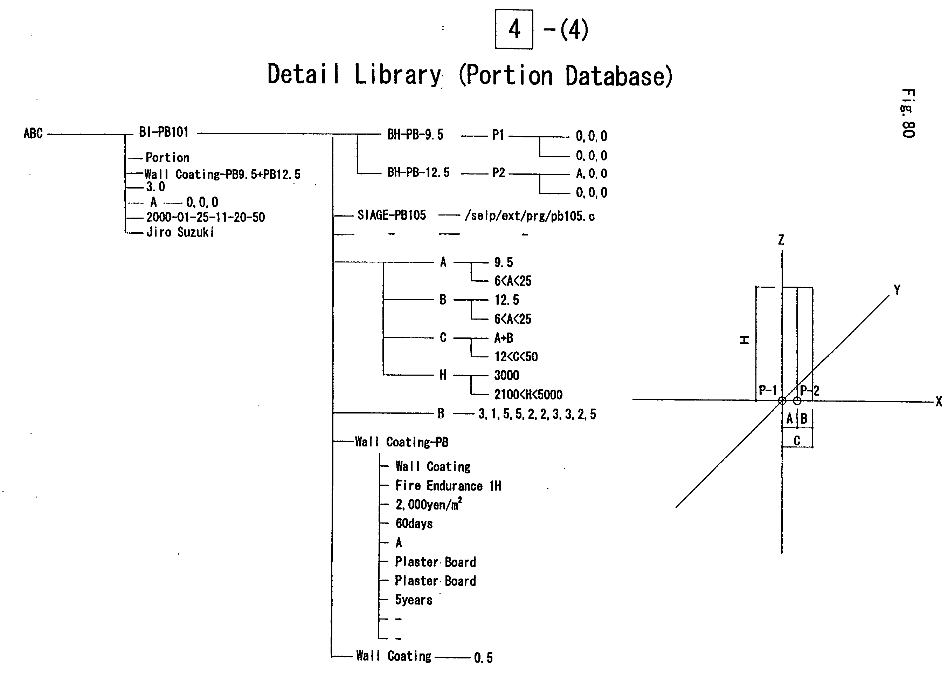

The five-layered position data expressing the wall (BI-RC001) consist of two sets of position data (BI-PB101) in Fig. 80 and one component data (BH-RC001) in Fig. 79. Further, position data of wall finishing with two stuck plaster plates (BI-PB101) consist of component data (BH-PB-9.5) shown in Fig. 77 and component data (BH-PB-12.5) shown in Fig. 78. Similarly, Wall base component data (BH-RC001) consist of element data (Y-RC001) shown in Fig.76 and the component data of the plaster board (BH-PB-12.5) consist of the element data (Y-PB001) shown in Fig. 75.

Figures 84 to 88 are explanation figures to show generated examples of a detail design piece (a detail plane figure). A total design piece is displayed first. Next, select a command for detail plane figure generation among the displayed extension program menu, to select the target total design piece, "W-5", for example (dotted lines in Fig. 84). Then detail design pieces (planning design pieces), DW-1 to DW-5, are generated by using the DL extension program that relates the detail design pieces to the total design pieces (planning design pieces) (see Fig. 85). For example, when the position data of the DL (BI-RC001) are related to the total design piece (planning design piece) "W-5", as explained in the previous example, detail design pieces (planning design pieces) "DW-5-S1" which means a wall base, "DW-5-F1" and "DW-5-F2" which mean a wall finish, are generated as data to be expressed on detail plane figures which belong to the detail design piece deployment division. This data generation is carried out by the extension program defined in the DL, BI-RC001. Among the layered DLs of the total design piece DL (BI-RC001), a DL having the same meaning as the detail design piece is related to the corresponding detail design piece. For example, the detail design piece "DW-5-S1" means a wall base, so that it is related to the DL BH-RC001 (Fig. 79) that means a wall base in the layered DLs of the total design piece. Similarly, detail design pieces ''DW-5-F1" and "DW-5-F2" that mean wall finishes are connected to the DL, BI-PB101, in Fig. 80, that means a wall finish. Figure 86 shows the status of the detail design piece (planning design piece) after execution of the processing program that is defined in the total design piece (connection design piece). One Detail design piece ("DW-1-F1") is divided into two detail design pieces ("DW-1-F1-1" and ("DW-1-F1-2"). Next, detail design pieces (planning design pieces), "DP-25" to "DP-27", are generated, and finally extension data (ex ---) to draw the detail plane figure as shown in Fig. 88 are generated from detail design pieces (planning design pieces) and detail design pieces (connection design pieces).

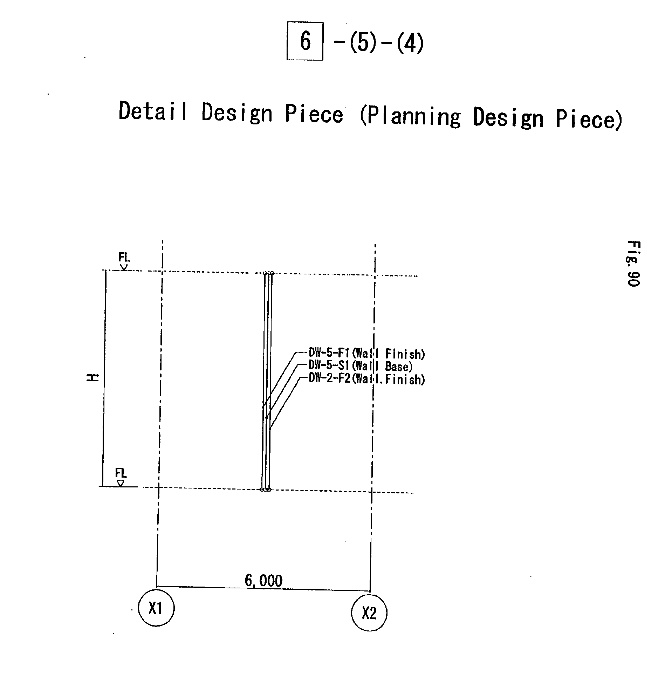

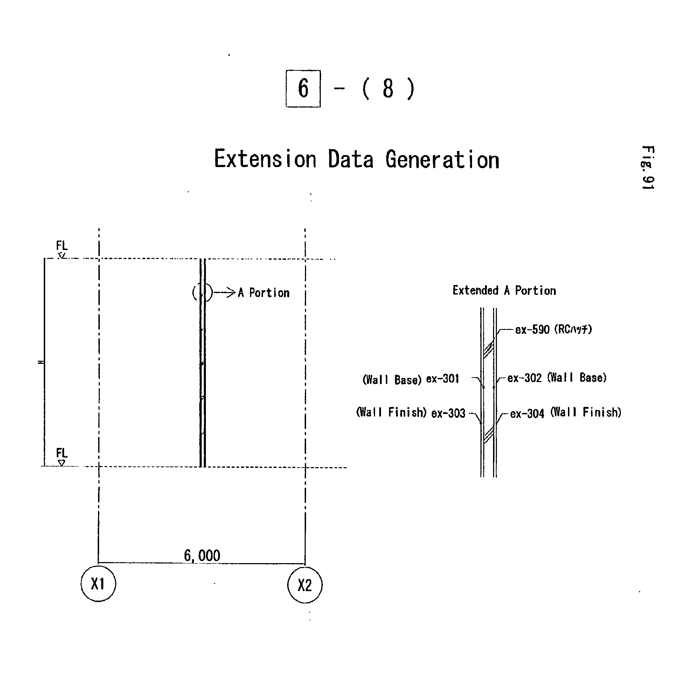

Figures 89 to 91 are explanation figures to show generated examples of a detail design piece (detail section figures). A total design piece is displayed first. Next, select a command for detail plane figure generation among the displayed extension program menu, to select the target total design piece, "W-5". for example (Fig. 89). As the target is a section figure, the place and the direction of the section are entered (Fig. 89). Then detail design pieces (planning design pieces) DW-2, ----, DW-5, ----, are generated (Fig. 90), and finally extension data for the detail section figure, ex----, are generated (Fig. 91).

Next, examples of other detail design piece change in the step [7] of the detail design piece change. In these examples, correction examples of the detail section figure and the general plane figure caused by a change in the detail plane figure are explained.

Figures 92 and 93 are explanation figures to show examples of correction for another detail design piece (in case of deletion of a detail design piece). The detail plane figure (extension data) is displayed first (Fig. 92). Then select the data (the wall finish) for deletion.

Figures 94 to 100 are explanation figures to show examples of correction for other detail design pieces (in case of addition of a detail design piece). A planning data piece to be added (shown as a dotted line in Fig. 94) is generated first. Then detail design pieces (planning design pieces), DW-7-S1 in Fig. 95, and detail design pieces, DP-35 and DP-36 in Fig. 96, are generated. Then the result is reflected to the existing extension data (ex-251 is deleted, and ex-251-1 and ex-251-2 are added), as shown in Figures 97 and 98. Finally the extension data shown in Fig. 99 are generated and a temporary total design piece manage name, W-KARI001, is attached and stored.

Figures 101 to 107 are explanation figures to show examples of correction for other detail design pieces, in case of adding detail design pieces and attaching them to a total design piece. Firstly, planning data pieces (dotted line segments in Fig. 101) are generated and DLs are related to the planning data pieces to generate detail design pieces (planning data of DW---, DC--- in Fig. 102). Next, detail design pieces (connection design pieces, DP---) are defined, and extension data (ex---) are generated (Fig. 104).

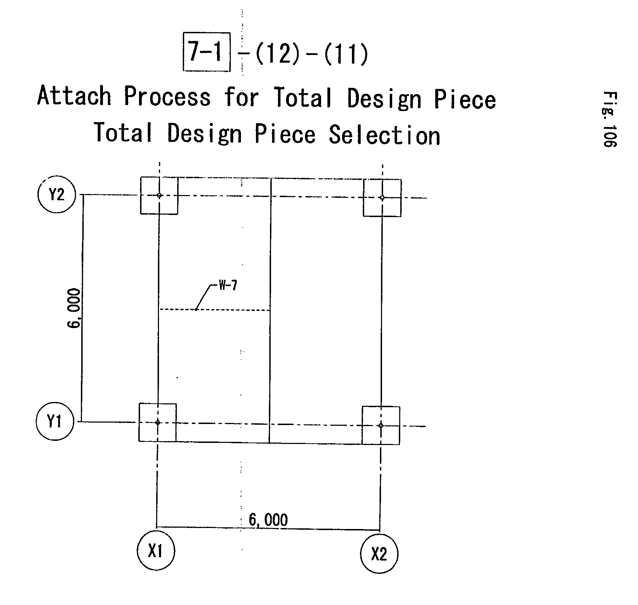

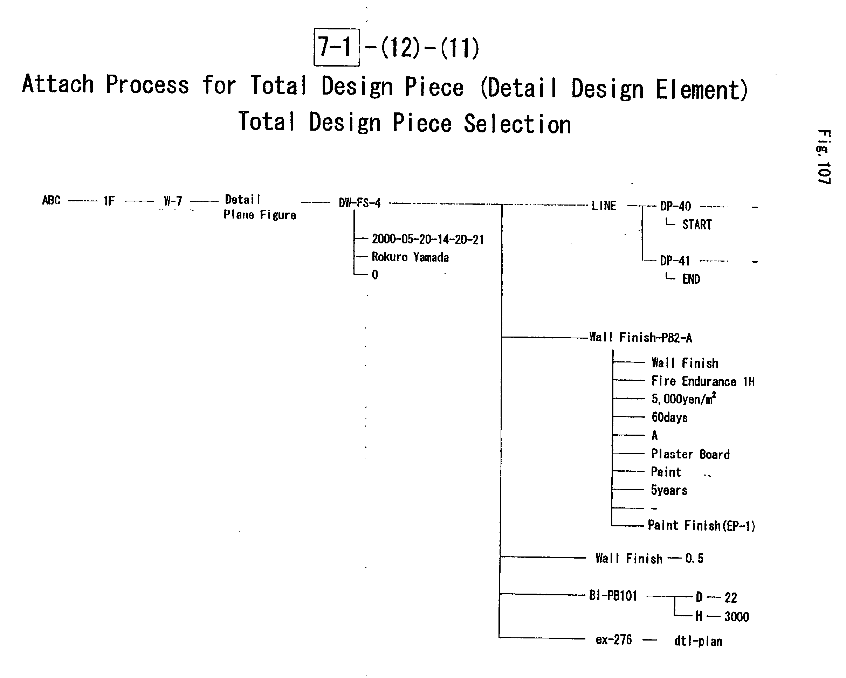

Then, Detail design piece (DW-FS-4) is selected (Fig. 105), and attached (related) to the total design piece (W-7) (Fig. 106). Consequently, The detail design piece (DW-FS-4) is related to the total design piece (W-7), as shown in Fig.107.

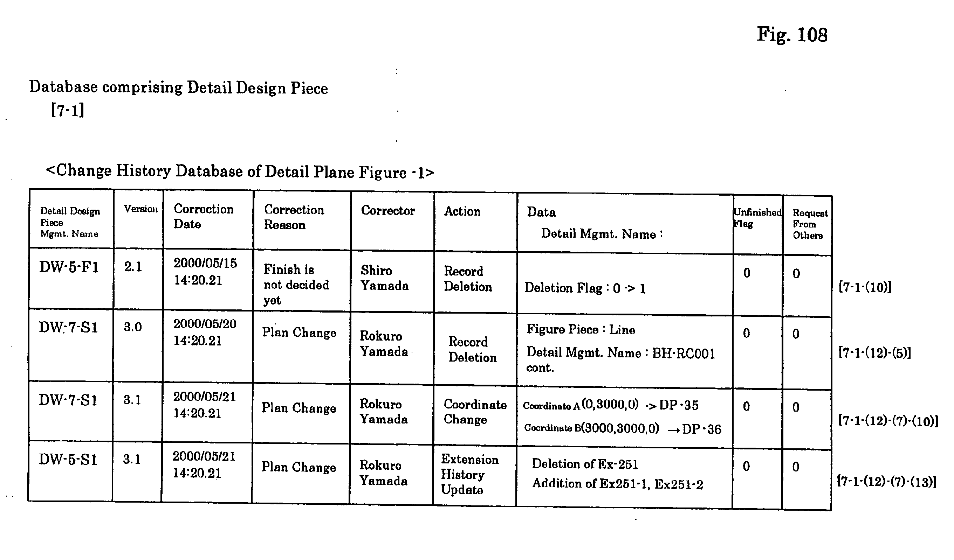

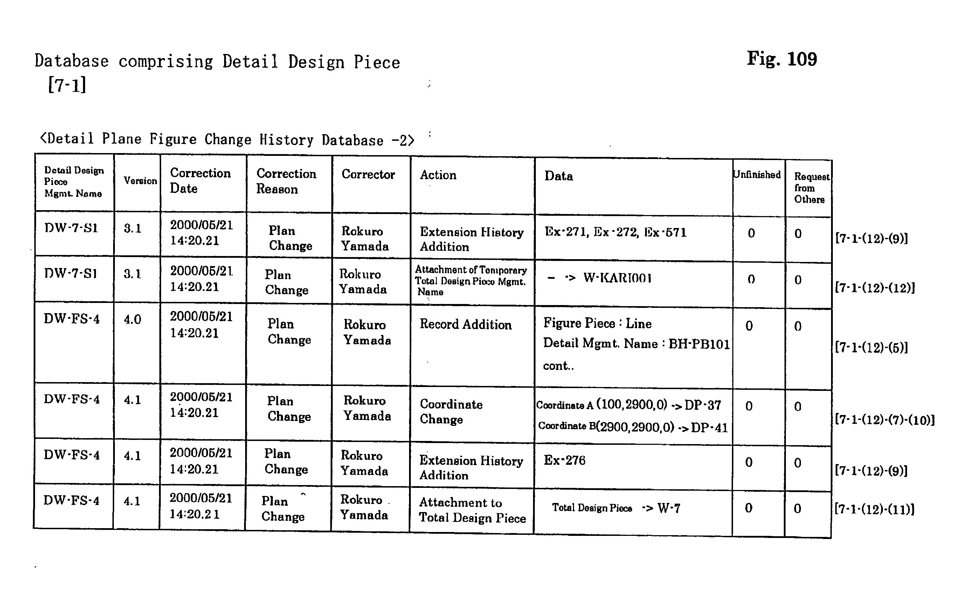

Figures 108 and 109 are explanation figure to show data examples of the detail plane figure change history DB. Correction history explained through Figures 92 to 107 is recorded in these DBs.

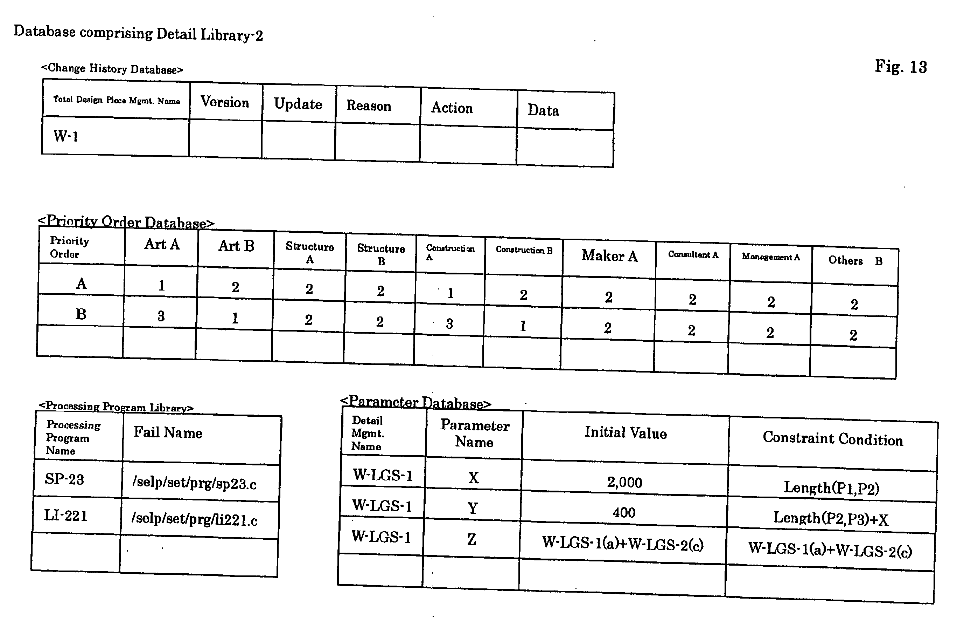

Next, correction synchronization is carried out. This is a process to reflect the detail design piece change results on the total design piece and other detail design pieces. Changes or updates for total design pieces or detail design pieces are carried out by an authorized designer having the highest priority. Priority orders are registered in the priority order DB shown in Fig. 13.

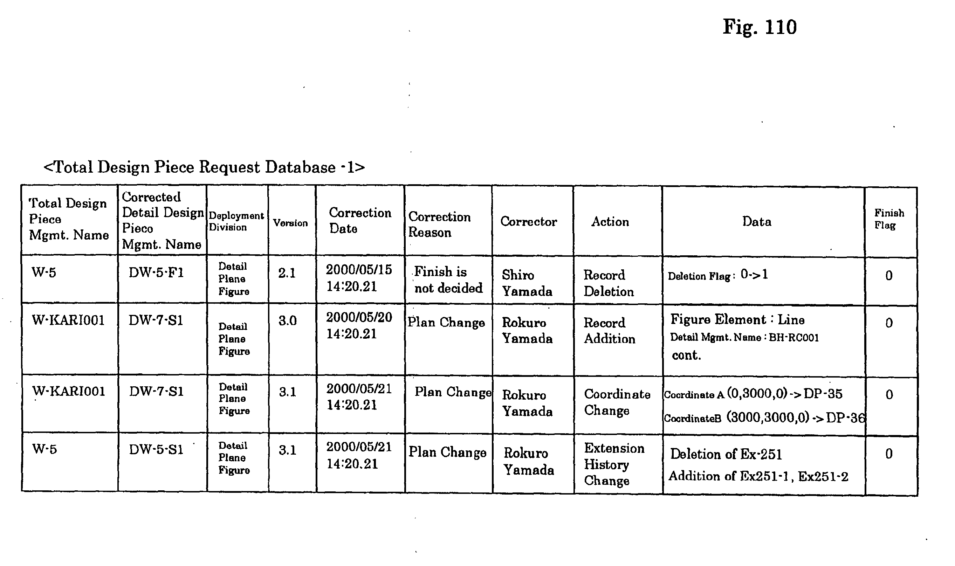

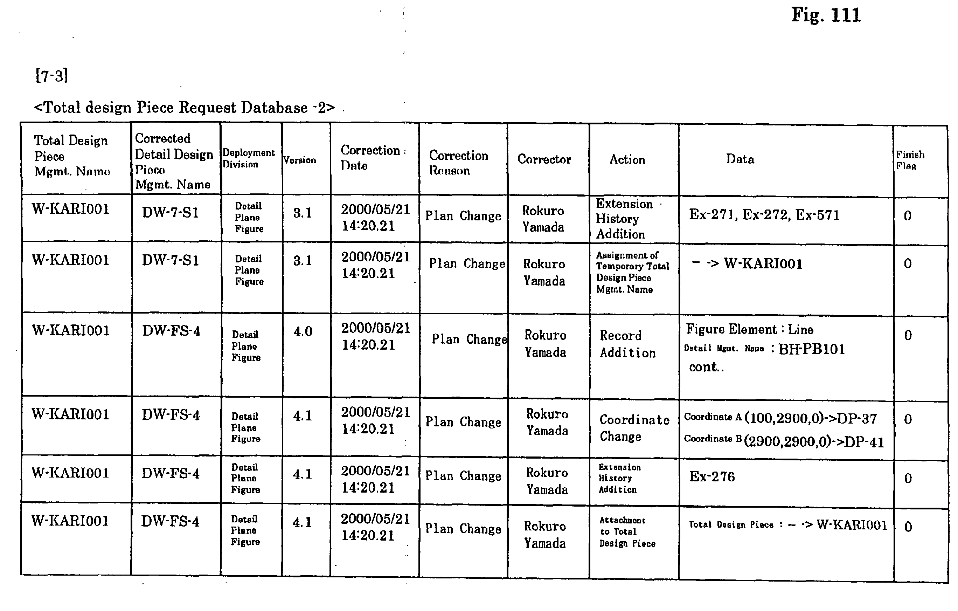

Figures 110 and 111 are explanation figures to show data example of a total design piece request DB. The contents of detail design piece change are stored in the "request DB" corresponding to the total design piece as shown in Fig. 36 [7-3]. That is, the contents of the detail design piece change history DB shown in Figures 108 and 109 are generated as the result of the reflection process to the total design piece request DB shown in Fig. 41.

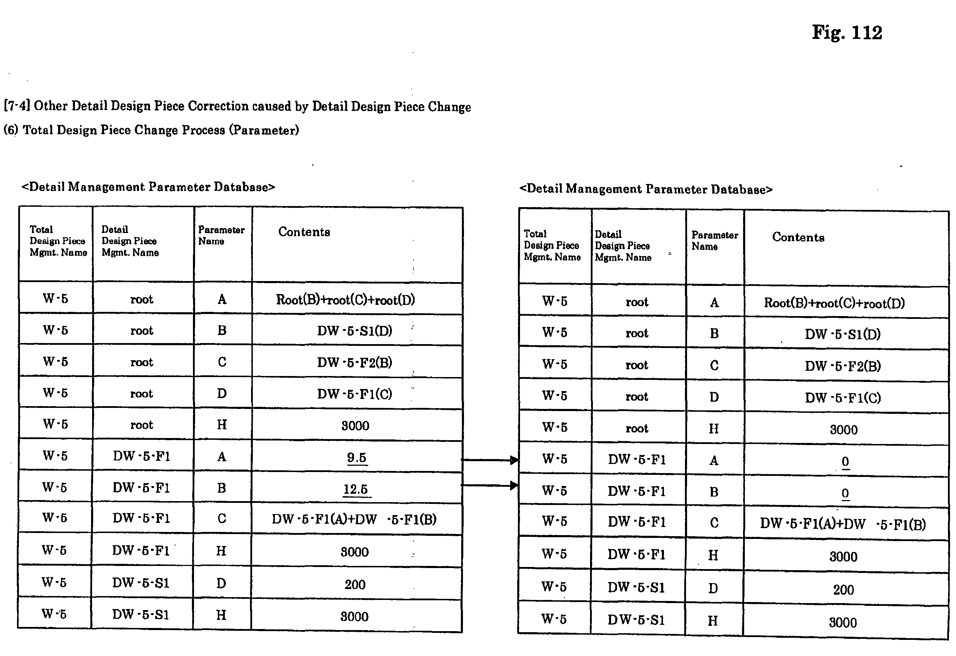

Figure112 is an explanation figure to show an example of change in a detail management parameter DB. In this example, values for parameters A and B of the detail management piece DW-5-F1 are deleted (set to zero), by the request to the" total design piece request DB".

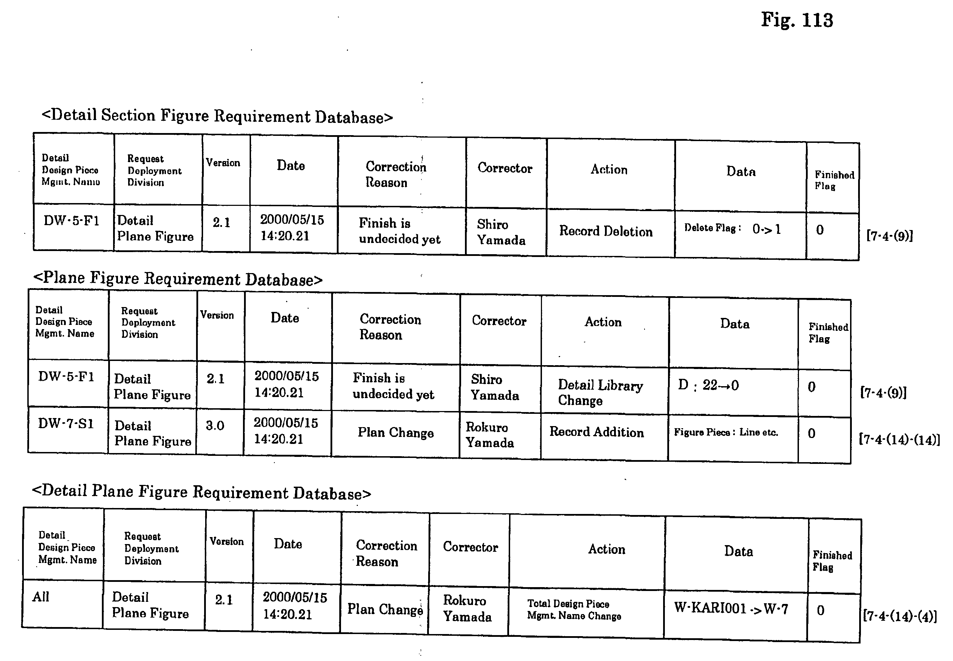

Figure 113 is an explanation figure to show a data example of a detail design piece request DB. DW-5-F1 deletion information is registered in the plane figure request DB by the process of [7-4]-(9). Information on the DL change of the detail design piece DW-5-F1 and on the addition of the detail design piece DW-7-S1 is stored in the plane figure request DB, and information on the management name change from W-KARI001 to W-7 is stored in the detail plane figure request DB, respectively.

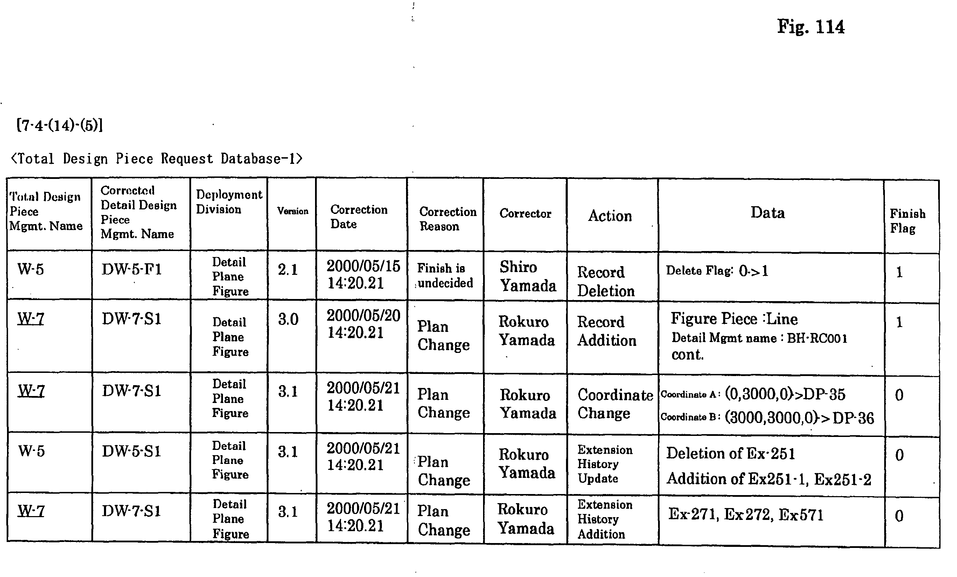

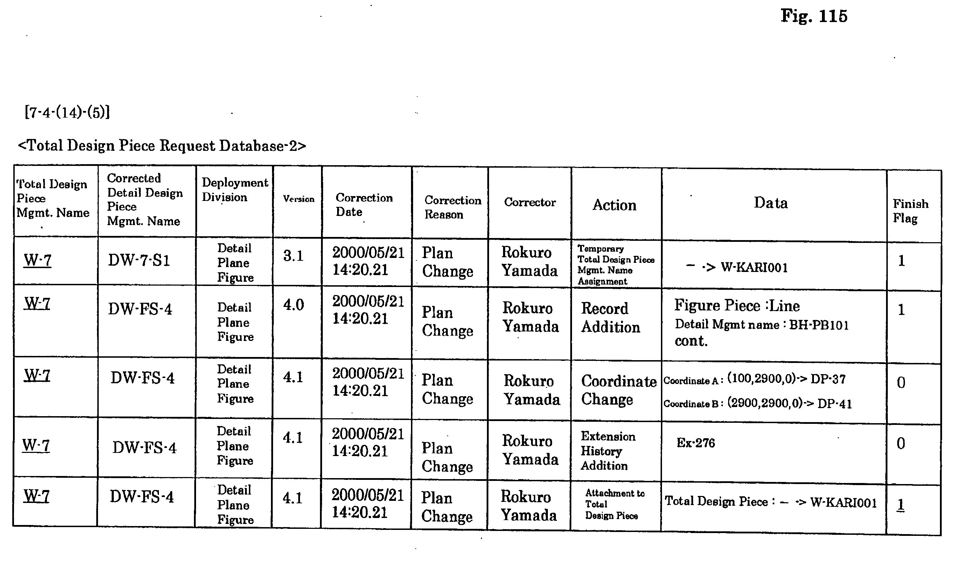

Figures 114 and 115 are explanation figures to show data examples of a total design piece request DB. The total design piece management name "W-KARI001" is changed to "W-7" by the process of [7-4]-(14)-(5). Also, a flag to show that the change process is finished is set in the total design piece request DB, by the information registration mentioned above.

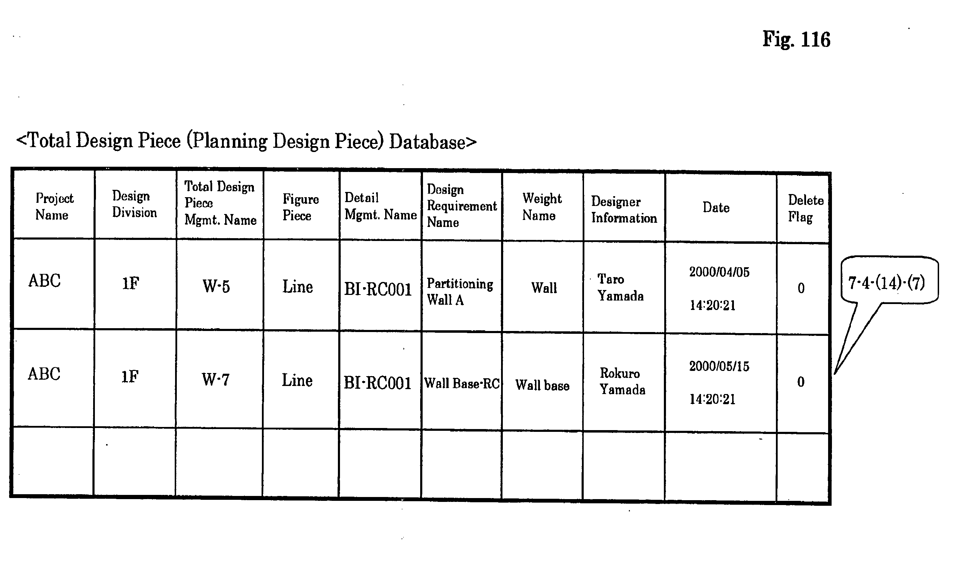

Figure 116 is an explanation figure to show a data example of a total design piece DB. The total design piece W-7 is newly registered in the total design piece DB.

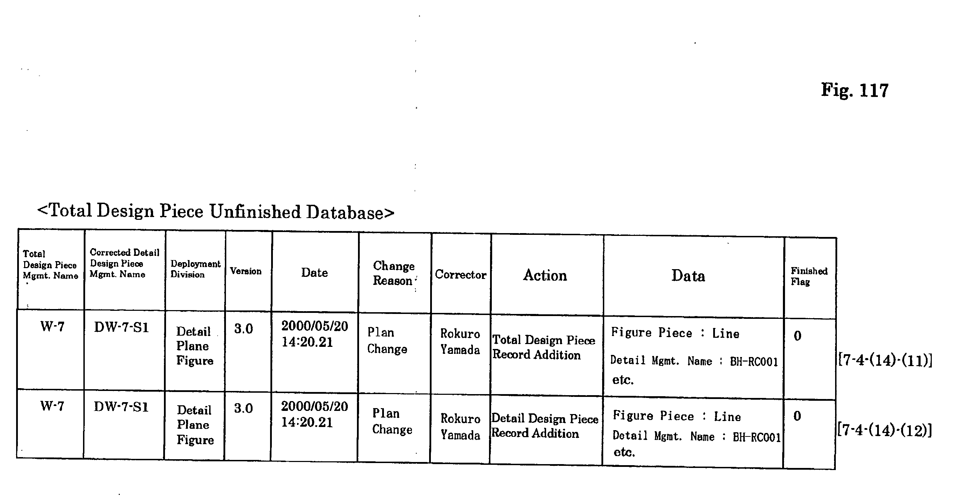

Figure 117 is an explanation figure to show a data example of an unprocessed total design piece DB. In this DB, correction information on the detail design piece DW-7-S1 is registered.

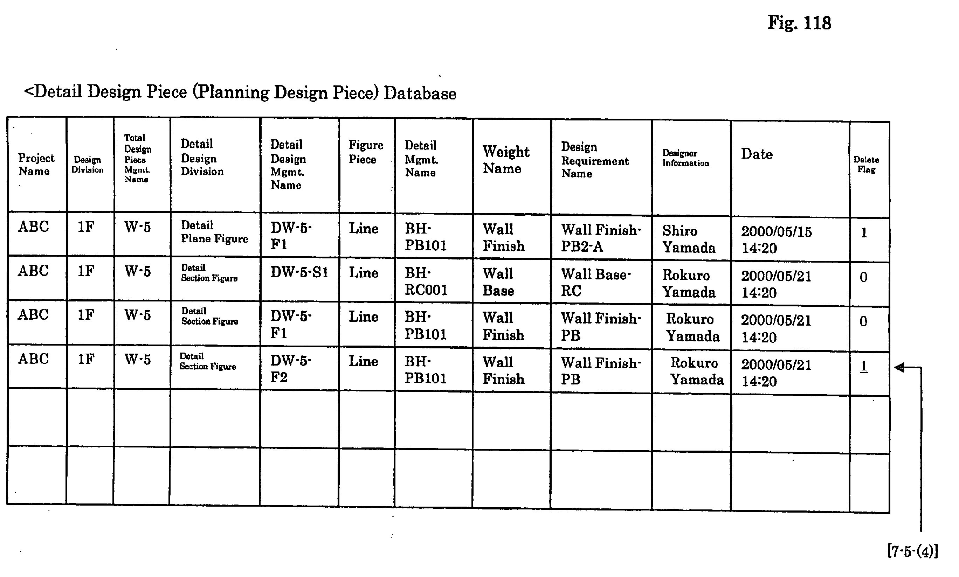

Figure 118 is an explanation figure to show an example of revision process for detail design piece DB (process to set a deletion flag for the detail design piece DW-5-F2).

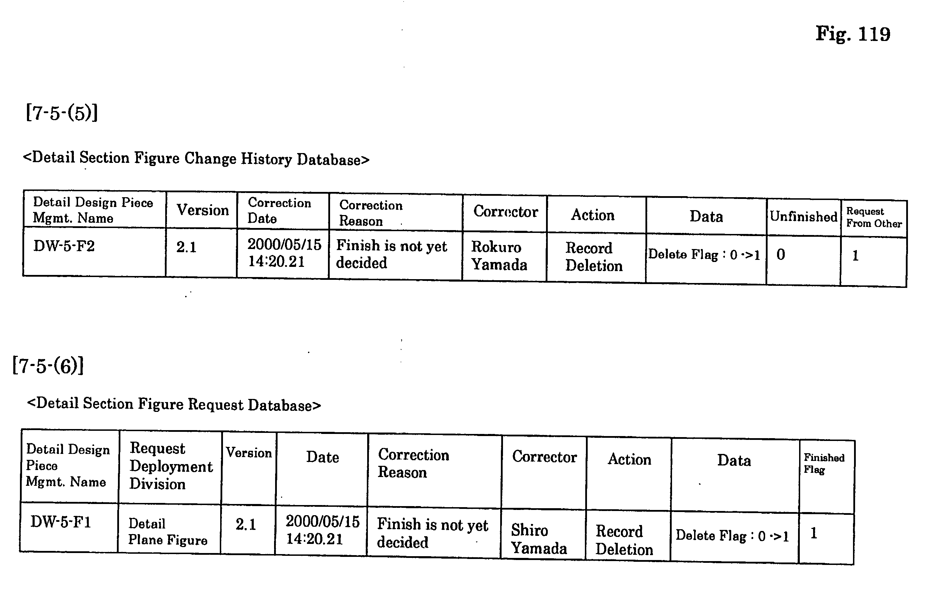

Figure 119 is an explanation figure to show data examples of a change history DB and a detail design piece request DB. The detail section figure is changed according to the change in the detail plane figure, and the change history information is recorded in the detail design piece change history DB corresponding to the detail section figure. Request flag in the figure showing "1" means the change is made by a request from a request DB. Also, A "finish" flag of 1 is set in the corresponding record of the request DB for the section detail figure.

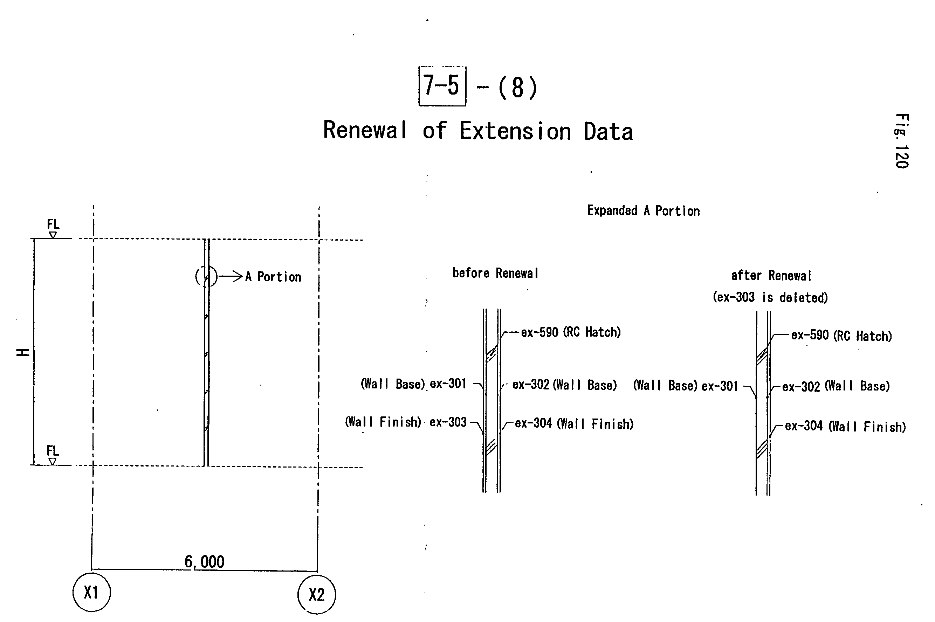

Figure 120 shows data change examples in the extension data of the detail section figure of which data pieces have the same meaning as the detail plane design pieces. The extension data ex-303 is changed (deleted) according to the change ("deletion" flag is "1") in the detail design piece.

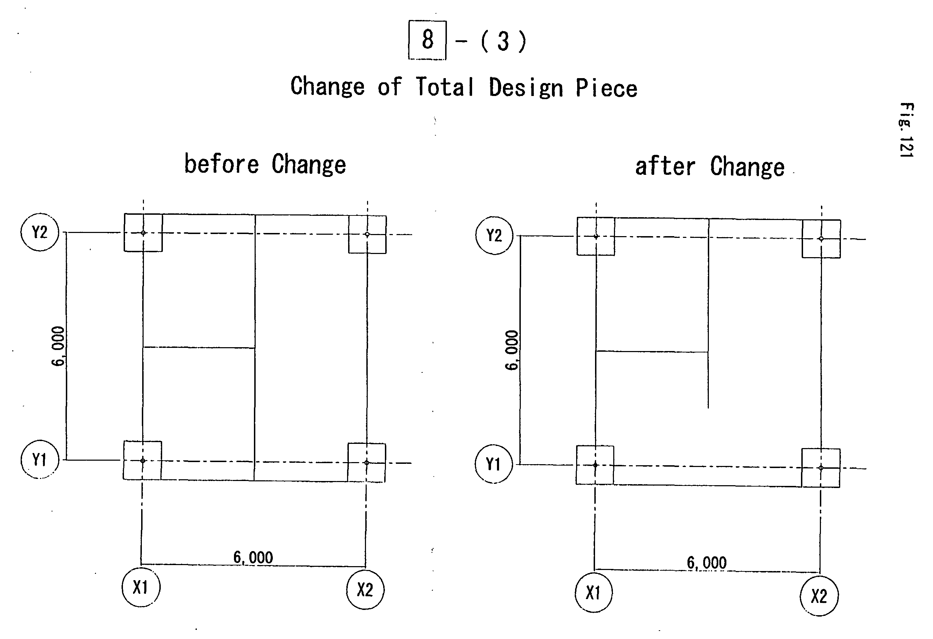

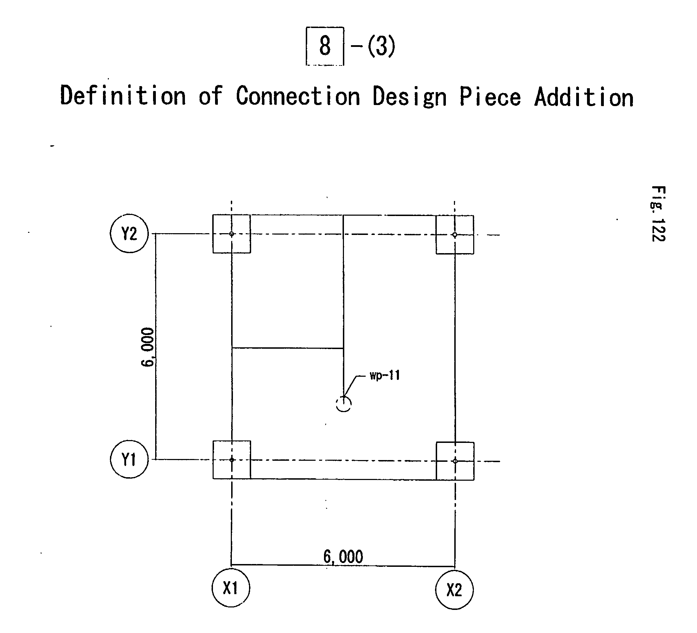

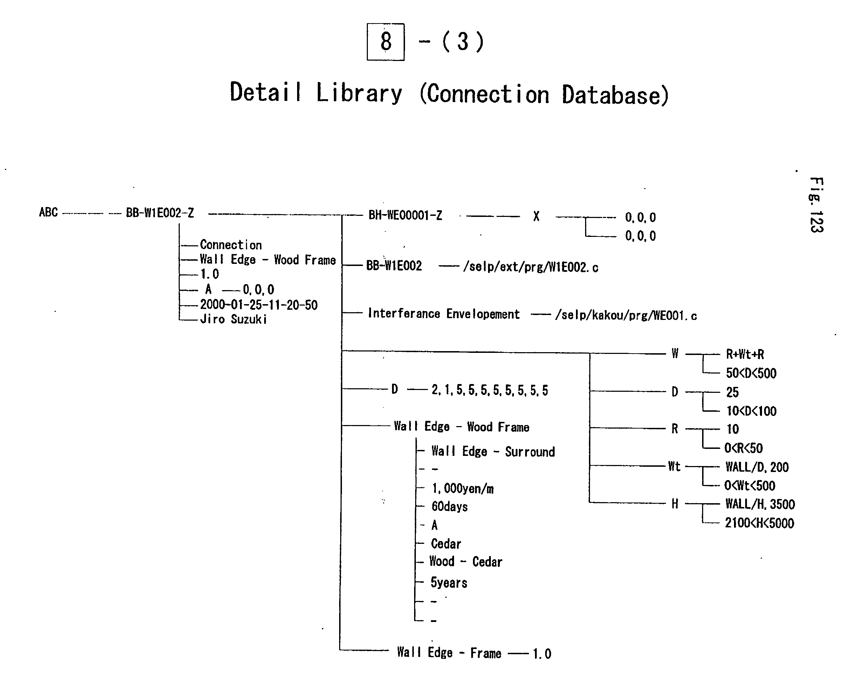

Figures 121 to 127 are explanation figures to show examples of correction for a detail design piece. First, the total design piece is changed as show in Fig. 121. Next, a connection design piece (wp-11) is defined newly. Then, a connection (BB-W1E002-Z) is selected from the DL and related to the detail design pieces.

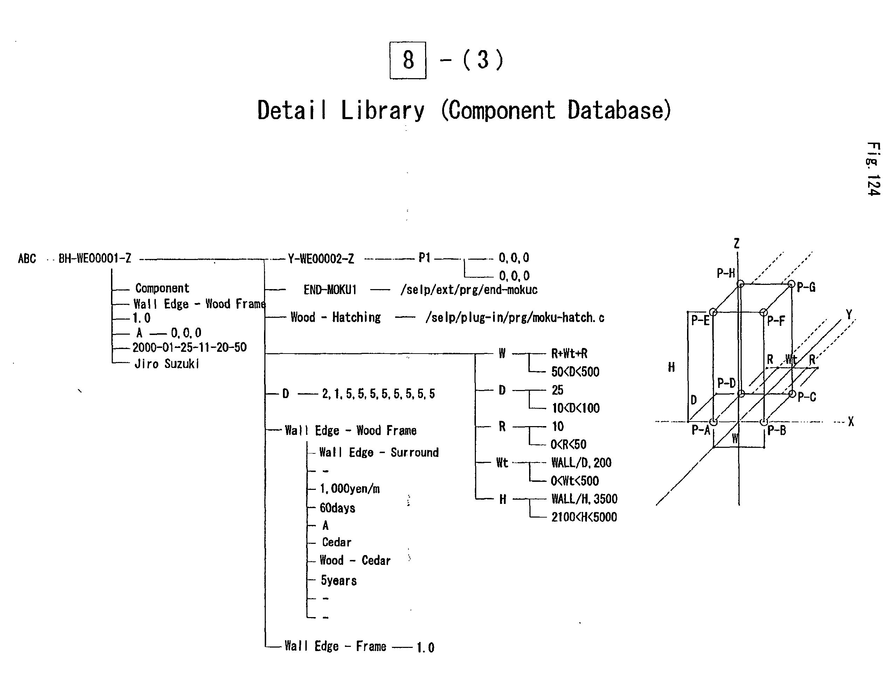

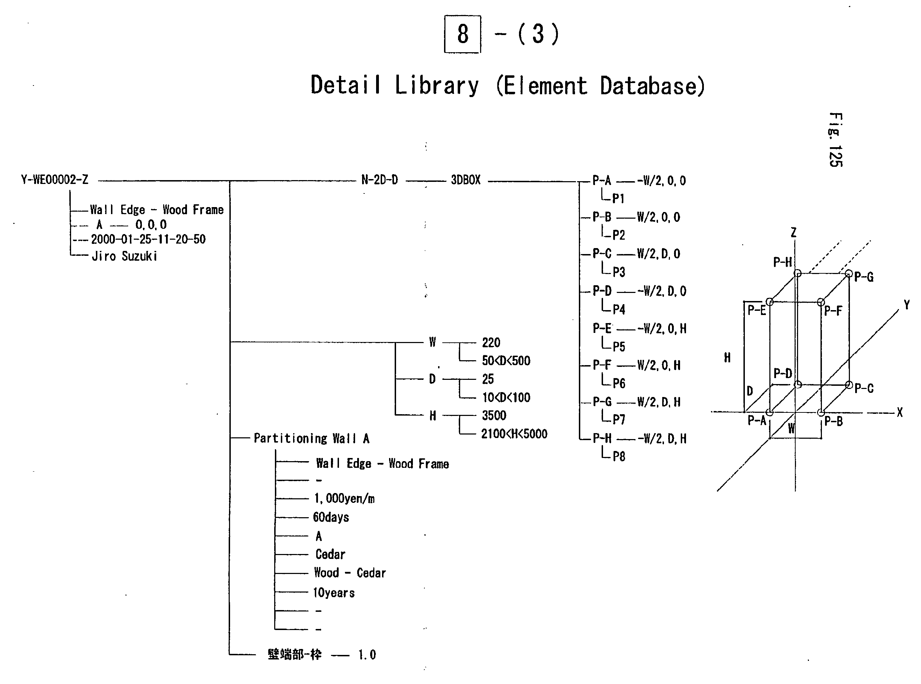

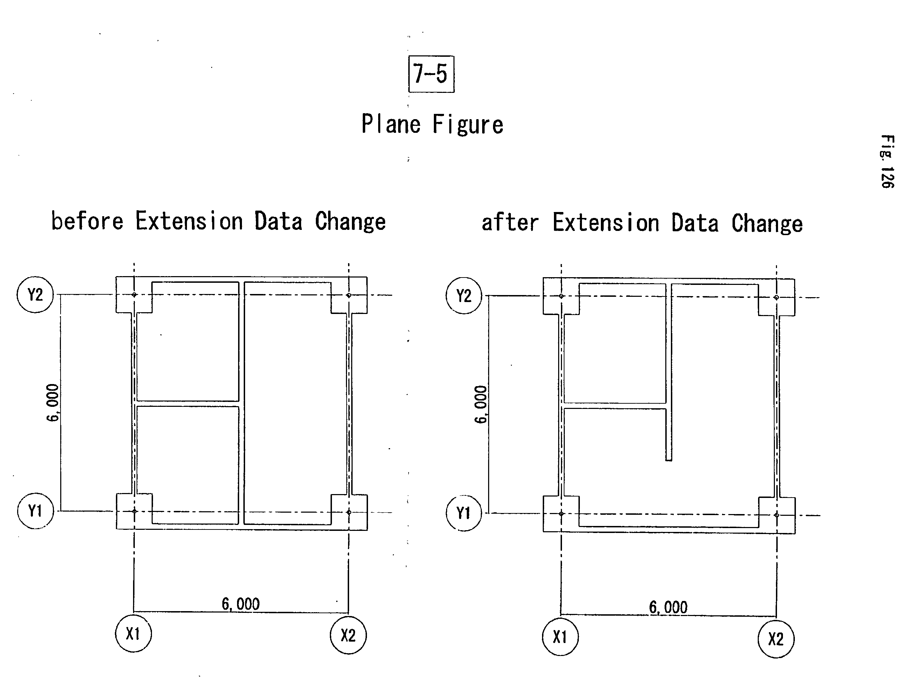

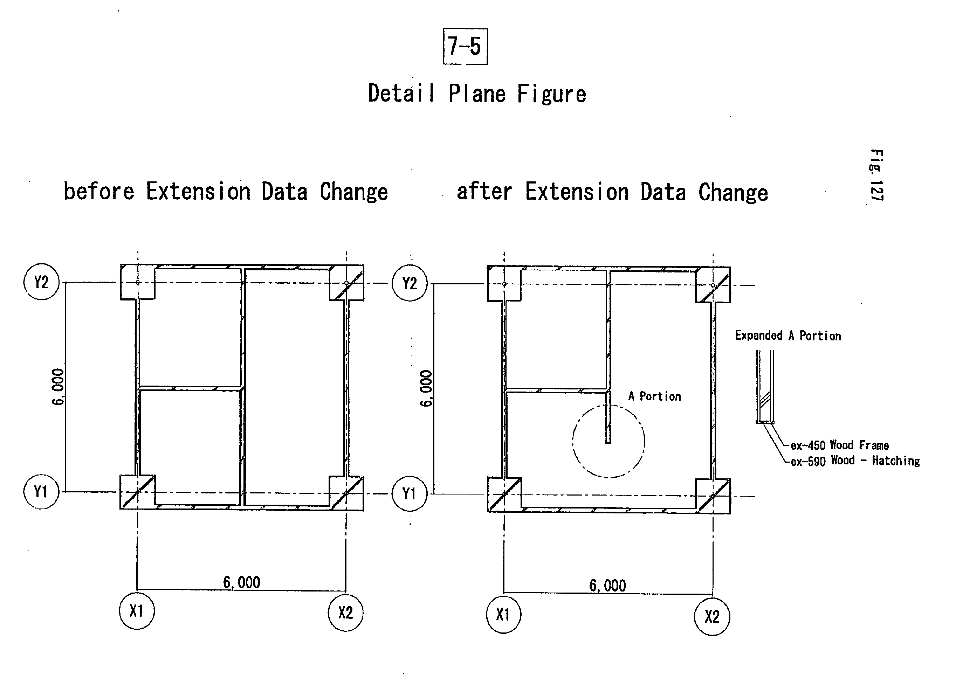

Figures 124 and 125 show a DL of a component BH-WE00001-Z, and a DL of an element Y-WE00002-Z, respectively, that compose the connection BB-W1E002-Z. Finally, extension data are updated according to each detail design piece change (Figures 126, 127). Extension data, "ex-450" and "ex-590° in Fig. 127 are additional data of the connection design pieces that are generated from the detail design pieces (connection design pieces) deployed from the total design piece (connection design piece) "wp-11".

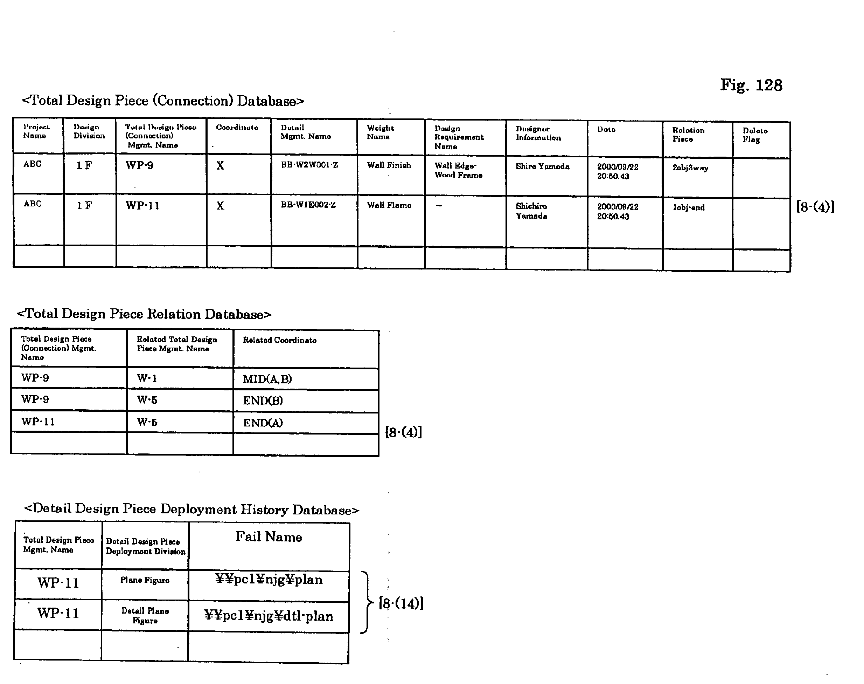

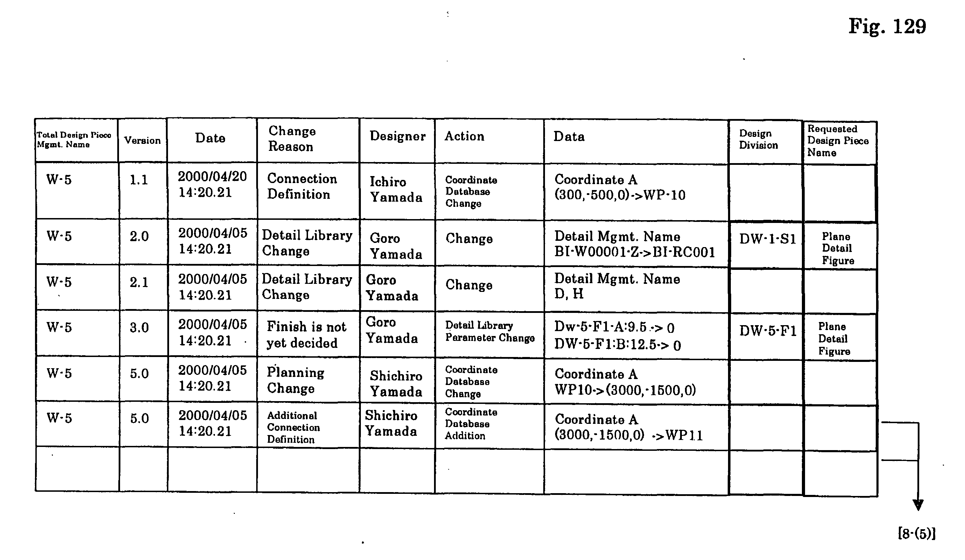

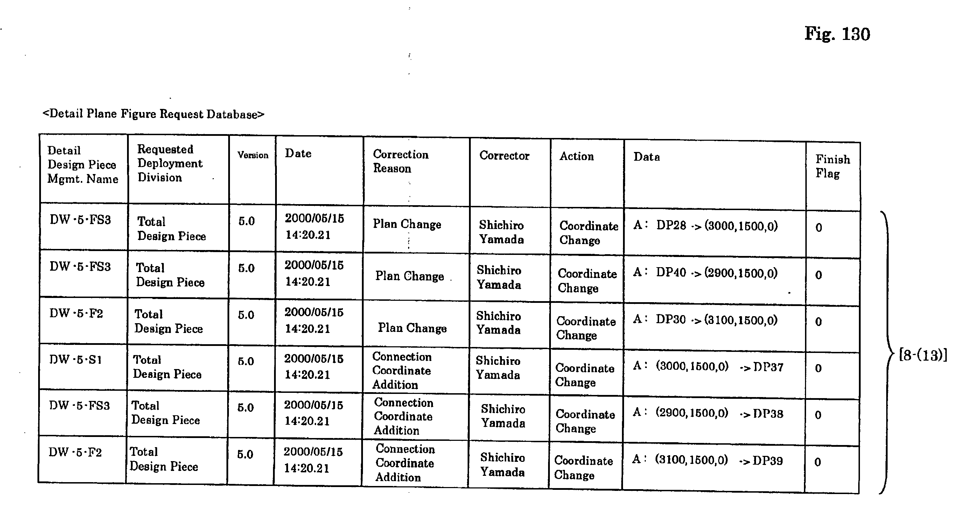

Figure 128 is an explanation figure to show a data example of a total design piece (a connection) DB. Figure 129 is an explanation figure to show a data example of the total design piece change history DB. Figure 130 is an explanation figure to show a data example of the detail plane figure request DB. According to the changes in the total design pieces, connection design pieces are released once and re- defined. Change history and change request information are recorded in each DB based on changes shown in Figures 121 to 127.

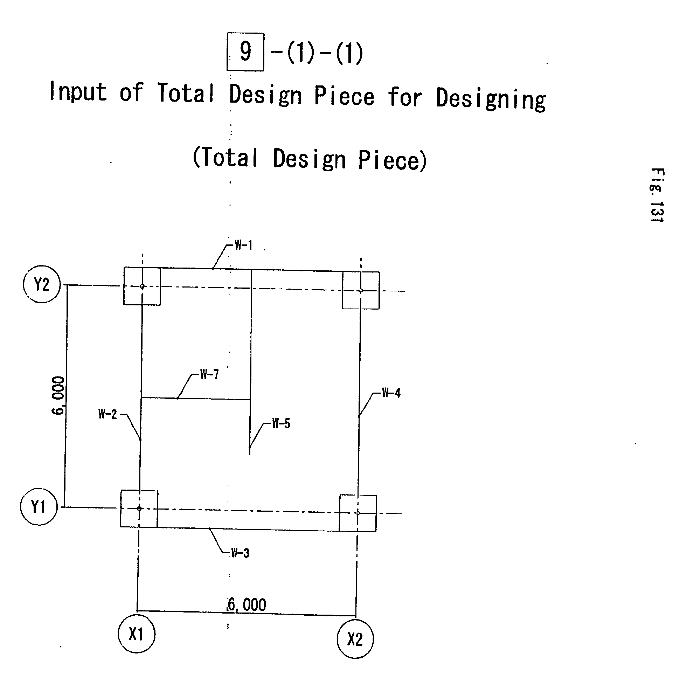

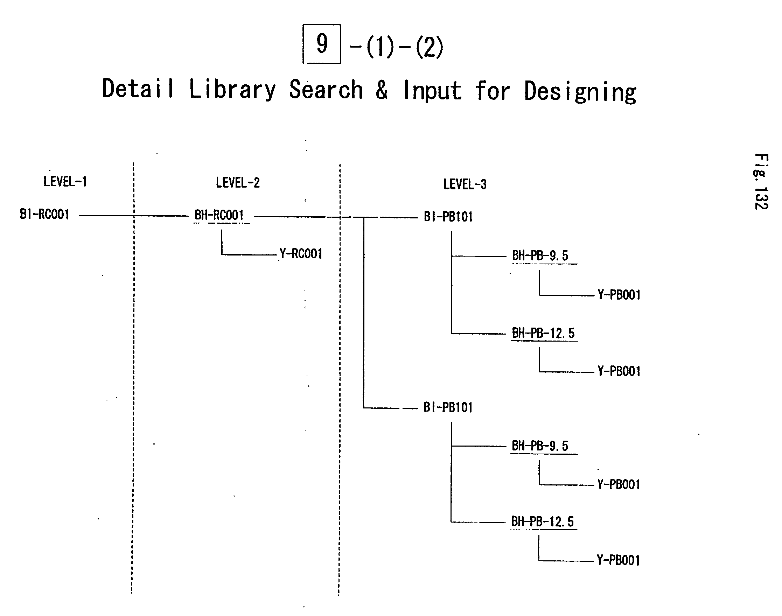

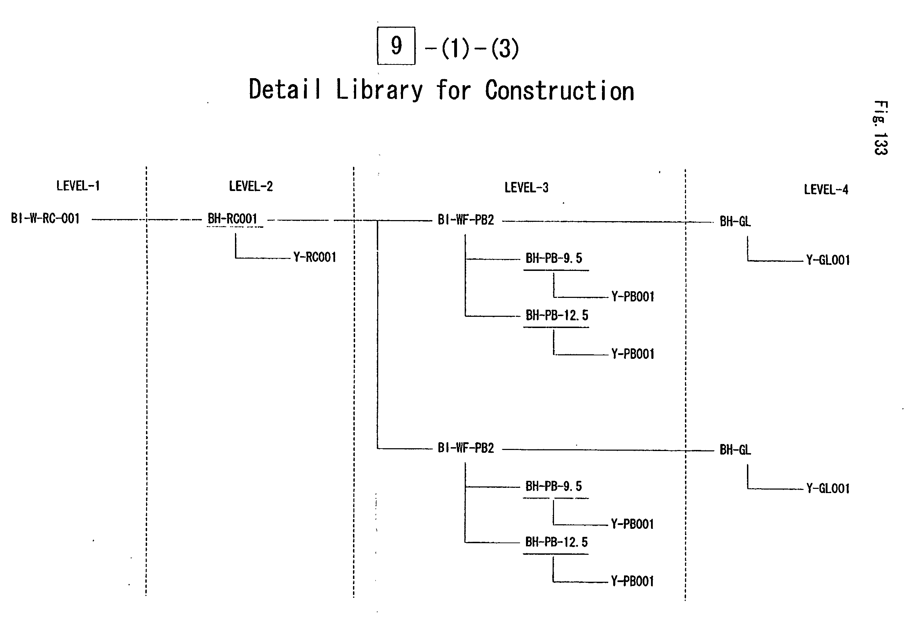

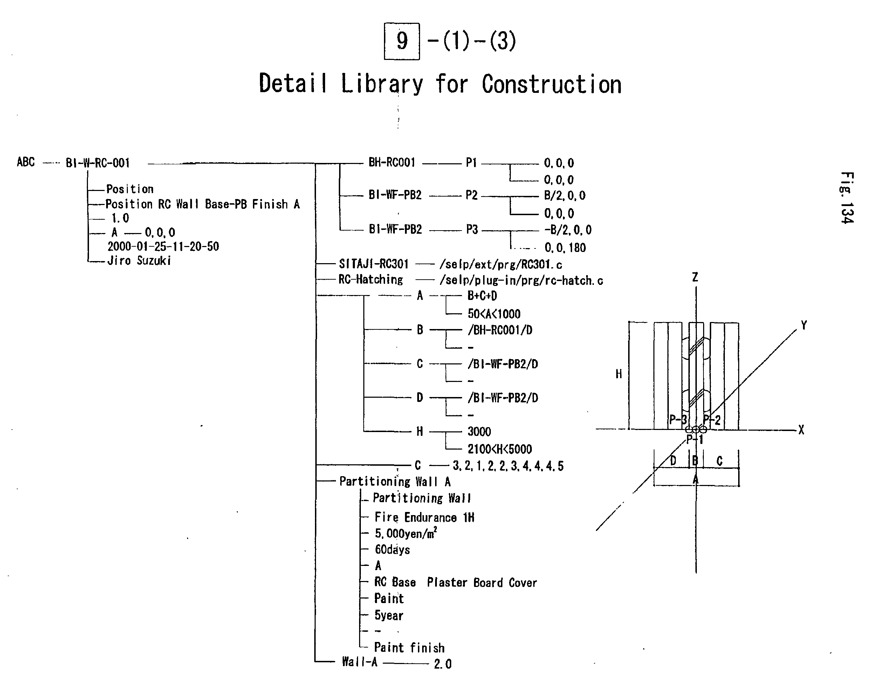

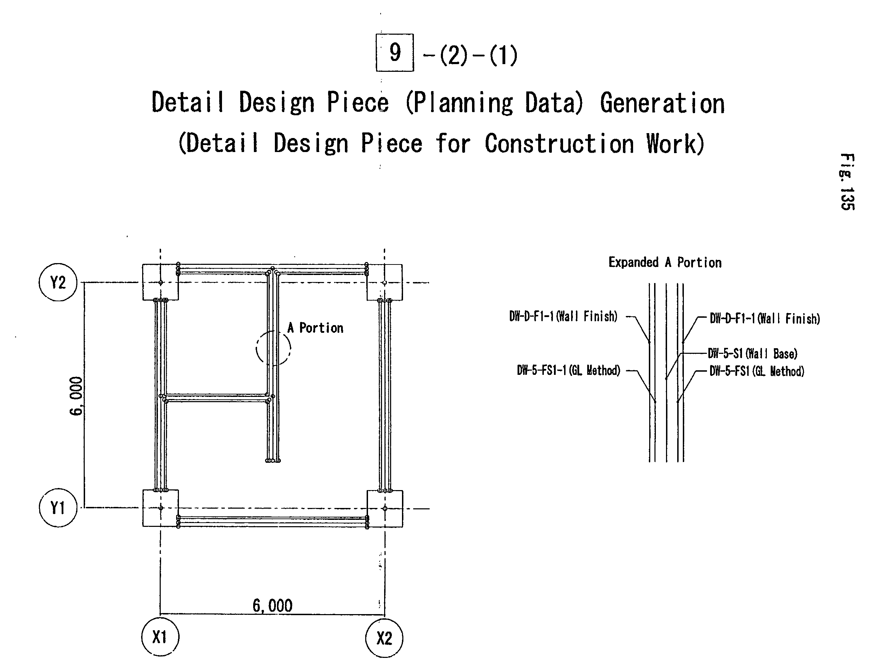

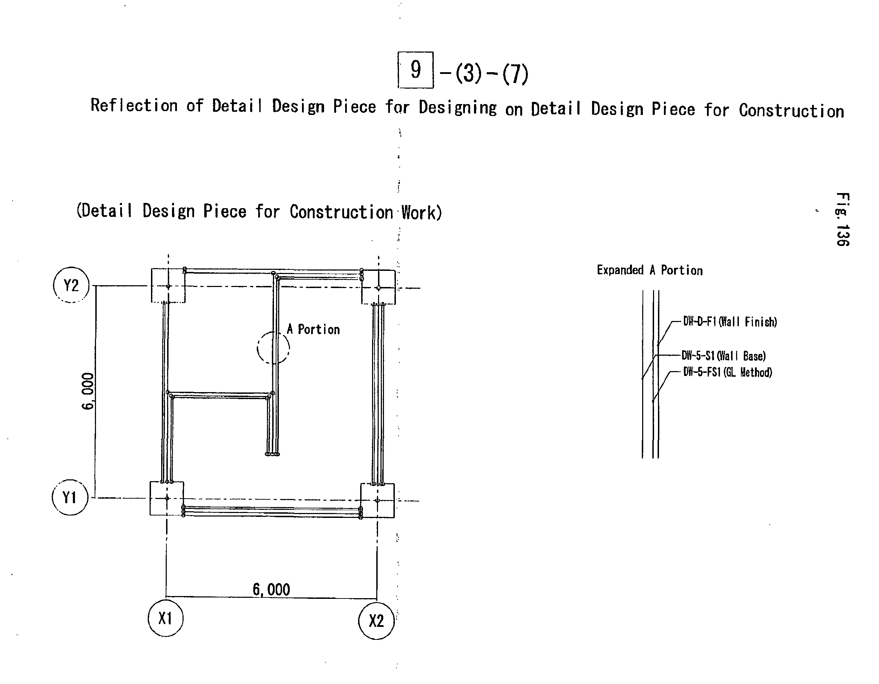

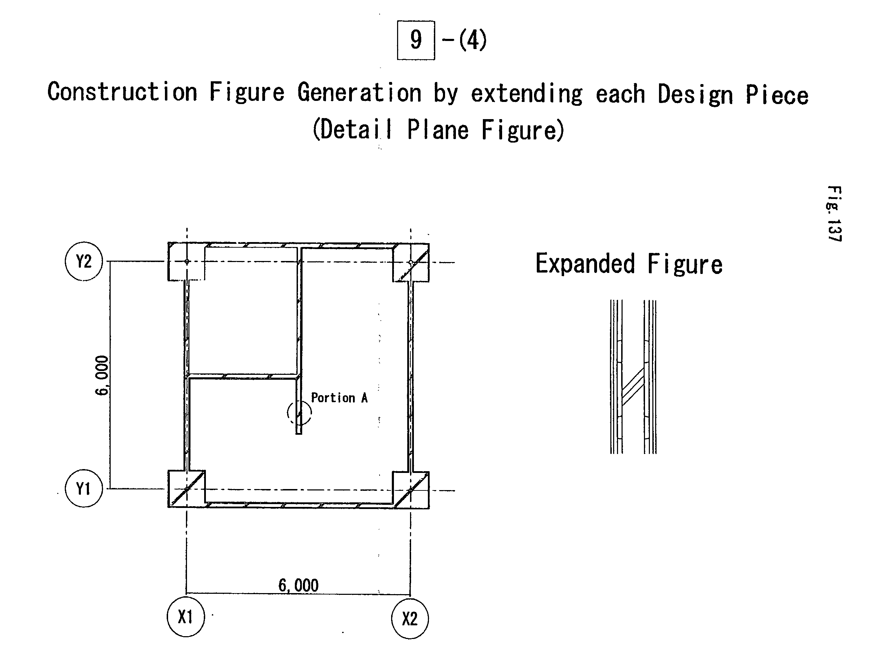

Figures 131 to 137 are explanation figures to show examples of construction design pieces generated by DL replacement. Total design pieces for designing are inputted first (Fig. 131). Next, DLs for designing are inputted (Fig. 132). Then, a DL having the same meanings are searched among the master DL for construction and inputted (Figures 133 and 134), to generate total design pieces for construction. Then, detail design pieces (planning design pieces) for construction and detail design pieces (connection design pieces) for construction are generated (Fig. 135), and the detail design pieces for designing are reflected on the detail design pieces for construction (Fig. 136). Finally, the detail design pieces for construction are extended to draw a construction figure (Fig. 136).

Examples of the embodiment of this invention are shown in detail heretofore, but other variations explained in the following are also possible. That is, although embodiment examples are shown for generating extension data with a CAD format that can be applied to various drawing outputs, the extension program output data of this invention can be applied to any kind of applications.

For example, if unit costs for components are registered as DL data, a total material cost estimation table with a table calculation program format can be outputted, by calculating the total number of each component contained in the total design pieces by using the extension program. Furthermore, simulation programs such as structure calculation or structure analysis may be included as extension programs of the building production support system of this invention.

As described hereinbefore, the building production support system of this invention provides detail libraries (DLs) containing data defined from both fixed information and variable information for elements that compose a design target object such as a building, components that consist of combinations of elements, positions that consist of combinations of components and connections where positions and/or components compete each other, generate and manage design pieces corresponding to such DLs, and utilizes various extension programs according to the design purpose. Thus the system can manage and express various design information and data either logically or physically, enabling to respond flexibly to various requirements of building design.

## Claims

1. A construction production support system that contains (1) a means to input planning data pieces that consist of figure pieces, (2) a means to generate total design pieces by : (a) generating a detail library (DL) through defining a building design object by elements composing said building design target and by multi-layered element complexes each of which is composed of a combination of said elements or complexes of said elements, and (b) selecting necessary elements or element complexes from said detail library in order to attach meaning to each of said figure pieces, and (3) a means to generate detail design pieces from information of said total design pieces and to output necessary information.

2. A construction production support system claimed in claim 1 where said detail library consists of an element layer, a component layer and a position layer, and the component layer consists of one or a number of elements and the position layer consists of one or a number of components or positions.

3. A construction production support system claimed in claim 1 where said detail library contains connection data that define a competing portion between positions or components.

4. A construction production support system claimed in claim 1 where said construction production support system contains a generating means and a correcting means for said detail library.

5. A construction production support system claimed in claim 1 where said construction production support system contains CAD functions.

6. A construction production support system claimed in claim 1 where said means to generate detail design pieces contains a means to output drawing data derived from detail design piece data.

7. A construction production support system claimed in claim 1 where said means to generate detail design pieces contains a means to output quantity surveying data derived from detail design piece data.

8. A construction production support system claimed in claim 1 where said means to generate detail design pieces contains a means to output endurance period managing data derived from detail design piece data.

9. A construction production support system claimed in claim 1 where said construction production support system contains a correcting means for said total design pieces and a correcting means for said detail design pieces.

10. A construction production support system claimed in claim 9 where each of said total design pieces and detail design pieces contains a request data base (DB) through which any change in any design piece can be reflected on other design pieces.

11. A construction production support system claimed in claim 10 where construction production support system contains a priority order DB that stores information of each designer's correction right.

12. A construction production support system claimed in claim 1 where said detail library (DL) possesses the same two data sets for designing and for construction and replaces the DL for designing by DL for construction automatically to generate detail design pieces for construction.

13. A method to support construction production that contains (1) a step to input planning drawings that consist of figure pieces, (2) a step to generate total design pieces by : (a) generating a detail library (DL) through defining a building design target by elements composing said building design target and by multi-layered element complexes each of which is composed of a combination of said elements or complexes of said elements, and (b) selecting necessary elements or element complexes from said detail library in order to attach meaning to each of said figure pieces, and (3) a step to generate detail design pieces from information of said total design pieces and to output necessary information.

14. An information recording medium of which contents can be read by a computer and in which a computer program is recorded to carry out functions of : (1) a means to input planning data pieces that consist of figure pieces, (2) a means to generate total design pieces by : (a) generating a detail library (DL) through defining a building design target by elements composing said building design target and by multi-layered element complexes each of which is composed of a combination of said elements or complexes of said elements, and (b) selecting necessary elements or element complexes from said detail library in order to attach meaning to each of said figure pieces, and (3) a means to generate detail design pieces from information of said total design pieces and to output necessary information.
